# EUROPEAN PATENT SPECIFICATION

(11) **EP 3 389 105 B1**
(45) Date of publication and mention of the grant of the patent: **20.01.2021**
(21) Application number: 16872911.9
(22) Date of filing: 02.12.2016
(51) Int. Cl.: H01L 51/50, C09K 11/06, C07F 15/00

(54) **COMPOSITION AND LIGHT-EMITTING DEVICE USING THE SAME**
ZUSAMMENSETZUNG UND LICHTEMITTIERENDE VORRICHTUNG DAMIT
COMPOSITION ET DISPOSITIF ÉLECTROLUMINESCENT L'UTILISANT

(30) Priority: 07.12.2015 JP 2015238657
(43) Date of publication of application: 17.10.2018
(73) Proprietor: Sumitomo Chemical Company, Limited, Tokyo 104-8260 (JP)
(72) Inventor: SAITO Takakazu, Tsukuba-shi Ibaraki 300-3294 (JP); SASADA Toshiaki, Tsukuba-shi Ibaraki 300-3294 (JP)
(74) Representative: J A Kemp LLP
(86) International application number: PCT/JP2016/085890
(87) International publication number: WO 2017/099013

(56) References cited:
- WO-A1-2008/143059
- WO-A1-2010/001830
- WO-A1-2010/032663
- WO-A1-2014/156922
- WO-A1-2015/163174
- WO-A1-2016/006523
- JP-A- 2013 033 915
- JP-A- 2013 245 179
- US-A1- 2010 141 125
- US-A1- 2011 084 601

## Description

### Technical Field

The present invention relates to a composition and a light-emitting device using the same.

### Background Art

An organic electroluminescent device (hereinafter also referred to as "light-emitting device") shows a high luminous efficiency and a low drive voltage, and hence can be suitably used for display and lighting applications. Research and development into such devices is being actively carried out.

As a material to be used for a light-emitting layer of a light-emitting device, for example, a composition comprising a phosphorescent compound (A), a phosphorescent compound (B), and a phosphorescent compound (C) represented by the following formulas has been proposed (Patent Literature 1). It is noted that the phenyl-pyridine ligand of the phosphorescent compound (B) and the benzothienyl-pyridine ligand of the phosphorescent compound (C) are ligands having no substituent. 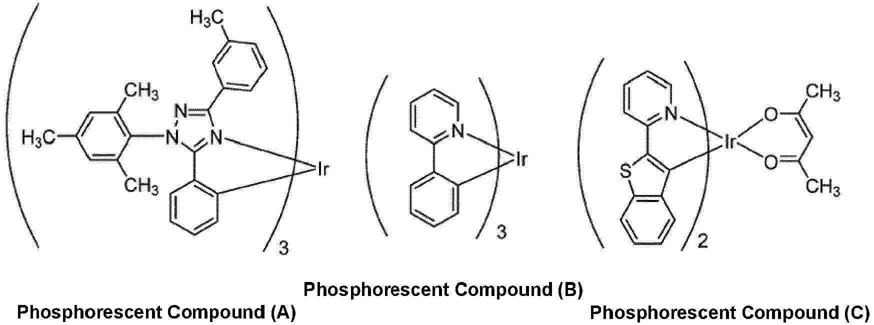 Patent Literature 2 discloses a coating type organic EL element having chromaticity stability to driving current, chromaticity stability during continuous driving and color rendering property.
Patent Literature 3 discloses an isomer-mixture metal complex composition that includes a plurality of atropisomers, and an organic EL element using the isomer-mixture metal complex composition as a material for the organic EL element.

### Citation List

### Patent Literature

[Patent Literature 1] International Publication No. 2014/156922
[Patent Literature 2] US 2011/084601
[Patent Literature 3] WO 2014/156922

### Summary of Invention

### Technical Problem

However, a light-emitting device fabricated using the composition described in Patent Literature 1 does not always show a sufficient external quantum efficiency.

Therefore, it is an object of the present invention to provide a composition useful for the fabrication of a light-emitting device which shows an excellent external quantum efficiency. Further, it is another object of the present invention to provide a light-emitting device comprising this composition.

### Solution to Problem

The present invention is defined by claims 1-15.

### Advantageous Effects of Invention

According to the present invention, a composition useful for the fabrication of a light-emitting device which shows an excellent external quantum efficiency can be provided. Further, according to the present invention, a light-emitting device comprising this composition can be provided.

### Description of Embodiments

Preferable embodiments of the present invention will now be described in detail.

### <Description of Common Terms>

Unless otherwise stated, terms commonly used in the present specification have the following meanings.

Me represents a methyl group, Et represents an ethyl group, Bu represents a butyl group, i-Pr represents an isopropyl group, and t-Bu represents a tert-butyl group.

The hydrogen atom may be a heavy hydrogen atom or a light hydrogen atom.

In the formula representing a phosphorescent compound, a solid line representing a bond to the central metal represents a covalent bond or a coordinate bond.

The term "polymer compound" means a polymer having molecular weight distribution and having a polystyrene-equivalent number-average molecular weight of 1 × 10³ to 1 × 10⁸.

The polymer compound may be any of a block copolymer, a random copolymer, an alternating copolymer, and a graft copolymer, or may even be some other form.

If a polymerization active group remains intact at the terminal group of the polymer compound, light-emitting properties may deteriorate if such a polymer compound is used to fabricate the light-emitting device, and therefore, it is preferable that the terminal group be a stable group. This terminal group is preferably a group covalently bonded to the main chain, and examples thereof include groups bonding to an aryl group or a monovalent heterocyclic group via a carbon-carbon bond.

The term "low molecular weight compound" means a compound that does not have a molecular weight distribution and that has a molecular weight of 1 × 10⁴ or less.

The term "constitutional unit" means a unit occurring one or more times in a polymer compound.

The "alkyl group" may be either linear or branched. The linear alkyl group usually has 1 to 50 carbon atoms, preferably 3 to 30 carbon atoms, and more preferably 4 to 20 carbon atoms, not including the carbon atoms of the substituent. The branched alkyl group usually has 3 to 50 carbon atoms, preferably 3 to 30 carbon atoms, and more preferably 4 to 20 carbon atoms, not including the carbon atoms of the substituent.

The alkyl group may have a substituent, and examples thereof include a methyl group, an ethyl group, a propyl group, an isopropyl group, a butyl group, a 2-butyl group, an isobutyl group, a tert-butyl group, a pentyl group, an isoamyl group, 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, and a dodecyl group, and groups obtained by substituting a hydrogen atom of these groups with a cycloalkyl group, an alkoxy group, a cycloalkoxy group, an aryl group, a fluorine atom, and the like; and examples thereof include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group.

The "cycloalkyl group" usually has 3 to 50 carbon atoms, preferably 3 to 30 carbon atoms, and more preferably 4 to 20 carbon atoms, not including the carbon atoms of the substituent.

The cycloalkyl group may have a substituent, and examples thereof include a cyclohexyl group, a cyclohexylmethyl group, and a cyclohexylethyl group.

The term "aryl group" means the atomic group remaining after removing from an aromatic hydrocarbon one hydrogen atom that is directly bonded to a carbon atom constituting the ring. The aryl group usually has 6 to 60 carbon atoms, preferably 6 to 20 carbon atoms, and more preferably 6 to 10 carbon atoms, not including the carbon atoms of the substituent.

The aryl group may have a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, and a 4-phenylphenyl group, and groups obtained by substituting a hydrogen atom of these groups with an alkyl group, a cycloalkyl group, an alkoxy group, a cycloalkoxy group, an aryl group, a fluorine atom, and the like.

The "alkoxy group" may be any of linear and branched. The linear alkoxy group usually has 1 to 40 carbon atoms, and preferably 4 to 10 carbon atoms, not including the carbon atoms of the substituent. The branched alkoxy group usually has 3 to 40 carbon atoms, and preferably 4 to 10 carbon atoms, not including the carbon atoms of the substituent.

The alkoxy group may have a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group, and groups obtained by substituting a hydrogen atom of these groups with a cycloalkyl group, an alkoxy group, a cycloalkoxy group, an aryl group, a fluorine atom, and the like.

The "cycloalkoxy group" usually has 3 to 40 carbon atoms, and preferably 4 to 10 carbon atoms, not including the carbon atoms of the substituent.

The cycloalkoxy group may have a substituent, and examples thereof include a cyclohexyloxy group.

The "aryloxy group" usually has 6 to 60 carbon atoms, and preferably 6 to 48, not including the carbon atoms of the substituent.

The aryloxy group may have a substituent, and examples thereof include a phenoxy group, a 1-naphthyloxy group, a 2-naphthyloxy group, a 1-anthracenyloxy group, a 9-anthracenyloxy group, and a 1-pyrenyloxy group, and groups obtained by substituting a hydrogen atom of these groups with an alkyl group, a cycloalkyl group, an alkoxy group, a cycloalkoxy group, a fluorine atom, and the like.

The term "p-valent heterocyclic group" (p denotes an integer of 1 or more) means an atomic group remaining after removing from a heterocyclic compound p atoms of hydrogen among the hydrogen atoms that are directly bonded to carbon atoms or hetero atoms constituting the ring. Among p-valent heterocyclic groups, preferable are "p-valent aromatic heterocyclic groups", which are the atomic groups remaining after p atoms of hydrogen among the hydrogen atoms directly bonded to carbon atoms or hetero atoms constituting the ring are removed from an aromatic heterocyclic compound.

The term "aromatic heterocyclic compound" means, for example, a compound in which the heterocyclic ring itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, or a compound in which an aromatic ring is condensed to a heterocyclic ring even if the heterocyclic ring itself does not exhibit aromaticity, such as phenoxazine, phenothiazine, dibenzoborole, dibenzosilole, benzopyran, and the like.

The monovalent heterocyclic group usually has 2 to 60 carbon atoms, and preferably 4 to 20 carbon atoms, not including the carbon atoms of the substituent.

The monovalent heterocyclic group may have a substituent, and examples thereof include a thienyl group, a pyrrolyl group, a furyl group, a pyridyl group, a piperidinyl group, a quinolinyl group, an isoquinolinyl group, a pyrimidinyl group and a triazinyl group, and groups obtained by substituting a hydrogen atom of these groups with an alkyl group, a cycloalkyl group, an alkoxy group, a cycloalkoxy group, and the like.

The term "halogen atom" means a fluorine atom, a chlorine atom, a bromine atom, or an iodine atom.

An "amino group" may have a substituent, and a substituted amino group is preferable. As the substituent that the amino group has, an alkyl group, a cycloalkyl group, an aryl group, or a monovalent heterocyclic group is preferable.

Examples of the substituted amino group include a dialkylamino group, a dicycloalkylamino group, and a diarylamino group.

Examples of the amino group include a dimethylamino group, a diethylamino group, a diphenylamino group, a bis(4-methylphenyl)amino group, a bis(4-tert-butylphenyl)amino group, and a bis(3,5-di-tert-butylphenyl)amino group.

An "alkenyl group" may be any of linear and branched. The linear alkenyl group usually has 2 to 30 carbon atoms, and preferably 3 to 20 carbon atoms, not including the carbon atoms of the substituent. The branched alkenyl group usually has carbon atoms 3 to 30, and preferably 4 to 20 carbon atoms, not including the carbon atoms of the substituent.

A "cycloalkenyl group" usually has 3 to 30 carbon atoms, and preferably 4 to 20 carbon atoms, not including the carbon atoms of the substituent.

The alkenyl group and the cycloalkenyl group each may have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, and a 7-octenyl group, and these groups having a substituent.

An "alkynyl group" may be any of linear and branched. The alkynyl group usually has 2 to 20 carbon atoms, and preferably 3 to 20 carbon atoms, not including the carbon atoms of the substituent. The branched alkynyl group usually has 4 to 30 carbon atoms, and preferably 4 to 20 carbon atoms, not including the carbon atoms of the substituent.

A "cycloalkynyl group" usually has 4 to 30 carbon atoms, and preferably 4 to 20 carbon atoms, not including the carbon atoms of the substituent.

The alkynyl group and the cycloalkynyl group each may have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

An "arylene group" means an atomic group remaining after removing from an aromatic hydrocarbon two hydrogen atoms that are directly bonded to a carbon atom constituting the ring. The arylene group usually has 6 to 60 carbon atoms, preferably 6 to 30 carbon atoms, and more preferably 6 to 18 carbon atoms, not including the carbon atoms of the substituent.

The arylene group may have a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, and preferable are groups represented by formulas (A-1) to (A-20). The arylene group may be a group obtained by bonding a plurality of these groups. 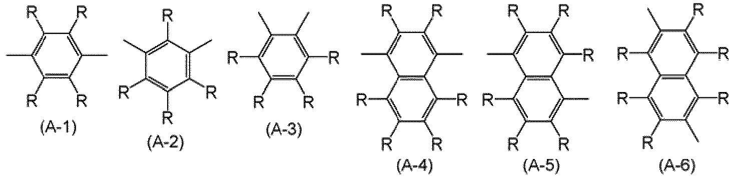 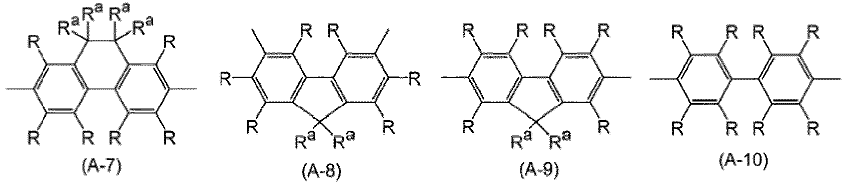 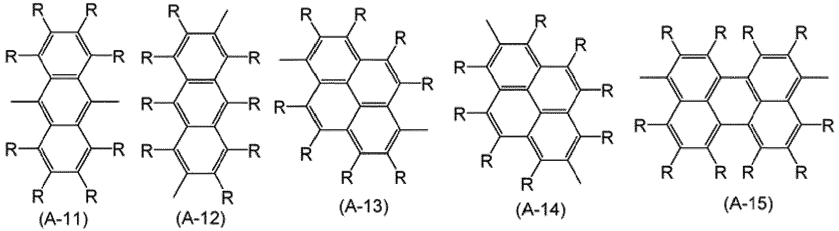 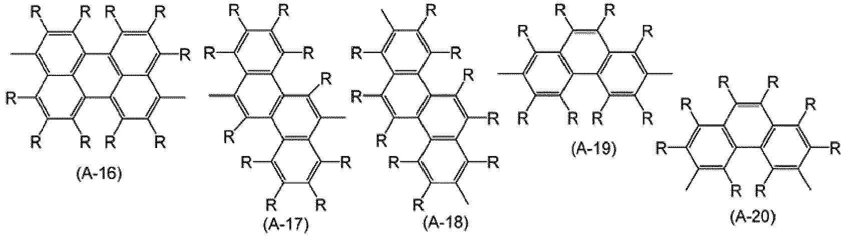 (Wherein R and R^{a} each independently represent a hydrogen atom, an alkyl group, a cycloalkyl group, an aryl group or a monovalent heterocyclic group; the plurality of R and R^{a} each may be the same or different at each occurrence; and the plurality of R^{a} may be bonded to each other to form a ring together with the atoms to which they are bonded.)

The divalent heterocyclic group usually has 2 to 60 carbon atoms, preferably 3 to 20 carbon atoms, and more preferably 4 to 15 carbon atoms, not including the carbon atoms of the substituent.

The divalent heterocyclic group may have a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among the hydrogen atoms directly bonded to a carbon atom or a hetero atom constituting the ring. Preferable are groups represented by formulas (AA-1) to (AA-34). The divalent heterocyclic group may be a group obtained by bonding a plurality of these groups. 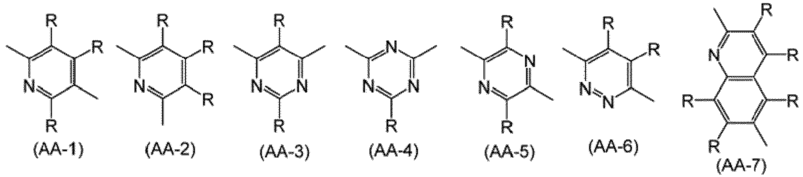 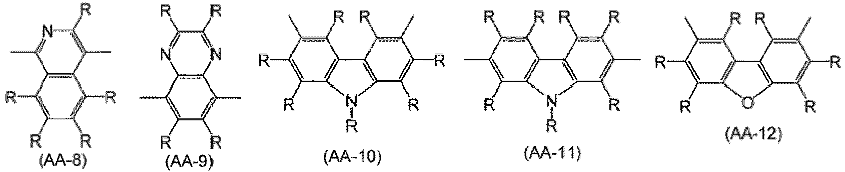 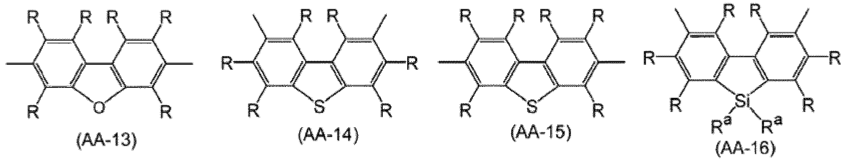 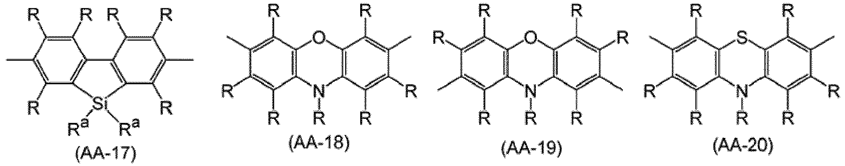 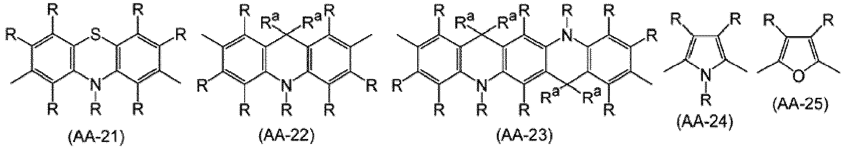 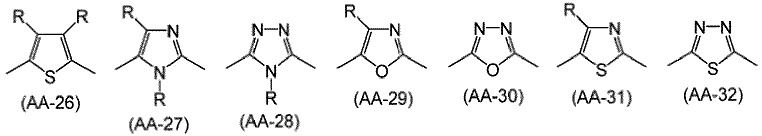 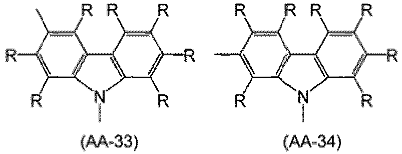 (Wherein R and R^{a} have the same meanings as described above.)

The term "crosslinkable group" means a group capable of producing a new bond when subjected to heat, UV-irradiation, near-UV irradiation, visible light irradiation, infrared irradiation, a radical reaction, and the like. Preferable are crosslinkable groups represented by formulas (XL-1) to (XL-17) of the group of crosslinkable groups A. 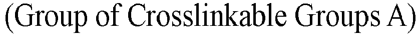 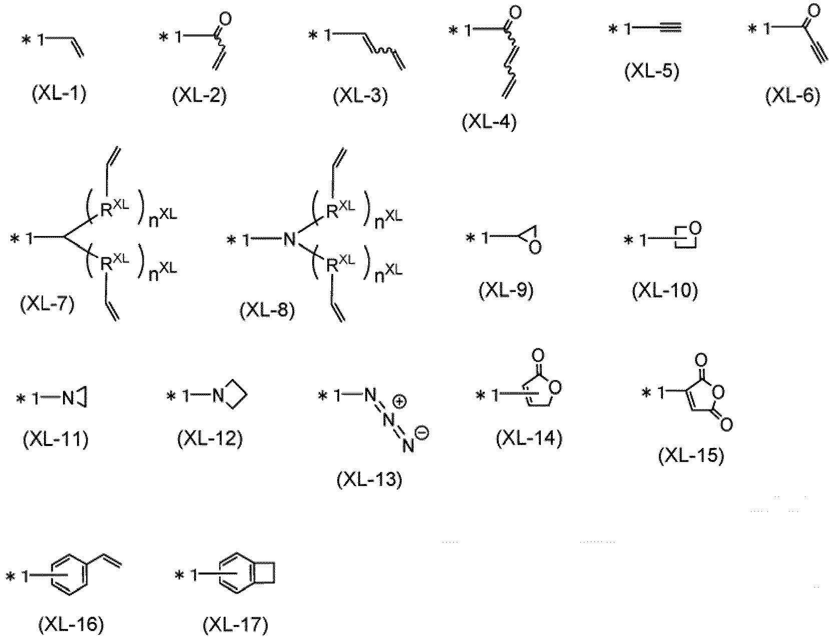 (Wherein R^{XL} represents a methylene group, an oxygen atom, or a sulfur atom, and n^{XL} denotes an integer of 0 to 5; when there are a plurality of R^{XL}, they may be the same or different, and when there are a plurality of n^{XL}, they may be the same or different; *1 represents a bonding position; and these crosslinkable groups each may have a substituent.)

The term "substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, or a cycloalkynyl group. The substituent may also be a crosslinkable group.

### <Phosphorescent Compound>

The term "phosphorescent compound" usually means a compound exhibiting phosphorescence at room temperature (25°C), and is preferably a compound that emits light at room temperature from a triplet excited state. This compound that emits light from a triplet excited state has a central metal atom and a ligand.

The central metal atom may be a metal atom having an atomic number of 40 or more, which has a spin-orbit interaction in the compound, and is capable of causing intersystem crossing between the singlet state and the triplet state. Examples of the metal atom include a rhodium atom, a palladium atom, an iridium atom, and a platinum atom.

The ligand may be a neutral or anionic monodentate ligand, or a neutral or anionic multidentate ligand, which forms at least one bond selected from the group consisting of a coordinate bond and a covalent bond with the central metal atom. Examples of the bond between the central metal atom and the ligand include a metal-nitrogen bond, a metal-carbon bond, a metal-oxygen bond, a metal-phosphorus bond, a metal-sulfur bond, and a metal-halogen bond. The term multidentate ligand usually means a ligand having two or more and six or less donor atoms.

The phosphorescent compound can be obtained from Aldrich, Luminescence Technology Corp., American Dye Source, and the like.

Further, the phosphorescent compound can also be obtained based on known methods described in the "Journal of the American Chemical Society, Vol. 107, 1431-1432 (1985)", "Journal of the American Chemical Society, Vol. 106, 6647-6653 (1984)", International Publication No. 2004/026886, International Publication No. 2006/121811, International Publication No. 2011/024761, and International Publication No. 2007/097153.

The maximum peak wavelength of the emission spectrum of the phosphorescent compound can be evaluated by dissolving the phosphorescent compound in an organic solvent such as xylene, toluene, chloroform, or tetrahydrofuran to prepare a dilute solution (1 × 10⁻⁶ to 1 × 10⁻³ % by mass), and measuring the PL spectrum of the dilute solution at room temperature. Xylene is preferable as the organic solvent for dissolving the phosphorescent compound.

### <Phosphorescent Compound Represented by Formula (1)>

First, the phosphorescent compound represented by formula (1) contained in the composition according to the present embodiment is described.

The phosphorescent compound represented by formula (1) is constituted of M¹, which is a central metal, a ligand whose number is defined by the suffix n¹, and a ligand whose number is defined by the suffix n².

M¹ is preferably an iridium atom or a platinum atom, and more preferably an iridium atom, because the external quantum efficiency of the light-emitting device according to the present embodiment is better.

When M¹ is a rhodium atom or an iridium atom, n¹ is preferably 2 or 3, and more preferably 3.

When M¹ is a palladium atom or a platinum atom, n¹ is preferably 2.

E¹ and E² are preferably carbon atoms.

When the ring R^{1A} is a diazole ring, it is preferably an imidazole ring in which E^{11A} is a nitrogen atom or an imidazole ring in which E^{12A} is a nitrogen atom, and more preferably the ring R^{1A} is an imidazole ring in which E^{11A} is a nitrogen atom.

When the ring R^{1A} is a triazole ring, it is preferably a triazole ring in which E^{11A} and E^{12A} are nitrogen atoms.

When E^{11A} is a nitrogen atom and R^{11A} is present, R^{11A} is preferably an alkyl group, a cycloalkyl group, an aryl group, or a monovalent heterocyclic group, more preferably an aryl group, or a monovalent heterocyclic group, still more preferably an aryl group, and these groups each may have a substituent.

When E^{11A} is a carbon atom, R^{11A} is preferably a hydrogen atom, an alkyl group, a cycloalkyl group, an aryl group, or a monovalent heterocyclic group, more preferably a hydrogen atom, an alkyl group, a cycloalkyl group, or an aryl group, still more preferably a hydrogen atom, an alkyl group, or a cycloalkyl group, and particularly preferably a hydrogen atom, and these groups each may have a substituent.

When E^{12A} is a nitrogen atom and R^{12A} is present, R^{12A} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

When E^{12A} is a carbon atom, R^{12A} is preferably a hydrogen atom, an alkyl group, a cycloalkyl group, an aryl group, or a monovalent heterocyclic group, more preferably a hydrogen atom, an alkyl group, a cycloalkyl group, or an aryl group, still more preferably a hydrogen atom, an alkyl group, or a cycloalkyl group, and particularly preferably a hydrogen atom, and these groups each may have a substituent.

The aryl group in R^{11A} and R^{12A} is preferably a phenyl group, a naphthyl group, an anthracenyl group, a phenanthrenyl group, a dihydrophenanthrenyl group, a fluorenyl group, or a pyrenyl group, more preferably a phenyl group, a naphthyl group or a fluorenyl group, and still more preferably a phenyl group, and these groups each may have a substituent.

Preferable examples of the monovalent heterocyclic group in R^{11A} and R^{12A} include a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group, and a phenothiazinyl group, more preferable are a pyridyl group, a pyrimidinyl group, a triazinyl group, a dibenzofuranyl group, a carbazolyl group, an azacarbazolyl group, and a diazacarbazolyl group, and still more preferable are a pyridyl group, a pyrimidinyl group and a triazinyl group, and these groups each may have a substituent.

In the substituted amino group of R^{11A} and R^{12A}, the substituent possessed by the amino group is preferably an aryl group or a monovalent heterocyclic group, and these groups each may further have a substituent. The examples and preferable ranges of the aryl group in the substituent that the amino group has are the same as the examples and preferable ranges of the aryl group in R^{11A} and R^{12A}. The examples and preferable ranges of the monovalent heterocyclic group in the substituent that the amino group has are the same as the examples and preferable ranges of the monovalent heterocyclic group in R^{11A} and R^{12A}.

The optional substituents of R^{11A} and R^{12A} are preferably an alkyl group, a cycloalkyl group, an aryl group, a monovalent heterocyclic group, an alkoxy group, a cycloalkoxy group, an aryloxy group, or a substituted amino group, more preferably an alkyl group, a cycloalkyl group, an aryl group, a monovalent heterocyclic group, or a substituted amino group, still more preferably an alkyl group, a cycloalkyl group, an aryl group, or a monovalent heterocyclic group, and particularly preferably an alkyl group or an aryl group, and these groups each may further have a substituent.

The aryl group, monovalent heterocyclic group, or substituted amino group in R^{11A} and R^{12A} is preferably a group represented by formula (D-A), (D-B), or (D-C), more preferably a group represented by formula (D-A) or (D-C), and still more preferably a group represented by formula (D-C), because the external quantum efficiency of the light-emitting device according to the present embodiment is better.

m^{DA1}, m^{DA2}, m^{DA3}, m^{DA4}, m^{DA5}, m^{DA6}, and m^{DA7} are generally an integer of 10 or less, preferably an integer of 5 or less, more preferably an integer of 2 or less, and still more preferably 0 or 1. It is preferable that m^{DA2}, m^{DA3}, m^{DA4}, m^{DA5}, m^{DA6}, and m^{DA7} are the same integer, and it is more preferable that m^{DA1} , m^{DA2}, m^{DA3}, m^{DA4}, m^{DA5}, m^{DA6}, and m^{DA7} are the same integer.

G^{DA} is preferably a group represented by formula (GDA-11) to (GDA-15), more preferably a group represented by formula (GDA-11) to (GDA-14), still more preferably a group represented by formula (GDA-11) or (GDA-14), and particularly preferably a group represented by formula (GDA-11). 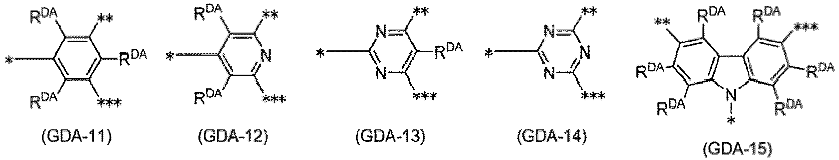 (Wherein,
* represents a bond with Ar^{DA1} in formula (D-A), Ar^{DA1} in formula (D-B), Ar^{DA2} in formula (D-B), or Ar^{DA3} in formula (D-B),
** represents a bond with Ar^{DA2} in formula (D-A), Ar^{DA2} in formula (D-B), Ar^{DA4} in formula (D-B), or Ar^{DA6} in formula (D-B),
*** represents a bond with Ar^{DA3} in formula (D-A), Ar^{DA3} in formula (D-B), Ar^{DA5} in formula (D-B), or Ar^{DA7} in formula (D-B), and
R^{DA} represents a hydrogen atom, an alkyl group, a cycloalkyl group, an alkoxy group, a cycloalkoxy group, an aryl group, or a monovalent heterocyclic group, and these groups each may further have a substituent; when there are a plurality of R^{DA}, they may be the same or different.)

R^{DA} is preferably a hydrogen atom, an alkyl group, a cycloalkyl group, an alkoxy group, or a cycloalkoxy group, more preferably a hydrogen atom, an alkyl group, or a cycloalkyl group, and these groups each may have a substituent.

Ar^{DA1}, Ar^{DA2}, Ar^{DA3}, Ar^{DA4}, Ar^{DA5}, Ar^{DA6}, and Ar^{DA7} are preferably a phenylene group, a fluorenediyl group, or a carbazolediyl group, more preferably a group represented by formula (A-1) to (A-3), (A-8), (A-9), (AA-10), (AA-11), (AA-33), or (AA-34), and still more preferably a group represented by formula (ArDA-1) to (ArDA-5), particularly preferably a group represented by formula (ArDA-1) to (ArDA-3), and especially preferably a group represented by formula (ArDA-1). 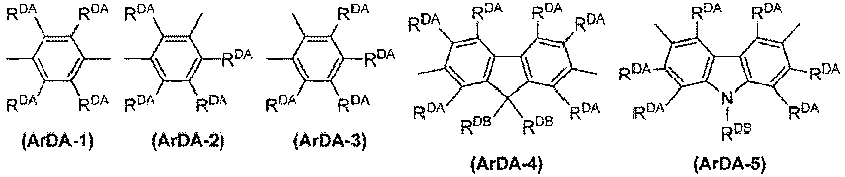
(Wherein R^{DA} has the same meaning as described above,
R^{DB} represents a hydrogen atom, an alkyl group, a cycloalkyl group, an aryl group, or a monovalent heterocyclic group, and these groups each may have a substituent; and when there are a plurality of R^{DB}, they may be the same or different.)

R^{DB} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

T^{DA} is preferably a group represented by formula (TDA-1) to (TDA-3), more preferably a group represented by formula (TDA-1). 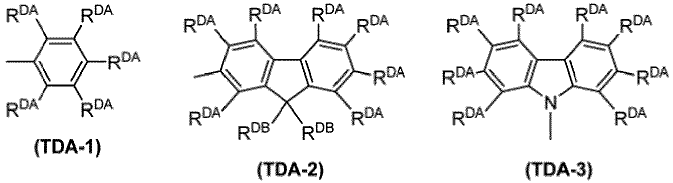 (Wherein R^{DA} and R^{DB} have the same meanings as described above.)

The group represented by formula (D-A) is preferably a group represented by formula (D-A1) to (D-A4), more preferably a group represented by formula (D-A1) or (D-A4), and still more preferably a group represented by formula (D-A1).

The group represented by formula (D-B) is preferably a group represented by formula (D-B1) to (D-B3), and more preferably a group represented by formula (D-B1).

The group represented by formula (D-C) is preferably a group represented by formula (D-C1) to (D-C4), more preferably a group represented by formula (D-C1) to (D-C3), more preferably a group represented by formula (D-C1) or (D-C2), and particularly preferably a group represented by formula (D-C1).

np1 is preferably 0 or 1, more preferably 1. np2 is preferably 0 or 1, and more preferably 0. np3 is preferably 0. np4 is preferably an integer of 0 to 2. np 5 is preferably an integer of 1 to 3. np6 is preferably an integer of 0 to 2.

R^{p1}, R^{p2}, R^{p3}, R^{p4}, R^{p5}, and R^{p6} are preferably an alkyl group or a cycloalkyl group, more preferably a methyl group, an ethyl group, an isopropyl group, a tert-butyl group, a hexyl group, a 2-ethylhexyl group, a cyclohexyl, a methoxy group, a 2-ethylhexyloxy group, a tert-octyl group or a cyclohexyloxy group, and still more preferably a methyl group, an ethyl group, an isopropyl group, a tert-butyl group, a hexyl group, a 2-ethylhexyl group, or a tert-octyl group.

Examples of the group represented by formula (D-A) include groups represented by formulas (D-A-1) to (D-A-12). 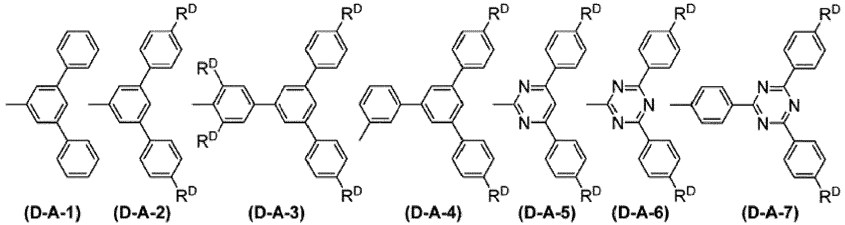 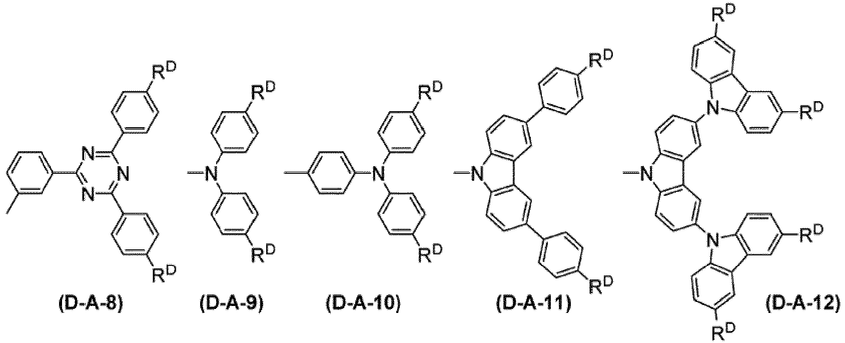 (Wherein,
R^{D} represents a methyl group, an ethyl group, an isopropyl group, a tert-butyl group, a hexyl group, a 2-ethylhexyl group, a tert-octyl group, a cyclohexyl group, a methoxy group, a 2-ethylhexyloxy group, or a cyclohexyloxy group; when there are a plurality of R^{D}, they may be the same or different.)

Examples of the group represented by formula (D-B) include groups represented by formulas (D-B-1) to (D-B-4). 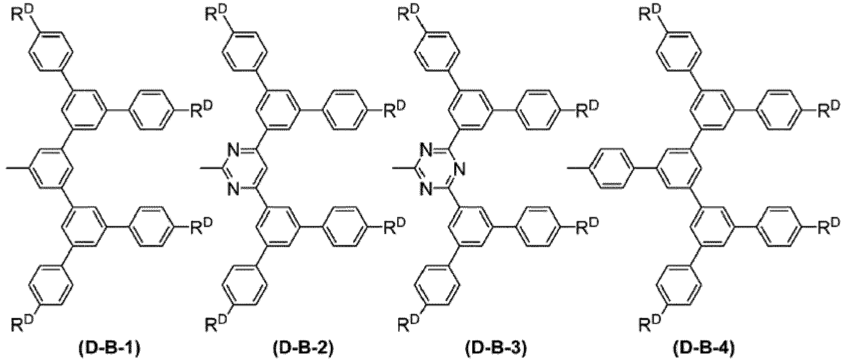 (Wherein R^{D} has the same meaning as described above.)

Examples of the group represented by formula (D-C) include groups represented by formulas (D-C-1) to (D-C-17). 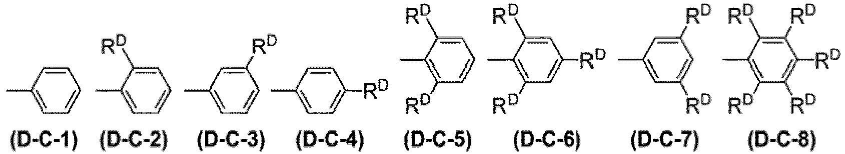 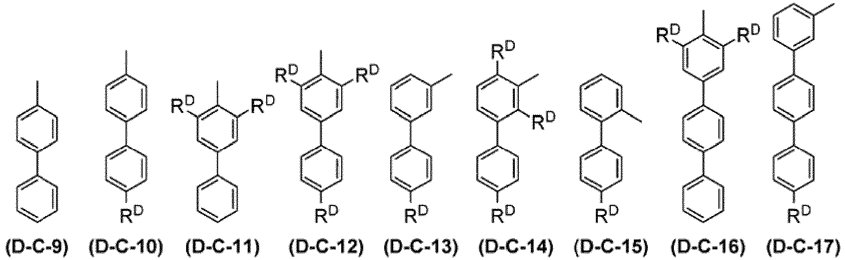 (Wherein R^{D} has the same meaning as described above.)

R^{D} is preferably a methyl group, an ethyl group, an isopropyl group, a tert-butyl group, a hexyl group, a 2-ethylhexyl group, or a tert-octyl group.

To achieve a better external quantum efficiency of the light-emitting device according to the present embodiment, at least one selected from the group consisting of R^{11A} and R^{12A} is preferably an aryl group which may have a substituent or a monovalent heterocyclic group which may have a substituent, more preferably is an aryl group which may have a substituent, still more preferably is a group represented by formula (D-A1), (D-A4), (D-B1), or (D-C1) to (D-C4), particularly preferably a group represented by formula (D-C1) to (D-C3), especially preferably a group represented by formula (D-C1) or (D-C2), and even more especially preferably a group represented by formula (D-C1).

When at least one member selected from the group consisting of R^{11A} and R^{12A} is an aryl group which may have a substituent or a monovalent heterocyclic group which may have a substituent, it is preferable that R^{11A} be an aryl group which may have a substituent or a monovalent heterocyclic group which may have a substituent, and it is more preferable that R^{11A} be an aryl group which may have a substituent.

R^{11A} and R^{12A} may be bonded to each other to form a ring together with the atoms to which they are bonded, but because the maximum peak wavelength of the emission spectrum of the phosphorescent compound represented by formula (1) becomes a long wavelength, it is preferable not to form a ring.

R^{13A} is preferably an aryl group or a monovalent heterocyclic group, and more preferably an aryl group, and these groups each may have a substituent.

The examples and preferable ranges of the aryl group, the monovalent heterocyclic group, and the substituted amino group in R^{13A} are each the same as the examples and preferable ranges of the aryl group, the monovalent heterocyclic group, and the substituted amino group in R^{11A} and R^{12A}.

The examples and preferable ranges of the optional substituent of R^{13A} are the same as the examples and preferable ranges of the optional substituents of R^{11A} and R^{12A}.

The ring R² is preferably a 5-or 6-membered aromatic hydrocarbon ring or a 5-or 6-membered aromatic heterocyclic ring, more preferably a 6-membered aromatic hydrocarbon ring or a 6-membered aromatic heterocyclic ring, and still more preferably a 6-membered aromatic hydrocarbon ring, and these rings each may have a substituent. When the ring R² is a 6-membered aromatic heterocyclic ring, E² is preferably a carbon atom.

Examples of the ring R² include a benzene ring, a naphthalene ring, a fluorene ring, a phenanthrene ring, an indene ring, a pyridine ring, a diazabenzene ring, and a triazine ring, A benzene ring, a naphthalene ring, a fluorene ring, a pyridine ring, or a pyrimidine ring is preferable, a benzene ring, a pyridine ring, or a pyrimidine ring is more preferable, and a benzene ring is still more preferable, and these rings each may have a substituent.

The optional substituent of the ring R² is preferably a fluorine atom, an alkyl group, a cycloalkyl group, an alkoxy group, a cycloalkoxy group, an aryloxy group, an aryl group, a monovalent heterocyclic group, or a substituted amino group, more preferably an alkyl group, a cycloalkyl group, an alkoxy group, an aryl group, a monovalent heterocyclic group, or a substituted amino group, still more preferably an alkyl group, a cycloalkyl group, an aryl group, a monovalent heterocyclic group, or a substituted amino group, particularly preferably an alkyl group or a group represented by formula (D-A), (D-B), or (D-C), especially preferably a group represented by formula (D -D), (D-B) or (D-C), even more especially preferably a group represented by formula (D-A) or (D-C), and most preferably a group represented by (D-A), and these groups each may further have a substituent.

The examples and preferable ranges of the aryl group, the monovalent heterocyclic group, and the substituted amino group of the optional substituent of the ring R² are each the same as the examples and preferable ranges of the aryl group, the monovalent heterocyclic group, and the substituted amino group in R^{11A} and R^{12A}.

The examples and preferable ranges of the substituent that the optional substituent of the ring R² may further have are the same as the examples and preferable ranges of the optional substituents of R^{11A} and R^{12A}.

### [Anionic Bidentate Ligand]

Examples of the anionic bidentate ligand represented by A¹-G¹-A² include ligands represented by the following formulas. 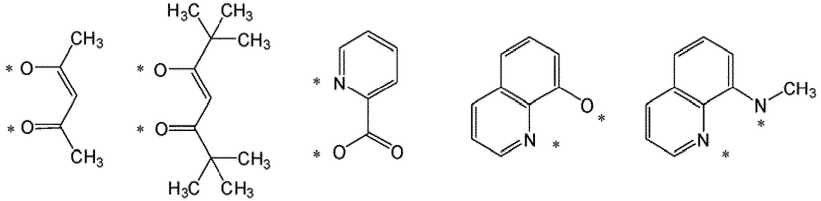 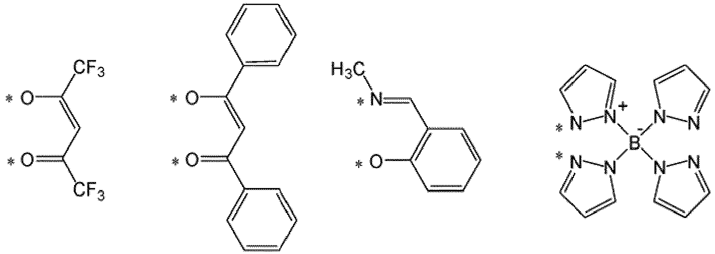 (Wherein * represents a site that binds to M¹.)

The anionic bidentate ligand represented by A¹-G¹-A² may be a ligand represented by the following formulas. However, the anionic bidentate ligand represented by A¹-G¹-A² is different from the ligand whose number is defined by the suffix n¹. 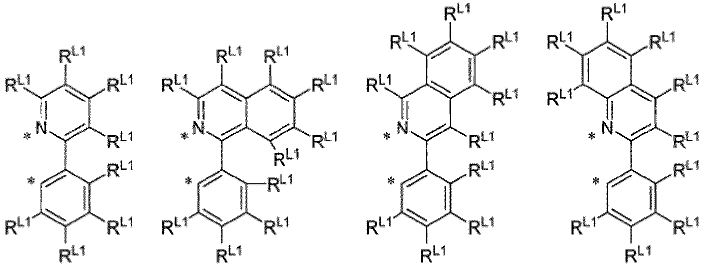 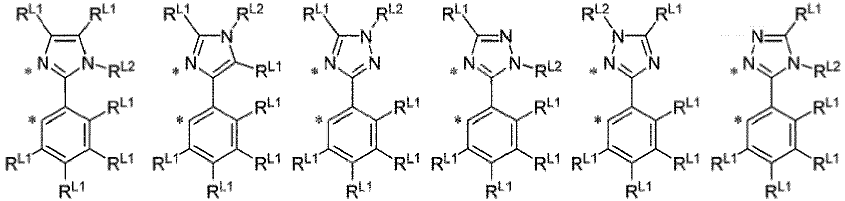 (Wherein,
* represents a site that binds to M¹,
R^{L1} represents a hydrogen atom, an alkyl group, a cycloalkyl group, or a halogen atom, and these groups each may have a substituent; the plurality of R^{L1} may be the same or different, and
R^{L2} represents an alkyl group, a cycloalkyl group, an aryl group, a monovalent heterocyclic group, or a halogen atom, and these groups each may have a substituent.)

R^{L1} is preferably a hydrogen atom, an alkyl group, a cycloalkyl group, or a fluorine atom, and more preferably a hydrogen atom or an alkyl group, and these groups each may have a substituent.

R^{L2} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

To achieve a better external quantum efficiency of the light-emitting device according to the present embodiment, the phosphorescent compound represented by formula (1) is preferably a phosphorescent compound represented by formula (1-A).

When the ring R^{2A} is a pyridine ring, a pyridine ring in which E^{21A} is a nitrogen atom, a pyridine ring in which E^{22A} is a nitrogen atom, or a pyridine ring in which E^{23A} is a nitrogen atom is preferable, and a pyridine ring in which E^{22A} is a nitrogen atom is more preferable.

When the ring R^{2A} is a pyrimidine ring, a pyrimidine ring in which E^{21A} and E^{23A} are nitrogen atoms, or a pyrimidine ring in which E^{22A} and E^{24A} are nitrogen atoms is preferable, and a pyrimidine ring in which E^{22A} and E^{24A} are nitrogen atoms is more preferable.

The ring R^{2A} is preferably a benzene ring.

R^{21A}, R^{22A}, R^{23A}, and R^{24A} are preferably a hydrogen atom, an alkyl group, a cycloalkyl group, an alkoxy group, an aryl group, a monovalent heterocyclic group, or a substituted amino group, more preferably a hydrogen atom, an alkyl group, a cycloalkyl group, an aryl group, a monovalent heterocyclic group, or a substituted amino group, and still more preferably a hydrogen atom, an alkyl group, or a group represented by formula (D-A), (D-B) or (D-C), particularly preferably a hydrogen atom or a group represented by formula (D-A), (D-B) or (D-C), especially preferably a hydrogen atom or a group represented by formula (D-A) or (D-C), and even more especially preferably a hydrogen atom or a group represented by formula (D-A), and these groups each may have a substituent.

The examples and preferable ranges of the aryl group, the monovalent heterocyclic group, and the substituted amino group in R^{21A}, R^{22A}, R^{23A}, and R^{24A} are each the same as the examples and preferable ranges of the aryl group, the monovalent heterocyclic group, and the substituted amino group of the optional substituent of the ring R².

The examples and preferable ranges of the optional substituent of R^{21A}, R^{22A}, R^{23A}, and R^{24A} are the same as the examples and preferable ranges of the substituent that the optional substituent of the ring R² may further have.

To achieve a better external quantum efficiency of the light-emitting device according to the present embodiment, at least one selected from the group consisting of R^{21A}, R^{22A}, R^{23A}, and R^{24A} is preferably a group represented by formula (D-A), (D-B), or (D-C), more preferably a group represented by formula (D-A) or (D-C), and still more preferably a group represented by formula (D-A).

When at least one member selected from the group consisting of R^{21A}, R^{22A}, R^{23A}, and R^{24A} is a group represented by formula (D-A), (D-B), or (D-C), it is preferable that R^{22A} or R^{23A} be a group represented by formula (D-A), (D-B), or (D-C), and more preferable that R^{22A} be a group represented by formula (D-A), (D-B), or (D-C).

To achieve an even better external quantum efficiency of the light-emitting device according to the present embodiment, the phosphorescent compound represented by formula (1-A) is preferably a phosphorescent compound represented by formula (1-A1), a phosphorescent compound represented by formula (1-A2), a phosphorescent compound represented by formula (1-A3), or a phosphorescent compound represented by formula (1-A4), more preferably a phosphorescent compound represented by formula (1-A1) or a phosphorescent compound represented by formula (1-A3), and still more preferably a phosphorescent compound represented by formula (1-A1).

Examples of the phosphorescent compound represented by formula (1) include phosphorescent compounds represented by formulas (Ir-100) to (Ir-133), (Pt-100) to (Pt-104), (Pd-100), or (Rh-100), and the phosphorescent compounds represented by formulas (Ir-100) to (Ir-129), (Pt-100) to (Pt-104), (Pd-100), or (Rh-100) are preferable. In the formula, EA represents a group represented by -CH= or a group represented by -N=.

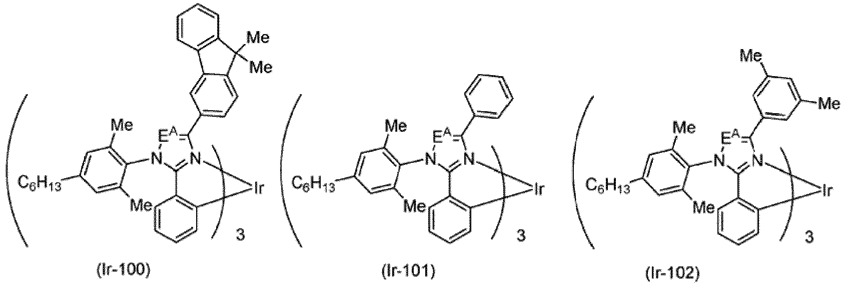

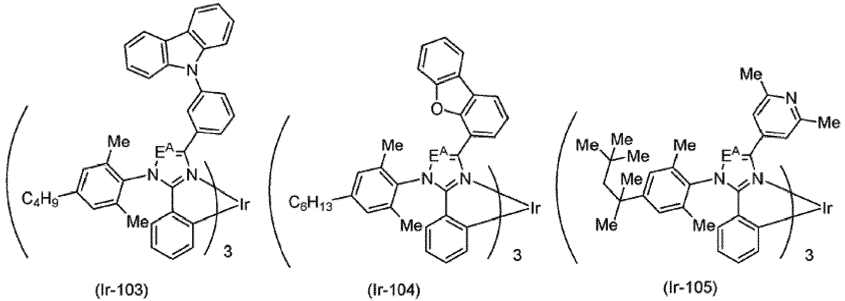

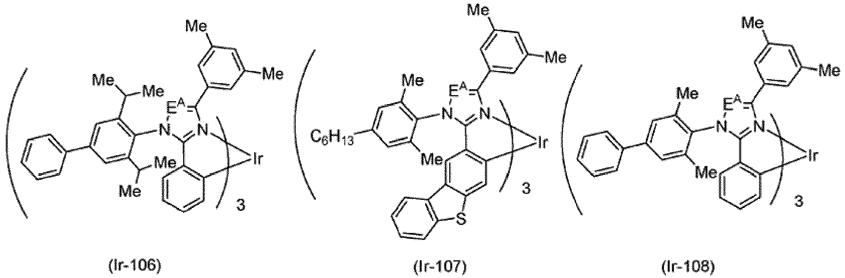

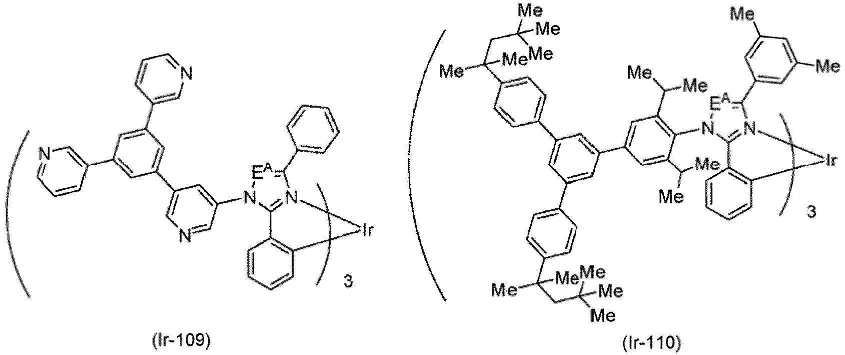

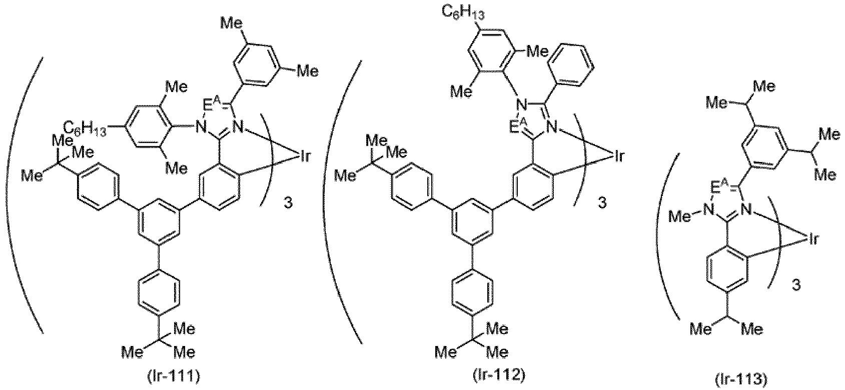

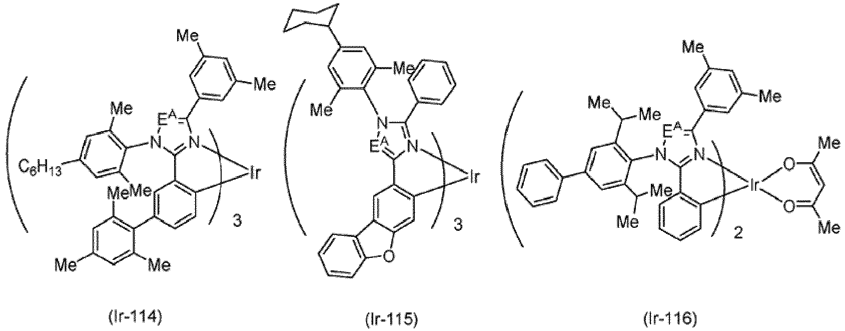

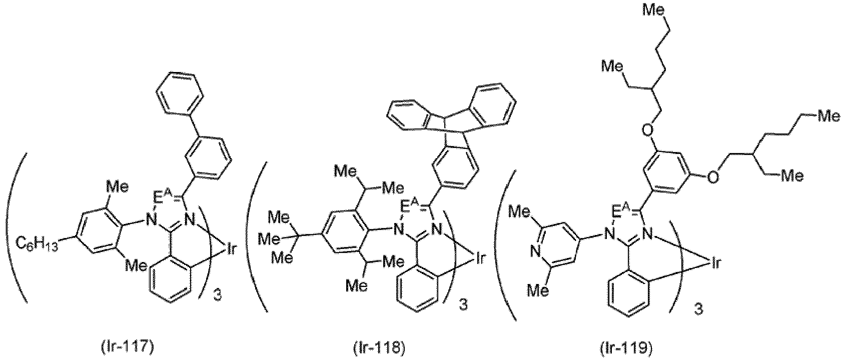

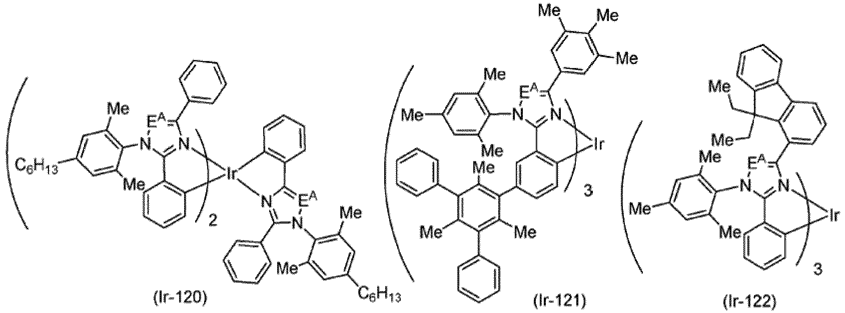

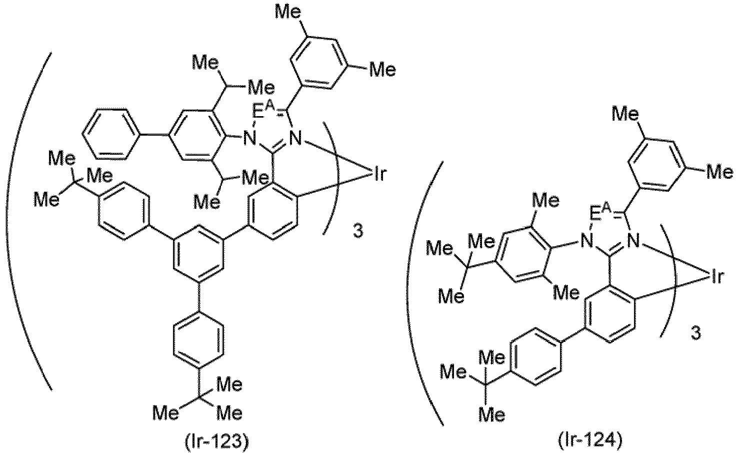

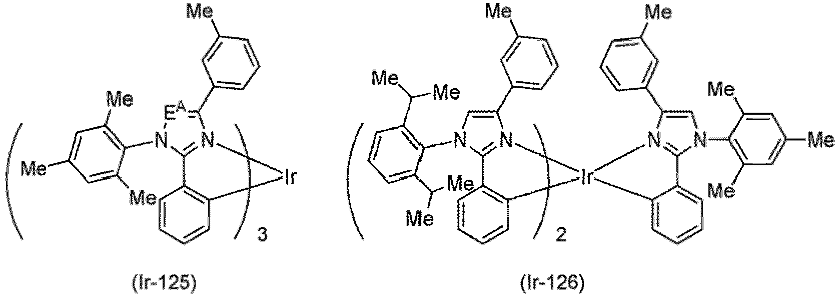

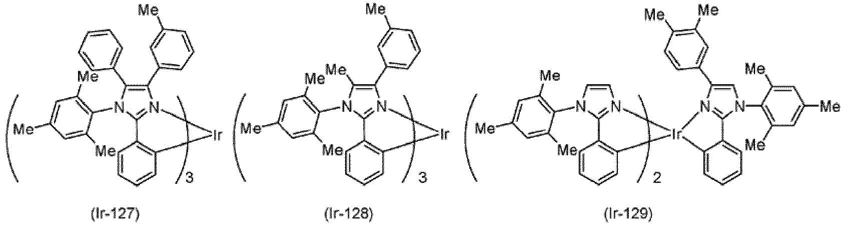

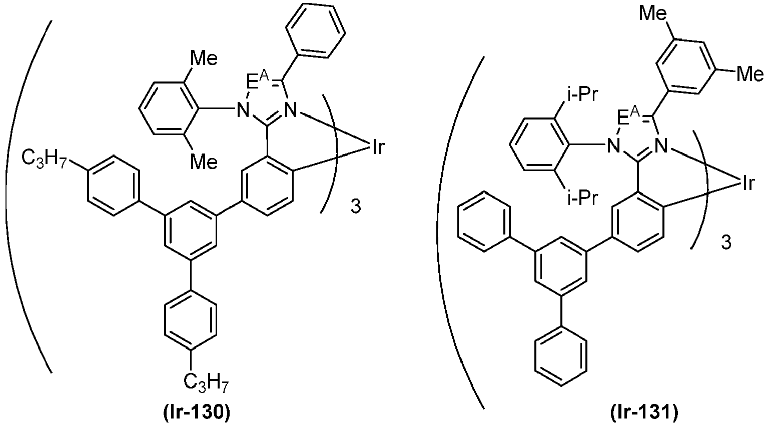

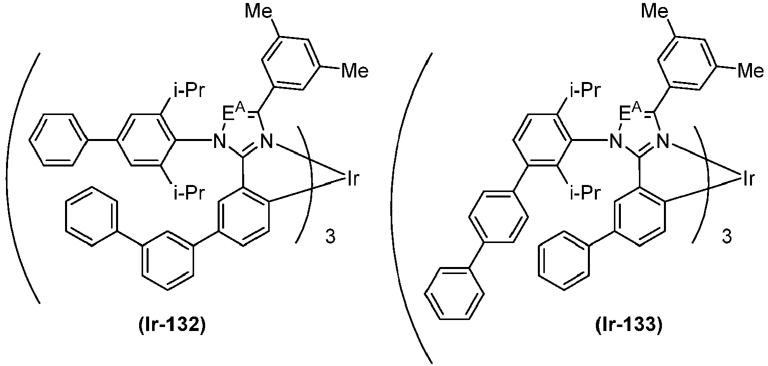

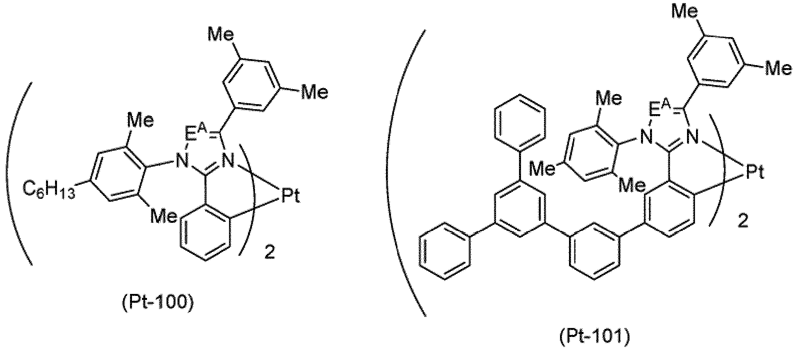

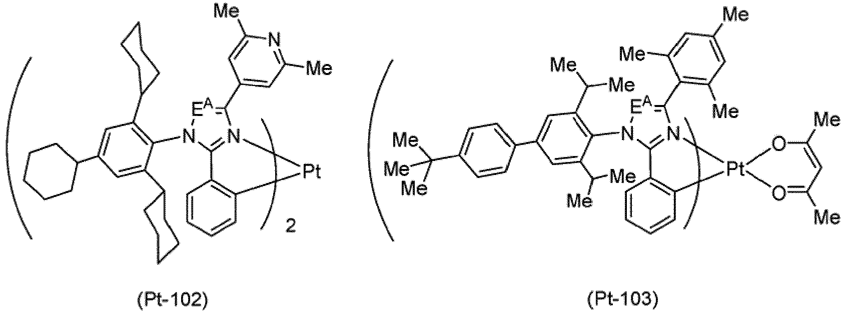

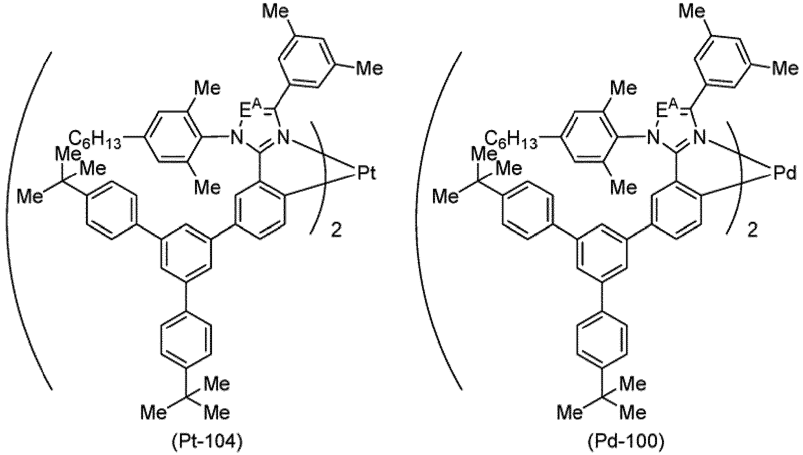

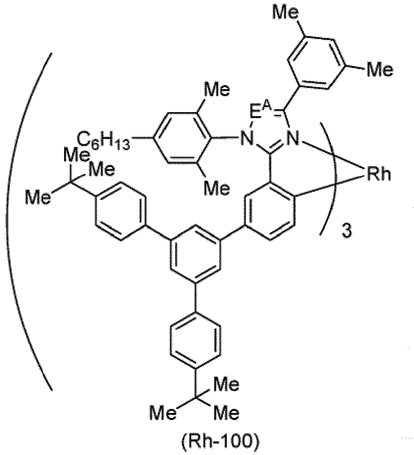

### <Method for Producing Phosphorescent Compound Represented by Formula (1)>

The phosphorescent compound represented by formula (1) can be produced by, for example, a method in which a compound serving as a ligand is reacted with a metal compound. Optionally, a functional group conversion reaction of the ligand of the phosphorescent compound may be carried out.

The phosphorescent compound represented by formula (1) can be produced by, for example, a step A of reacting a compound represented by formula (M-1) with a metal compound or a hydrate thereof, and a step B of reacting the compound obtained in step A (hereinafter also referred to as "phosphorescent compound intermediary (1)") with a compound represented by formula (M-1) or a precursor of a ligand represented by A¹-G¹-A² (hereinafter also referred to as "production method 1"). 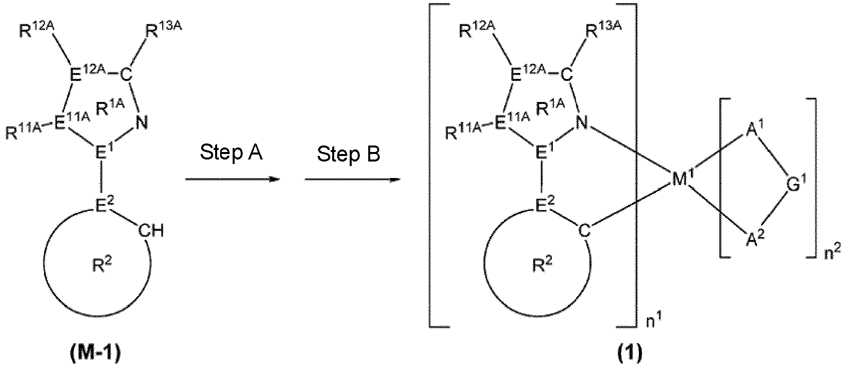 (Wherein M¹, n¹, n², the ring R^{1A}, the ring R², E¹, E², E^{11A}, E^{12A}, R^{11A}, R^{12A}, R^{13A}, and A¹-G¹-A² have the same meanings as described above.)

In step A, examples of the metal compound include iridium compounds such as iridium chloride, tris(acetylacetonato)iridium(III), a chloro(cyclooctadiene)iridium(I) dimer, and iridium(III) acetate; platinum compounds such as potassium chloroplatinate; palladium compounds such as palladium chloride and palladium acetate; and rhodium compounds such as rhodium chloride. Examples of hydrates of metal compounds include iridium chloride trihydrate and rhodium chloride trihydrate.

Examples of the phosphorescent compound intermediary (1) include a compound represented by formula (M-2). 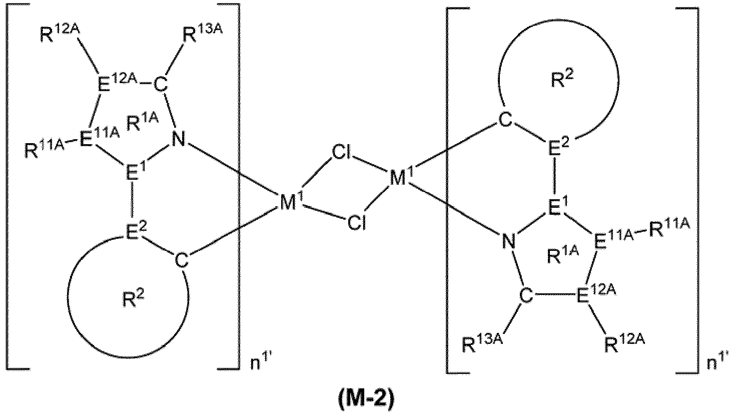 (Wherein,
M¹, the ring R^{1A}, the ring R², E¹, E², E^{11A}, E^{12A}, R^{11A}, R^{12A}, and R^{13A} have the same meanings as described above, and
n^{1'} represents 1 or 2. When M¹ is a rhodium atom or an iridium atom, n^{1'} is 2, and when M¹ is a palladium atom or a platinum atom, n^{1'} is 1.)

In step A, the compound represented by formula (M-1) is usually 2 to 20 moles with respect to 1 mole of the metal compound or its hydrate.

In step B, the amount of the compound represented by formula (M-1) or the precursor of the ligand represented by A¹-G¹-A² is usually 1 to 100 moles with respect to 1 mole of the phosphorescent compound intermediate (1).

In step B, the reaction is preferably carried out in the presence of a silver compound such as silver trifluoromethanesulfonate. When a silver compound is used, its amount is usually 2 to 20 moles relative to 1 mole of the phosphorescent compound intermediate (1).

Next, the functional group conversion reaction (hereinafter also referred to as "production method 2") of the ligand of the phosphorescent compound represented by formula (1) will be described.

In production method 2, examples of the functional group conversion reaction include known coupling reactions that use a transition metal catalyst, such as the Suzuki reaction, Buchwald reaction, Stille reaction, Negishi reaction, and Kumada reaction.

Examples of the production method 2 may include a method including a step C of performing a coupling reaction between a compound represented by formula (M-3) and a compound represented by formula (M-4). 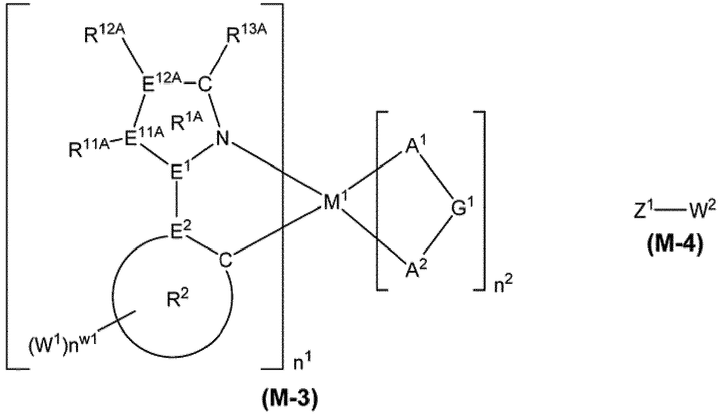 (Wherein,
M¹, n¹, n², the ring R^{1A}, the ring R², E¹, E², E^{11A}, E^{12A}, R^{11A}, R^{12A}, R^{13A}, and A¹-G¹-A² have the same meanings as described above,
W¹ represents a chlorine atom, a bromine atom or an iodine atom; when there are a plurality of W¹, they may be the same or different,
n^{W1} denotes an integer of 1 or more and 10 or less,
Z¹ represents an alkyl group, a cycloalkyl group, an aryl group, or a monovalent heterocyclic group, and these groups each may have a substituent, and
W² represents a group selected from the group consisting of the group of substituents B.)

### <Group of Substituents B>

A group represented by -B(OR^{C2})₂ (wherein R^{C2} represents a hydrogen atom, an alkyl group, a cycloalkyl group, or an aryl group, and these groups each may have a substituent; and the plurality of R^{C2} may be the same or different, and may be connected to each other to form a ring structure together with the oxygen atom to which they are bonded);
a group represented by -BF₃Q' (wherein Q' represents Li, Na, K, Rb, or Cs);
a group represented by -MgY' (wherein Y' represents a chlorine atom, a bromine atom, or an iodine atom);
a group represented by -ZnY" (wherein Y" represents a chlorine atom, a bromine atom, or an iodine atom); and
a group represented by -Sn(R^{C3})₃ (wherein R^{C3} represents a hydrogen atom, an alkyl group, a cycloalkyl group, or an aryl group, and these groups each may have a substituent; and the plurality of R^{C3} may be the same or different, and may be connected to each other to form a ring structure together with the tin atom to which they are bonded.

### Examples of the group represented by -B(OR^{C2})₂ include groups represented by formulas (W-1) to (W-10).

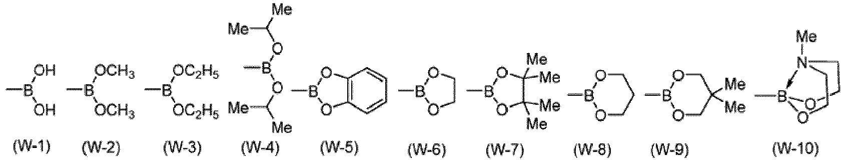

W¹ is preferably a bromine atom or an iodine atom, as this enables the coupling reaction to proceed more easily.

n^{W1} is preferably an integer of 1 to 5, more preferably 1 or 2, and still more preferably 1.

Z¹ is preferably an aryl group or a monovalent heterocyclic group, and more preferably an aryl group, and these groups each may have a substituent.

The examples and preferable ranges of the aryl group and monovalent heterocyclic group of Z¹ are each the same as the examples and preferable ranges of the aryl group and monovalent heterocyclic group of the optional substituent of the ring R².

The examples and preferable ranges of the optional substituent of Z¹ are the same as the examples and preferable ranges of the substituent that the optional substituent of the ring R² may further have.

W² is preferably a group represented by -B(OR^{C2})₂, and more preferably a group represented by formula (W-7).

In the coupling reaction, in order to accelerate the reaction, a catalyst such as a palladium catalyst may be used. Examples of the palladium catalyst may include palladium acetate, bis(triphenylphosphine)palladium(II) dichloride, tetrakis(triphenylphosphine)palladium(0), [1,1'-bis(diphenylphosphino)ferrocene]dichloropalladium(II), and tris(dibenzylideneacetone)dipalladium(0).

The palladium catalyst may be used in combination with a phosphorus compound such as triphenylphosphine, tri(o-tolyl)phosphine, tri(tert-butyl)phosphine, tricyclohexylphosphine, and 1,1'-bis (diphenylphosphino)ferrocene.

When a palladium catalyst is used in the coupling reaction, the amount thereof is usually an effective amount, for example, with respect to 1 mole of the compound represented by formula (M-3), preferably 0.00001 to 10 moles in terms of palladium element.

In the coupling reaction, optionally, a palladium catalyst and a base may be used in combination.

The compound represented by formula (M-3) can be synthesized, for example, by a method including a step D in which a phosphorescent compound represented by formula (1) is reacted with a halogenating agent.

In step D, examples of the halogenating agent include N-chlorosuccinimide, N-bromosuccinimide, N-iodosuccinimide, and the like.

In step D, the amount of the halogenating agent is usually 1 to 50 moles with respect to 1 mole of the phosphorescent compound represented by formula (1).

Steps A, B, C, and D are usually carried out in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen type solvents such as methylene chloride and chloroform; nitrile type solvents such as acetonitrile and benzonitrile; hydrocarbon solvents such as hexane, decalin, toluene, xylene, and mesitylene; amide solvents such as N,N-dimethylformamide, N,N-dimethylacetamide; acetone, dimethylsulfoxide, water, and the like.

In steps A, B, C, and D, the reaction time is usually 30 minutes to 200 hours, and the reaction temperature is usually between the melting point and the boiling point of the solvent present in the reaction system.

The compounds, catalysts, and solvents used in the reactions described in <Method for Producing Phosphorescent Compound Represented by Formula (1)> may be used singly or in combination of two or more.

### <Phosphorescent Compound Represented by Formula (2)>

Next, the phosphorescent compound represented by formula (2) contained in the composition according to the present embodiment will be described.

The phosphorescent compound represented by formula (2) is a phosphorescent compound constituted of M², which is a central metal, a ligand whose number is defined by the suffix n³, and a ligand whose number is defined by the suffix n⁴.

M² is preferably an iridium atom or a platinum atom, and more preferably an iridium atom, because the external quantum efficiency of a light-emitting device comprising the composition according to the present embodiment is better.

When M² is a rhodium atom or an iridium atom, n³ is preferably 2 or 3, and more preferably 3.

When M² is a palladium atom or a platinum atom, n³ is preferably 2.

E^{L} is preferably a carbon atom.

Ring L¹ is preferably a 6-membered aromatic heterocyclic ring having 1 or more and 4 or less nitrogen atoms as constituent atoms, more preferably a 6-membered aromatic heterocyclic ring having 1 or more and 2 or less nitrogen atoms as constituent atoms.

Examples of the ring L¹ include a pyridine ring, a diazabenzene ring, a quinoline ring, and an isoquinoline ring, a pyridine ring, a pyrimidine ring, a quinoline ring, or an isoquinoline ring is preferable, and a pyridine ring, a quinoline ring, or an isoquinoline ring is more preferable.

Ring L² is preferably a 5- or 6-membered aromatic hydrocarbon ring or a 5- or 6-membered aromatic heterocyclic ring, more preferably a 6-membered aromatic hydrocarbon ring or a 6-membered aromatic heterocyclic ring, and still more preferably a 6-membered aromatic hydrocarbon ring. When the ring L² is a 6-membered aromatic heterocyclic ring, E^{L} is preferably a carbon atom.

Examples of the ring L² include a benzene ring, a naphthalene ring, a fluorene ring, a phenanthrene ring, an indene ring, a pyridine ring, a diazabenzene ring, a pyrrole ring, a furan ring, and a thiophene ring, preferably a benzene ring, a naphthalene ring, a fluorene ring, a pyridine ring, or a pyrimidine ring, more preferably a benzene ring, a pyridine ring, or a pyrimidine ring, and still more preferably a benzene ring.

At least one ring selected from the group consisting of the ring L¹ and the ring L² has a group represented by formula (1-T). The expression "at least one ring selected from the group consisting of the ring L¹ and the ring L² has a group represented by formula (1-T)" means that, among the plurality of rings, a part or all of the hydrogen atoms directly bonded to a carbon atom or a nitrogen atom forming at least one of the rings is substituted with a group represented by formula (1-T). In the phosphorescent compound represented by formula (2), when there are a plurality of rings L¹ and L² (i.e., when n³ is 2 or 3), of the plurality of rings L¹ and L², although it is only necessary for at least one ring to have a group represented by formula (1-T), it is preferable that all of the plurality of rings L¹, all of the plurality of rings L², or all of the plurality of rings L¹ and L² to have a group represented by formula (1-T). More preferably, all of the plurality of rings L¹ or all of the plurality of rings L² have a group represented by formula (1-T), and still more preferably all of the plurality of rings L² have a group represented by formula (1-T).

When there are a plurality of groups represented by formula (1-T), they may be the same or different.

The ring L¹ and the ring L² may have another substituent different from the group represented by formula (1-T). The other substituent is preferably a cyano group, an alkenyl group, or a cycloalkenyl group, and these groups each may further have a substituent.

When the ring L¹ has a plurality of other substituents, those substituents may be the same or different and may be bonded to each other to form a ring together with the atoms to which they are bonded.

When the ring L² has a plurality of other substituents, those substituents may be the same or different and may be bonded to each other to form a ring together with the atoms to which they are bonded.

The other substituent(s) in the ring L¹ and the other substituent(s) in the ring L² may be bonded to each other to form a ring together with the atoms to which they are bonded.

### [Group Represented by Formula (1-T)]

R^{1T} is preferably an alkyl group, a cycloalkyl group, a halogen atom, an aryl group, a monovalent heterocyclic group, or a substituted amino group, more preferably an alkyl group, a cycloalkyl group, a fluorine atom, an aryl group, a monovalent heterocyclic group, or a substituted amino group, and still more preferably an alkyl group, a cycloalkyl group, an aryl group, a monovalent heterocyclic group, or a substituted amino group, and these groups each may have a substituent.

The examples and preferable ranges of the aryl group in R^{1T} are the same as the examples and preferable ranges of the aryl group in R^{11A} and R^{12A}.

The examples and preferable ranges of the monovalent heterocyclic group in R^{1T} are the same as the examples and preferable ranges of the monovalent heterocyclic group in R^{11A} and R^{12A}.

The examples and preferable ranges of the substituted amino group in R^{1T} are the same as the examples and preferable ranges of the substituted amino group in R^{11A} and R^{12A}.

The examples and preferable ranges of the optional substituent of R^{1T} are the same as the examples and preferable ranges of the optional substituent of R^{11A} and R^{12A}.

To achieve a better external quantum efficiency of a light-emitting device comprising the composition according to the present embodiment, R^{1T} is preferably an alkyl group, a cycloalkyl group, or a group represented by formula (D-A), (D-B), or D-C), more preferably an alkyl group or a group represented by formula (D-A), (D-B), or (D-C), still more preferably an alkyl group or a group represented by formula (D-A) or (D-B), and even more preferably an alkyl group or a group represented by formula (D-A).

In the groups represented by formulas (D-A) and (D-B) in R^{1T}, G^{DA} is preferably a group represented by formulas (GDA-11) to (GDA-15), more preferably a group represented by formulas (GDA-11) to (GDA-14), and still more preferably a group represented by formula (GDA-11) or (GDA-14).

In R^{1T}, the group represented by formula (D-A) is preferably a group represented by formulas (D-A1) to (D-A4), more preferably a group represented by formula (D-A1), (D-A3), or (D-A4), and still more preferably a group represented by formula (D-A1) or (D-A3).

In In R^{1T}, the group represented by formula (D-B) is preferably a group represented by formulas (D-B1) to (D-B3), and more preferably a group represented by formula (D-B1) or (D-B3).

In R^{1T}, the group represented by formula (D-C) is preferably a group represented by formulas (D-C1) to (D-C4), more preferably a group represented by formulas (D-C1) to (D-C3), still more preferably a group represented by formula (D-C1) or (D-C2), and particularly preferably a group represented by formula (D-C1).

### [Anionic Bidentate Ligand]

Examples of the anionic bidentate ligand represented by A³-G²-A⁴ include ligands represented by the following formulas. 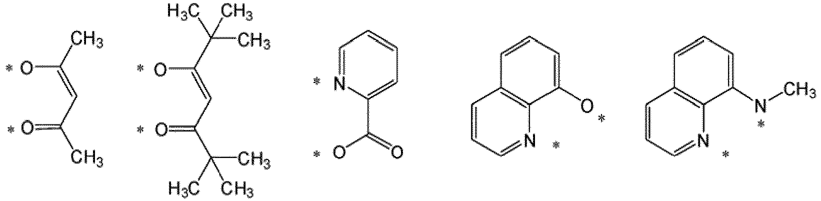 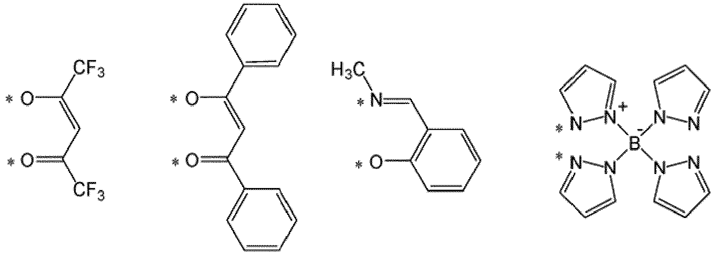 (Wherein, * represents a site that binds to M².)

The anionic bidentate ligand represented by A³-G²-A⁴ may be a ligand represented by the following formulas. 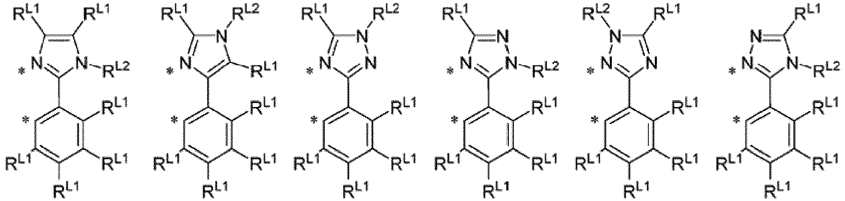
(Wherein, * represents a site that binds to M², and
R^{L1} and R^{L2} have the same meanings as described above.)

R^{L1} is preferably a hydrogen atom, an alkyl group, a cycloalkyl group, or a fluorine atom, and more preferably a hydrogen atom or an alkyl group, and these groups each may have a substituent.

R^{L2} is preferably an alkyl group, a cycloalkyl group, an aryl group, or a monovalent heterocyclic group, more preferably an aryl group or a monovalent heterocyclic group, and still more preferably an aryl group, and these group each may have a substituent.

To achieve a better external quantum efficiency of a light-emitting device comprising the composition according to the present embodiment, the phosphorescent compound represented by formula (2) is preferably a phosphorescent compound represented by formula (2-B).

When the ring L^{1B} is a pyrimidine ring, a pyrimidine ring in which E^{11B} is a nitrogen atom is preferable.

The ring L^{1B} is preferably a pyridine ring.

When the ring L^{1B} has a group represented by formula (1-T), R^{11B}, R^{12B}, or R^{13B} is preferably the group represented by formula (1-T), more preferably R^{12B} or R^{13B} is the group represented by formula (1-T), and still more preferably R^{13B} is the group represented by formula (1-T).

When the ring L^{2B} is a pyridine ring, a pyridine ring in which E^{21B} is a nitrogen atom, a pyridine ring in which E^{22B} is a nitrogen atom, or a pyridine ring in which E^{23B} is a nitrogen atom is preferable, and a pyridine ring in which E^{22B} is a nitrogen atom is more preferable.

When the ring L^{2B} is a pyrimidine ring, a pyrimidine ring in which E^{21B} and E^{23B} are nitrogen atoms or a pyrimidine ring in which E^{22B} and E^{24B} are nitrogen atoms is preferable, and a pyrimidine ring in which E^{22B} and E^{24B} are nitrogen atoms is more preferable.

The ring L^{2B} is preferably a benzene ring.

When the ring L^{2B} has a group represented by formula (1-T), R^{22B}, R^{23B}, or R^{24B} is preferably the group represented by formula (1-T), and more preferably R^{22B} or R^{23B} is the group represented by formula (1-T).

To achieve an even better external quantum efficiency of a light-emitting device comprising the composition according to the present embodiment, the phosphorescent compound represented by formula (2-B) is preferably a phosphorescent compound represented by formula (2-B1), a phosphorescent compound represented by formula (2-B2), a phosphorescent compound represented by formula (2-B3), a phosphorescent compound represented by formula (2-B4), or a phosphorescent compound represented by formula (2-B5), and more preferably a phosphorescent compound represented by formula (2-B1), a phosphorescent compound represented by formula (2-B2), or a phosphorescent compound represented by formula (2-B3).

R^{15B}, R^{16B}, R^{17B}, and R^{18B} are preferably a hydrogen atom.

Examples of the phosphorescent compound represented by formula (2) include a phosphorescent compound represented by the following formulas.

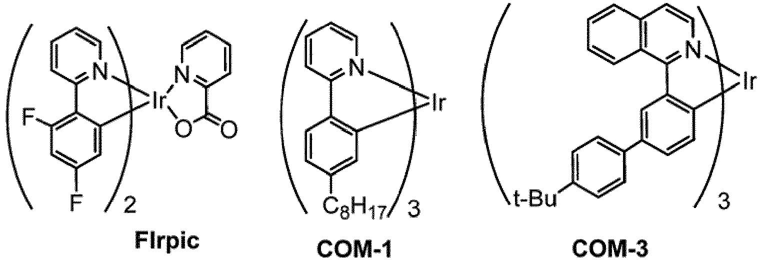

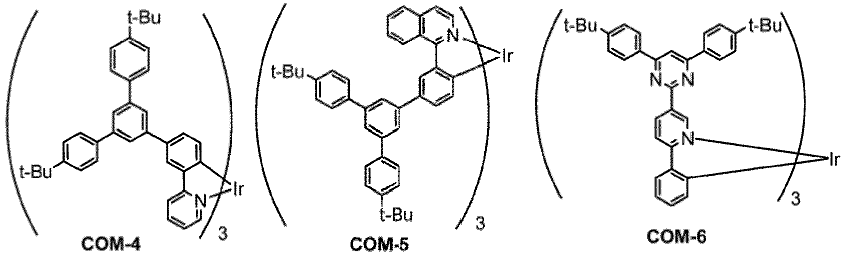

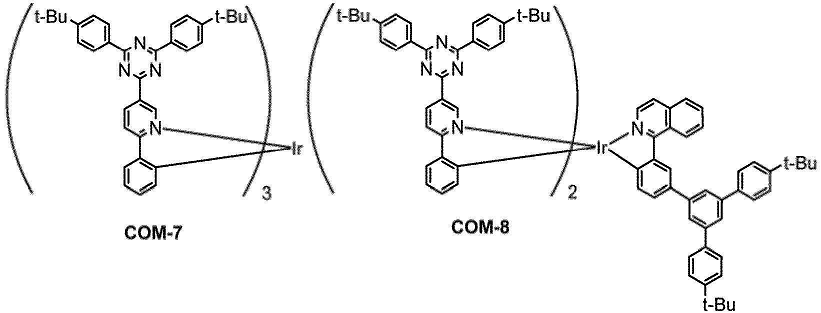

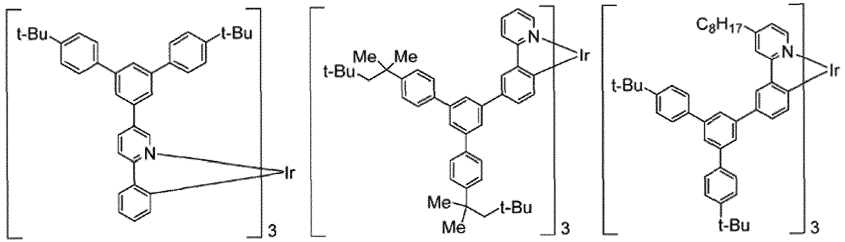

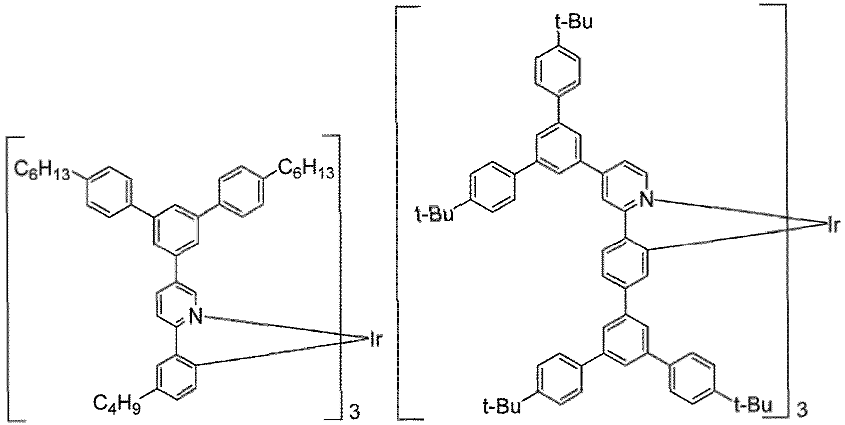

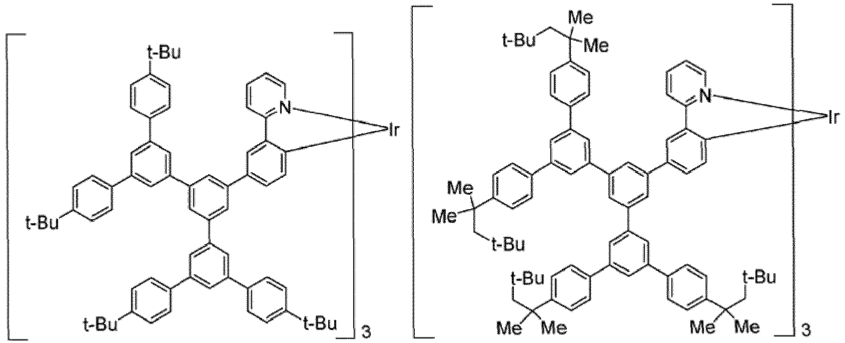

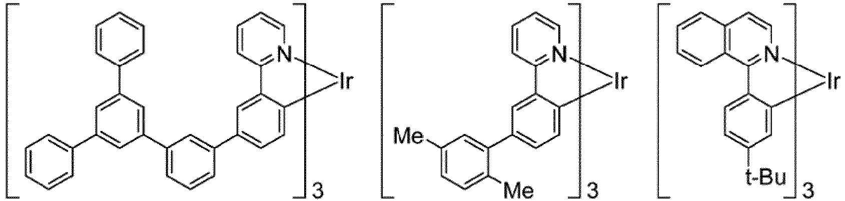

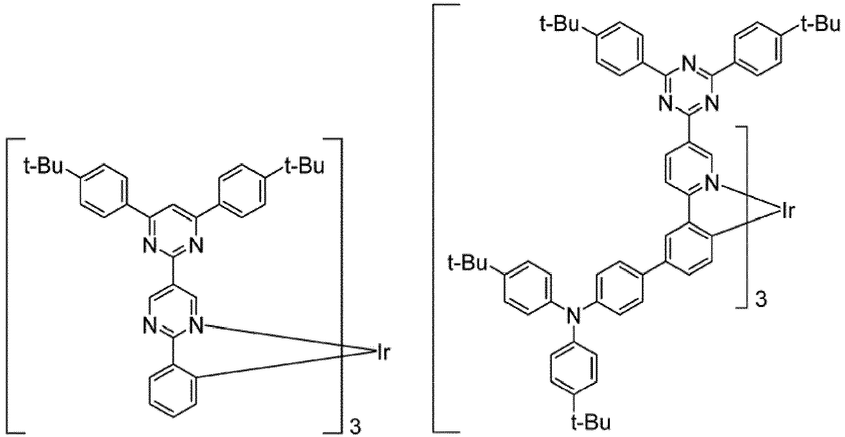

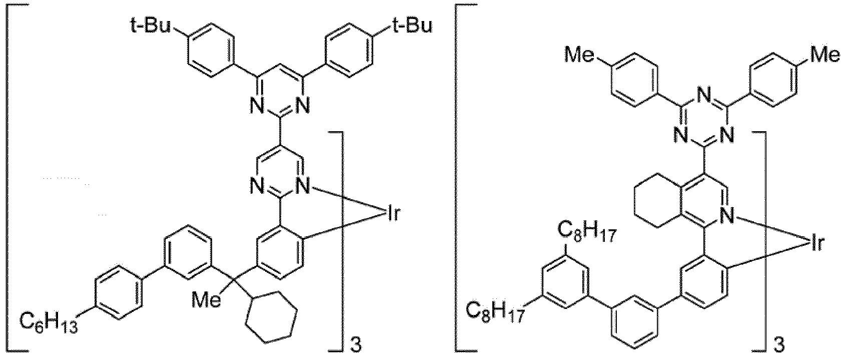

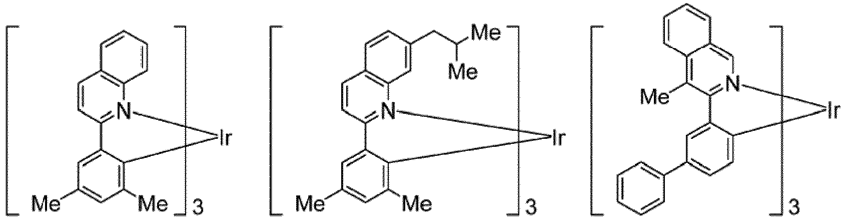

### <Composition>

The composition according to the present embodiment is a composition comprising a phosphorescent compound represented by formula (1) and a phosphorescent compound represented by formula (2).

In the composition according to the present embodiment, one phosphorescent compound represented by formula (1) may be contained singly, or two or more of them may be contained. Further, the composition according to the present embodiment may comprise a single phosphorescent compound represented by formula (2), or two or more phosphorescent compounds. To achieve a better external quantum efficiency and a better luminance lifetime of a light-emitting device comprising the composition according to the present embodiment, the composition according to the present embodiment preferably comprises two or more phosphorescent compounds represented by formula (2).

When the composition according to the present embodiment comprises two or more phosphorescent compounds represented by formula (2), to achieve a better external quantum efficiency of a light-emitting device comprising the composition according to the present embodiment, it is preferable that at least one of the two or more phosphorescent compounds represented by formula (2) be a phosphorescent compound represented by formula (2) in which the group represented by formula (1-T) is an alkyl group.

When the composition according to the present embodiment comprises two or more phosphorescent compounds represented by formula (2), to achieve an even better external quantum efficiency of a light-emitting device comprising the composition according to the present embodiment, it is preferable that a combination of at least two phosphorescent compounds represented by formula (2) be a combination of two phosphorescent compounds represented by formula (2) in which the group represented by formula (1-T) is an alkyl group, or, a combination of a phosphorescent compound represented by formula (2) in which the group represented by formula (1-T) is an alkyl group and a phosphorescent compound represented by formula (2) in which the group represented by formula (1-T) is a group represented by formula (D-A), (D-B), or (D-C).

When the composition according to the present embodiment comprises two or more phosphorescent compounds represented by formula (2), to achieve a better luminance lifetime of a light-emitting device comprising the composition according to the present embodiment, it is preferable that at least one of the two or more phosphorescent compounds represented by formula (2) be a phosphorescent compound represented by formula (2) in which the group represented by formula (1-T) is a group represented by formula (D-A), (D-B), or (D-C), and more preferably at least one be a phosphorescent compound represented by formula (2) in which the group represented by formula (1-T) is a group represented by formula (D-A).

When the composition according to the present embodiment comprises two or more phosphorescent compounds represented by formula (2), to achieve a better luminance lifetime of a light-emitting device comprising the composition according to the present embodiment, it is preferable that a combination of at least two phosphorescent compounds represented by formula (2) be a combination of a phosphorescent compound represented by formula (2) in which the group represented by formula (1-T) is an alkyl group and a phosphorescent compound represented by formula (2) in which the group represented by formula (1-T) is a group represented by formula (D-A), (D-B), or (D-C), or, a combination of two phosphorescent compounds represented by formula (2) in which the group represented by formula (1-T) is a group represented by formula (D-A), (D-B), or (D-C), and more preferably is a combination of two phosphorescent compounds represented by formula (2) in which the group represented by formula (1-T) is a group represented by formula (D-A), (D-B), or (D-C).

In the composition according to the present embodiment, the emission color can be adjusted, even to a white color, by adjusting the ratio between the content of the phosphorescent compound represented by formula (1) and the content of the phosphorescent compound represented by formula (2).

The emission color of the light-emitting device can be confirmed by determining the chromaticity coordinates (CIE chromaticity coordinates) by measuring the luminescent chromaticity of the light-emitting device. A white emission color means, for example, that the X chromaticity coordinate is within a range of 0.25 to 0.55, and the Y chromaticity coordinate is within the range of 0.25 to 0.55.

From the viewpoint of adjusting the emission color of the light-emitting device comprising the composition according to the present embodiment (in particular, adjusting the emission color to white), the maximum peak wavelength of the emission spectrum of the phosphorescent compound represented by formula (1) is usually 380 nm or more and less than 495 nm, preferably 400 nm or more and 490 nm or less, more preferably 420 nm or more and 480 nm or less, and still more preferably 450 nm or more and 475 nm or less.

From the viewpoint of adjusting the emission color of the light-emitting device comprising the composition according to the present embodiment (in particular, adjusting the emission color to white), the maximum peak wavelength of the emission spectrum of the phosphorescent compound represented by formula (2) is usually 495 nm or more and less than 750 nm, preferably 500 nm or more and 680 nm or less, and more preferably 505 nm or more and 640 nm or less.

When the composition according to the present embodiment comprises two or more phosphorescent compounds represented by formula (2), from the viewpoint of adjusting the emission color of the light-emitting device comprising the composition according to the present embodiment (in particular, adjusting the emission color to white), the maximum peak wavelength of the emission spectrum of each of the at least two phosphorescent compounds represented by formula (2) is preferably different, and that difference is preferably 100 to 200 nm, more preferably 20 to 150 nm, and more preferably 40 to 120 nm.

When the composition according to the present embodiment comprises two or more phosphorescent compounds represented by formula (2), and, when the maximum peak wavelength of the emission spectrum of each of the at least two phosphorescent compounds represented by formula (2) is different, from the viewpoint of adjusting the emission color of the light-emitting device comprising the composition according to the present embodiment (in particular, adjusting the emission color to white), the maximum peak wavelength of the emission spectrum of the phosphorescent compound represented by formula (2) whose maximum peak wavelength of the emission spectrum is on the shorter wavelength side is preferably 500 nm or more and less than 570 nm, and more preferably 505 nm or more and 560 nm or less. Also, the maximum peak wavelength of the emission spectrum of the phosphorescent compound represented by formula (2) whose maximum peak wavelength of the emission spectrum is on the longer wavelength side is preferably 570 nm or more and 680 nm or less, and more preferably 590 nm or more and 640 nm or less.

From the viewpoint of adjusting the emission color of the light-emitting device comprising the composition according to the present embodiment (in particular, adjusting the emission color to white), the total content of the phosphorescent compound(s) represented by formula (2) is, based on 100 parts by mass for the total content of the phosphorescent compound(s) represented by formula (1), preferably 0.01 to 50 parts by mass, more preferably 0.05 to 30 parts by mass, still more preferably 0.1 to 10 parts by mass, and particularly preferably 0.5 to 5 parts by mass.

When the composition according to the present embodiment comprises two or more phosphorescent compounds represented by formula (2), and, when the maximum peak wavelength of the emission spectrum of each of the at least two phosphorescent compounds represented by formula (2) is different, of the two, the content of the phosphorescent compound represented by formula (2) whose maximum peak wavelength of the emission spectrum is the longer wavelength is, based on a content of the phosphorescent compound represented by formula (2) whose maximum peak wavelength of the emission spectrum is the shorter wavelength of 100 parts by mass, usually 1 to 10,000 parts by mass, and to achieve a better color reproducibility for a light-emitting device comprising the composition according to the present embodiment, this content is preferably 5 to 1000 parts by mass, and more preferably 10 to 200 parts by mass.

When the composition according to the present embodiment comprises two or more phosphorescent compounds represented by formula (2), to achieve a better external quantum efficiency of a light-emitting device comprising the composition according to the present embodiment, at least one of the phosphorescent compounds represented by formula (2) is preferably a phosphorescent compound represented by formulas (2-B1) to (2-B5), more preferably a phosphorescent compound represented by formulas (2-B1) to (2-B3), and still more preferably a phosphorescent compound represented by formula (2-B1).

When the composition according to the present embodiment comprises two or more phosphorescent compounds represented by formula (2), to achieve a better external quantum efficiency of a light-emitting device comprising the composition according to the present embodiment, a combination of at least two phosphorescent compounds represented by formula (2) is preferably a combination of two selected from the phosphorescent compounds represented by formulas (2-B1) to (2-B5), more preferably a combination of a phosphorescent compound represented by formula (2-B1) and one selected from the phosphorescent compounds represented by formulas (2-B2) to (2-B5), and still more preferably a combination of a phosphorescent compound represented by formula (2-B1) and a phosphorescent compound represented by formula (2-B2) or (2-B3).

### <Other Components>

The composition according to the present embodiment may also further comprise at least one material selected from the group consisting of a hole transporting material, a hole injecting material, an electron transporting material, an electron injecting material, a light-emitting material (which is different from the phosphorescent compound represented by formula (1) and the phosphorescent compound represented by formula (2)), an antioxidant, and a solvent.

### [Host Material]

By further comprising a host material having at least one function selected from hole injectability, hole transportability, electron injectability, and electron transportability in the composition according to the present embodiment, the external quantum efficiency of a light-emitting device comprising the composition according to the present embodiment is better. In the composition according to the present embodiment, one host material may be contained singly, or two or more of them may be contained.

When the composition according to the present embodiment further comprises a host material, the content of the host material is, based on 100 parts by mass for the total of the phosphorescent compound represented by formula (1), the phosphorescent compound represented by formula (2), and the host material, usually 1 to 99 parts by mass, preferably 10 to 90 parts by mass, more preferably 20 to 80 parts by mass, and still more preferably 50 to 75 parts by mass.

To achieve a better external quantum efficiency of a light-emitting device comprising the composition according to the present embodiment, a lowest excited triplet state (T₁) of the host material is preferably an energy level equivalent to or higher than the lowest excited triplet state (T₁) of the phosphorescent compound represented by formula (1).

The host material is classified into a low molecular weight compound and a polymer compound, and a low molecular weight compound is preferable.

### [Low Molecular Weight Host]

Low molecular weight compounds (hereinafter referred to as "low molecular weight host") preferable as the host material will now be described.

The low molecular weight host is preferably a compound represented by formula (H-1).

Ar^{H1} and Ar^{H2} are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group, or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group, or an azacarbazolyl group, still more preferably a phenyl group, a pyridyl group, a carbazolyl group, or an azacarbazolyl group, particularly preferably a group represented by formula (TDA-1) or (TDA-3), and especially preferably a group represented by formula (TDA-3), and these groups each may have a substituent.

The optional substituent of Ar^{H1} and Ar^{H2} is preferably a halogen atom, an alkyl group, a cycloalkyl group, an alkoxy group, a cycloalkoxy group, an aryl group, or a monovalent heterocyclic group, more preferably an alkyl group, a cycloalkyl group, an alkoxy group, or a cycloalkoxy group, and still more preferably an alkyl group or a cycloalkyl group is more preferable, and these groups each may further have a substituent.

n^{H1} is preferably 1. n^{H2} is preferably 0.

n^{H3} is usually an integer of 0 to 10, preferably an integer of 0 to 5, more preferably an integer of 1 to 3, and particularly preferably 1.

n^{H11} is preferably an integer of 1 or more and 5 or less, more preferably an integer of 1 or more and 3 or less, and still more preferably 1.

R^{H11} is preferably a hydrogen atom, an alkyl group, a cycloalkyl group, an aryl group, or a monovalent heterocyclic group, more preferably a hydrogen atom, an alkyl group, or a cycloalkyl group, and still more preferably a hydrogen atom or an alkyl group, and these groups each may have a substituent.

L^{H1} is preferably an arylene group or a divalent heterocyclic group.

L^{H1} is a compound represented by formula (A-1) to (A-3), (A-8) to (A-10), (AA-1) to (AA-6), (AA-10) to (AA-21), or (A-24) to (AA-34), more preferably a group represented by formula (A-1), (A-2), (A-8), (A-9), (AA-1) to (AA-4), (AA-10) to (AA-15), or (A-29) to (AA-34), still more preferably a group represented by formula (A-1), (A-2), (A-8), (A-9), (AA-2), (AA-4), or (AA-10) to (AA-15), particularly preferably a group represented by formula (A-1), (A-2), (A-8), (AA-2), (AA-4), (AA-10), (AA-12), or (AA-14), and especially preferably a group represented by formula (A-1), (A-2), (AA-2), (AA-4), or (AA-14).

The optional substituent of L^{H1} is preferably a halogen atom, an alkyl group, a cycloalkyl group, an alkoxy group, a cycloalkoxy group, an aryl group, or a monovalent heterocyclic group, more preferably an alkyl group, an alkoxy group, an aryl group, or a monovalent heterocyclic group, and still more preferably an alkyl group, an aryl group, or a monovalent heterocyclic group, and these groups each may further have a substituent.

L^{H21} is preferably a single bond or an arylene group, and more preferably a single bond, and the arylene group may have a substituent.

The definition and examples of the arylene group or divalent heterocyclic group represented by L^{H21} are the same as the definition and examples of the arylene group or divalent heterocyclic group represented by L^{H1}.

R^{H21} is preferably an aryl group or a monovalent heterocyclic group, and these groups each may have a substituent.

The definition and examples of the aryl group or the monovalent heterocyclic group represented by R^{H21} are the same as the definition and examples of the aryl group or the monovalent heterocyclic group represented by Ar^{H1} and Ar^{H2}.

The definition and examples of the optional substituent of R^{H21} are the same as the definitions and examples of the optional substituent of Ar^{H1} and Ar^{H2}.

The compound represented by formula (H-1) is preferably a compound represented by formula (H-2). 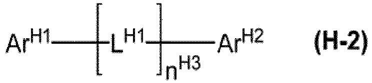 (Wherein Ar^{H1}, Ar^{H2}, n^{H3}, and L^{H1} have the same meanings as described above.)

Examples of the compound represented by formula (H-1) include the compounds represented by formulas (H-101) to (H-118).

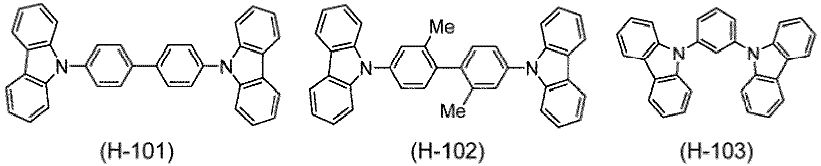

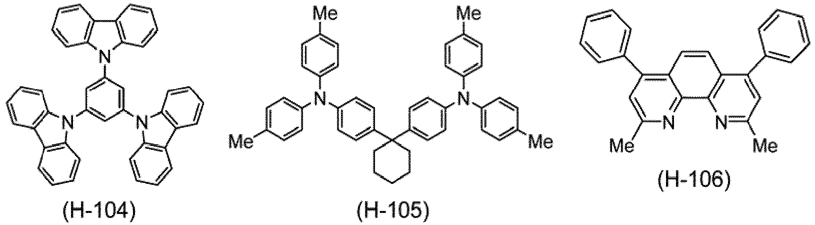

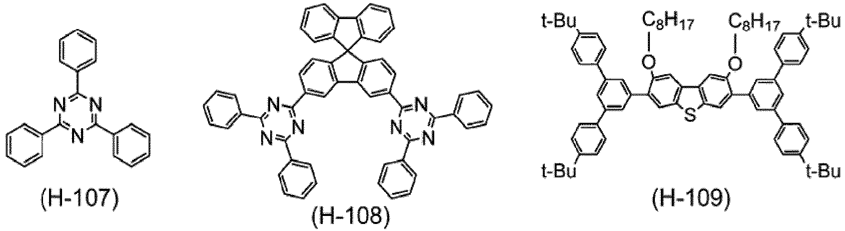

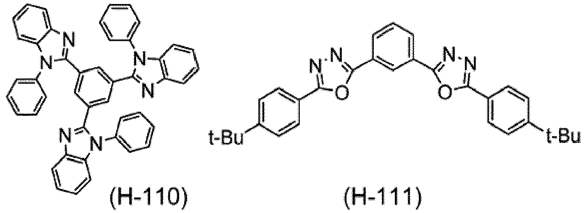

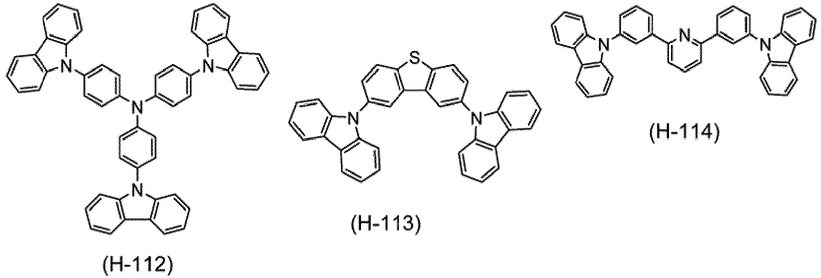

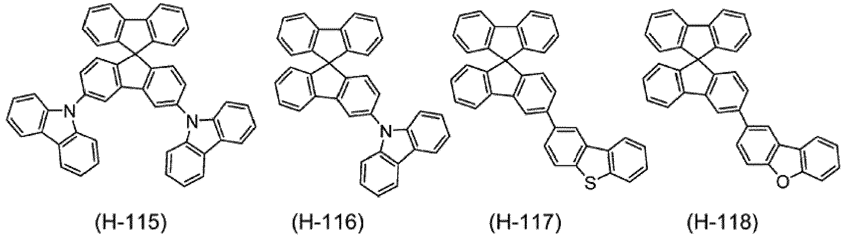

### [Polymer Host]

Examples of the polymer compound used for the host material include a polymer compound that serves as a hole transporting material (described later) and a polymer compound that serves as an electron transporting material (described later).

Polymer compound compounds that are preferable as the host material (hereinafter referred to as "polymer host") will now be described.

The polymer host is preferably a polymer compound comprising a constitutional unit represented by formula (Y).

-[-Ar^{Y1}-]- (Y)

Ar^{Y1} represents an arylene group, a divalent heterocyclic group, or a divalent group in which at least one arylene group and at least one divalent heterocyclic group are directly bonded to each other, and these groups each may have a substituent.

The arylene group represented by Ar^{Y1} is more preferably an arylene group represented by formula (A-1), (A-2), (A-6) to (A-10), (A-19), or (A-20), and still more preferably a group represented by formula (A-1), (A-2), (A-7), (A-9), or (A-19), and these groups each may have a substituent.

More preferably, the divalent heterocyclic group represented by Ar^{Y1} is a group represented by formula (AA-1) to (AA-4), (AA-10) to (AA-15), (AA-18) to (AA-21), (AA-33), or (AA-34), and still more preferably a group represented by formula (AA-4), (AA-10), (AA-12), (AA-14), or (AA-33), and these groups each may have a substituent.

The more preferable range and still more preferable range of the arylene group and divalent heterocyclic group in the divalent group represented by Ar^{Y1} in which at least one arylene group and at least one divalent heterocyclic group are directly bonded to each other are respectively the same as the more preferable range and still more preferable range of the arylene group and divalent heterocyclic group represented by Ar^{Y1} described above.

Examples of the "divalent group in which at least one arylene group and at least one divalent heterocyclic group are directly bonded to each other" include groups represented by the following formulas, and these groups each may have a substituent. 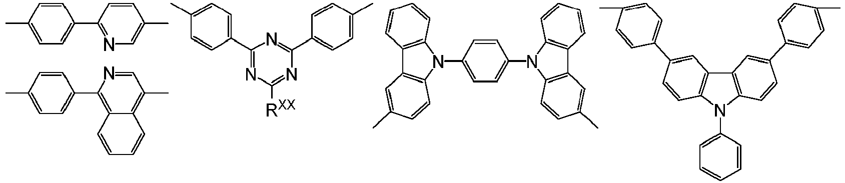 (Wherein R^{XX} represents a hydrogen atom, an alkyl group, a cycloalkyl group, an aryl group, or a monovalent heterocyclic group, and these groups each may have a substituent.)

R^{XX} is preferably an alkyl group, a cycloalkyl group, or an aryl group, and these groups each may have a substituent.

The optional substituent of the group represented by Ar^{Y1} is preferably an alkyl group, a cycloalkyl group, or an aryl group, and these groups each may further have a substituent.

Examples of the constitutional unit represented by formula (Y) include the constitutional units represented by formulas (Y-1) to (Y-10). From the viewpoint of achieving a better external quantum efficiency of the light-emitting device according to the present embodiment, the constitutional unit is preferably a constitutional unit represented by formulas (Y-1) to (Y-3). From the viewpoint of better electron transportability, the constitutional unit is preferably a constitutional unit represented by formulas (Y-4) to (Y-7). From the viewpoint of better hole transportability, the constitutional unit is preferably a constitutional unit represented by formulas (Y-8) to (Y-10). 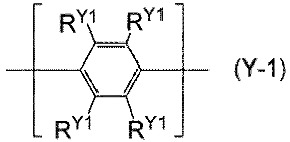 (Wherein R^{Y1} represents a hydrogen atom, an alkyl group, a cycloalkyl group, an alkoxy group, a cycloalkoxy group, an aryl group, or a monovalent heterocyclic group, and these groups each may have a substituent; and the plurality of R^{Y1} may be the same or different and adjacent R^{Y1} may be bonded to each other to form a ring together with the carbon atom to which they are bonded.)

R^{Y1} is preferably a hydrogen atom, an alkyl group, a cycloalkyl group, or an aryl group, and these groups each may have a substituent.

The constitutional unit represented by formula (Y-1) is preferably a constitutional unit represented by formula (Y-1'). 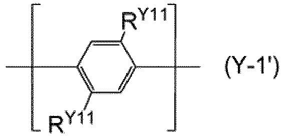 (Wherein R^{Y11} represents an alkyl group, a cycloalkyl group, an alkoxy group, a cycloalkoxy group, an aryl group, or a monovalent heterocyclic group, and these groups each may have a substituent; and the plurality of R^{Y11} may be the same or different.)

R^{Y11} is preferably an alkyl group, a cycloalkyl group, or an aryl group, and more preferably an alkyl group or a cycloalkyl group, and these groups each may have a substituent. 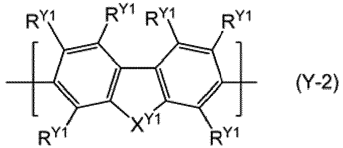 (Wherein R^{Y1} has the same meaning as described above; X^{Y1} represents a group represented by -C(R^{Y2})₂-, -C(R^{Y2})=C(R^{Y2})-, or C(R^{Y2})₂-C(R^{Y2})₂-; R^{Y2} represents a hydrogen atom, an alkyl group, a cycloalkyl group, an alkoxy group, a cycloalkoxy group, an aryl group, or a monovalent heterocyclic group, and these groups each may have a substituent; and the plurality of R^{Y2} may be the same or different, and R^{Y2} may be bonded to another R^{Y2} to form a ring together with the carbon atom to which they are bonded.)

R^{Y2} is preferably an alkyl group, a cycloalkyl group, an aryl group, or a monovalent heterocyclic group, and more preferably an alkyl group, a cycloalkyl group, or an aryl group, and these groups each may have a substituent.

In X^{Y1}, the combination of the two R^{Y2} groups in the group represented by -C(R^{Y2})₂- is preferably a combination in which both groups are alkyl groups or cycloalkyl groups, a combination in which both groups are aryl groups, a combination in which both groups are monovalent heterocyclic groups, or a combination in which one group is an alkyl group or a cycloalkyl group and the other group is an aryl group or a monovalent heterocyclic group, and more preferably is a combination in which one group is an alkyl group or a cycloalkyl group and the other group is an aryl group, and these groups each may have a substituent. Two present R^{Y2} groups may be bonded to each other to form a ring together with the atoms to which they are bonded. When R^{Y2} forms a ring, the group represented by -C(R^{Y2})₂- is preferably a group represented by formulas (Y-A1) to (Y-A5), and more preferably a group represented by formula (Y-A4), and these groups each may have a substituent.

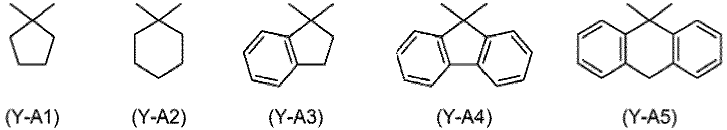

In X^{Y1}, the combination of the two R^{Y2} groups in the group represented by -C(R^{Y2})=C(R^{Y2})- is preferably a combination in which both groups are alkyl groups or cycloalkyl groups or a combination in which one group is an alkyl group or a cycloalkyl group and the other group is an aryl group, and these groups each may have a substituent.

In X^{Y1}, the four R^{Y2} in the group represented by -C(R^{Y2})₂-C(R^{Y2})₂- are preferably an optionally substituted alkyl group or cycloalkyl group. The plurality of R^{Y2} may be bonded to each other to form a ring together with the atoms to which they are bonded, and when R^{Y2} forms a ring, a group represented by -C(R^{Y2})₂-C(R^{Y2})₂- is preferably a group represented by formulas (Y-B1) to (Y-B5), and more preferably a group represented by formula (Y-B3), and these groups each may have a substituent. 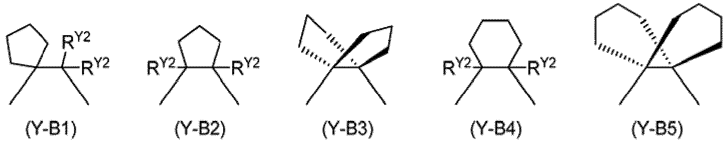 (Wherein R^{Y2} has the same meaning as described above.)

The constitutional unit represented by formula (Y-2) is preferably a constitutional unit represented by formula (Y-2'). 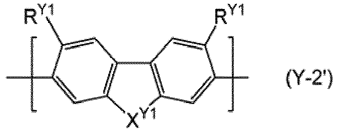 (Wherein R^{Y1} and X^{Y1} have the same meanings as described above.) 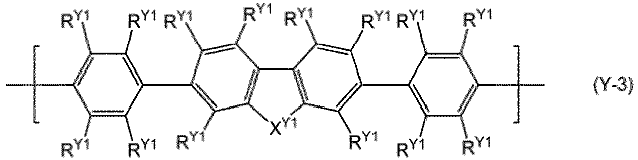 (Wherein R^{Y1} and X^{Y1} have the same meanings as described above.)

The constitutional unit represented by formula (Y-3) is preferably a constitutional unit represented by formula (Y-3'). 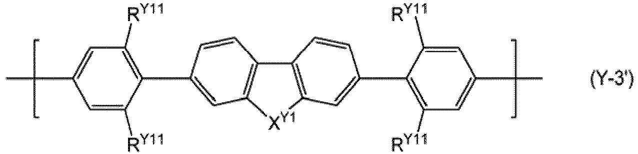 (Wherein R^{Y11} and X^{Y1} have the same meanings as described above.) 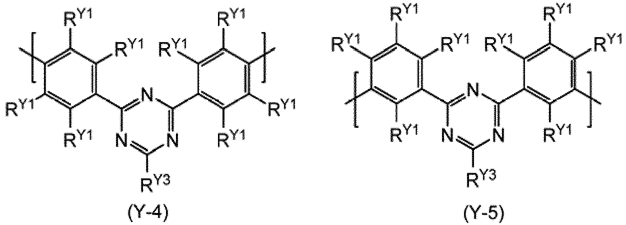 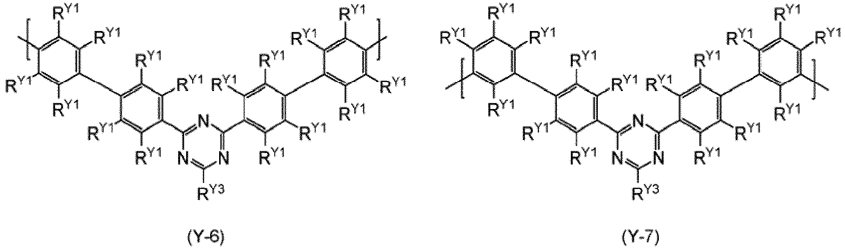 (Wherein R^{Y1} has the same meaning as described above; R^{Y3} represents a hydrogen atom, an alkyl group, a cycloalkyl group, an alkoxy group, a cycloalkoxy group, an aryl group, or a monovalent heterocyclic group, and these groups each may have a substituent.)

R^{Y3} is preferably an alkyl group, a cycloalkyl group, an alkoxy group, a cycloalkoxy group, an aryl group, or a monovalent heterocyclic group, and more preferably an aryl group, and these groups each may have a substituent.

The constitutional unit represented by formula (Y-4) is preferably a constitutional unit represented by formula (Y-4'), and the constitutional unit represented by formula (Y-6) is preferably a constitutional unit represented by formula (Y-6'). 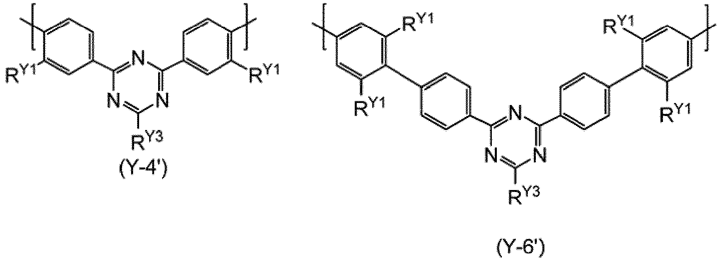 (Wherein R^{Y1} and R^{Y3} have the same meanings as described above.) 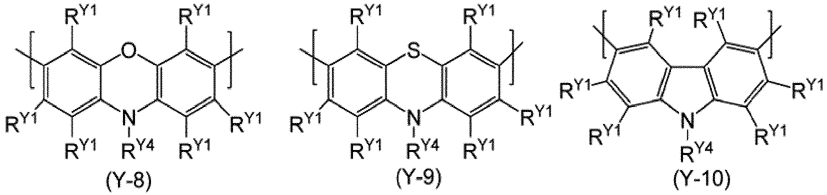 (Wherein R^{Y1} has the same meaning as described above; R^{Y4} represents a hydrogen atom, an alkyl group, a cycloalkyl group, an alkoxy group, a cycloalkoxy group, an aryl group, or a monovalent heterocyclic group, and these groups each may have a substituent.)

R^{Y4} is preferably an alkyl group, a cycloalkyl group, an alkoxy group, a cycloalkoxy group, an aryl group, or a monovalent heterocyclic group, and more preferably an aryl group. These groups each may have a substituent.

Examples of the constitutional unit represented by formula (Y) include constitutional units composed of arylene groups represented by formulas (Y-101) to (Y-121), constitutional units composed of divalent heterocyclic groups represented by formulas (Y-201) to (Y-206), and constitutional units composed of a divalent group represented by formulas (Y-300) to (Y-304) in which at least one arylene group and at least one divalent heterocyclic group are directly bonded to each other, and preferably constitutional units composed of arylene groups represented by formulas (Y-101) to (Y-121), constitutional units composed of divalent heterocyclic groups represented by formulas (Y-201) to (Y-206), and constitutional units composed of a divalent group represented by formulas (Y-301) to (Y-304) in which at least one arylene group and at least one divalent heterocyclic group are directly bonded to each other.

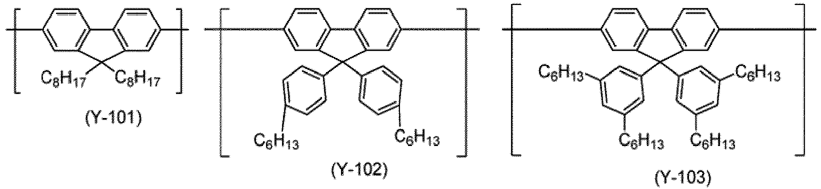

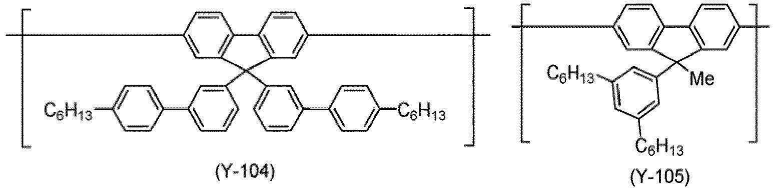

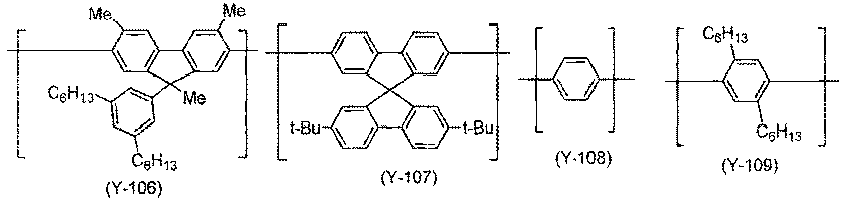

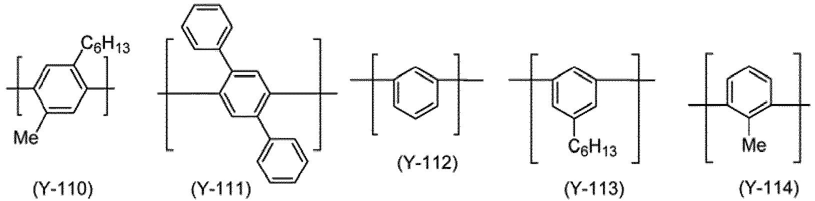

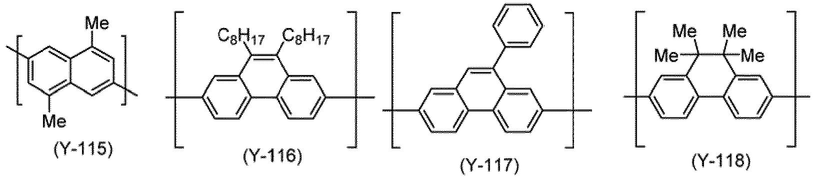

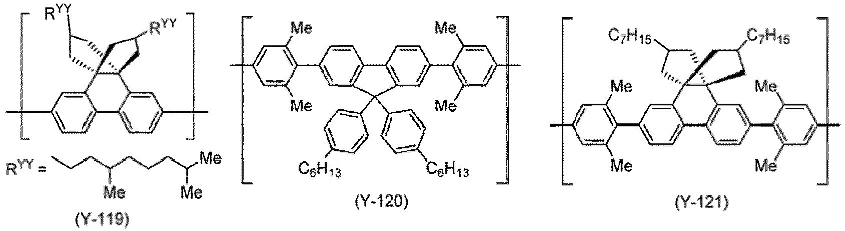

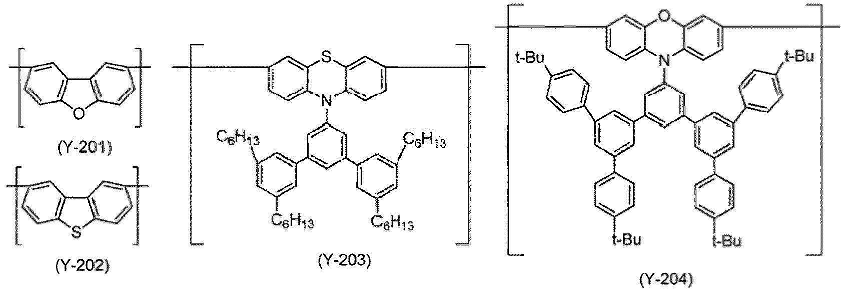

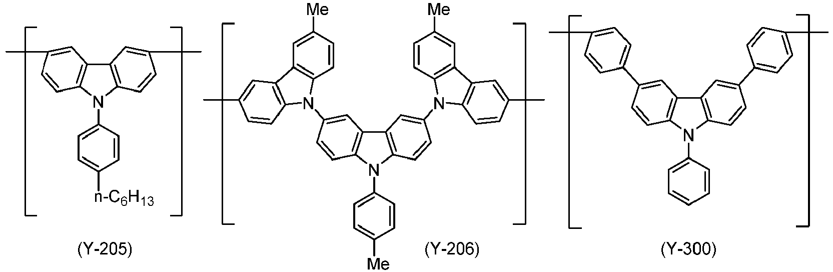

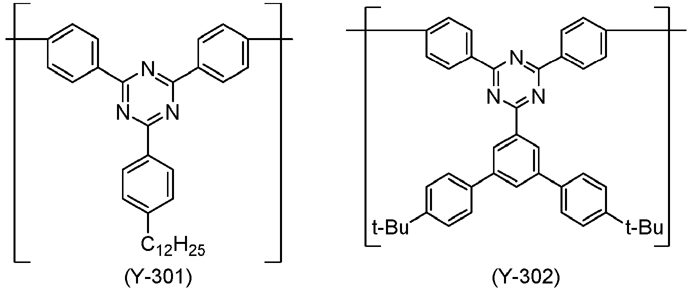

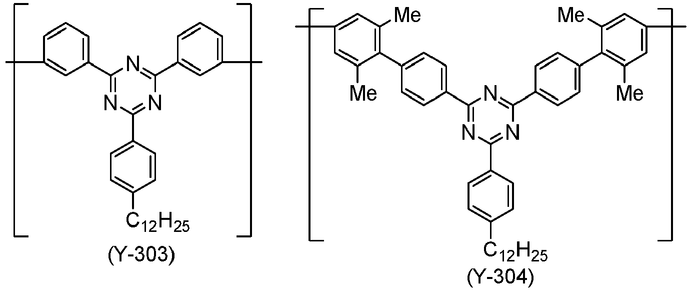

To achieve a better external quantum efficiency of the light-emitting device according to the present embodiment, the content of the constitutional unit represented by formula (Y) in which Ar^{Y1} is an arylene group is preferably 0.5 to 90 mol%, and more preferably 30 to 80 mol%, based on the total amount of constitutional units contained in the polymer host.

To achieve better charge transportability of the light-emitting device according to the present embodiment, the content of the constitutional unit represented by formula (Y) in which Ar^{Y1} is a divalent heterocyclic group or a divalent group in which at least one arylene group and at least one divalent heterocyclic group are directly bonded to each other is preferably 0.5 to 40 mol%, and more preferably 3 to 30 mol%, based on the total amount of constitutional units contained in the polymer host.

Only one constitutional unit represented by formula (Y) may be contained or two or more of them may be contained in the polymer host.

To achieve better hole transportability, it is preferable that the polymer host further comprises a constitutional unit represented by formula (X). 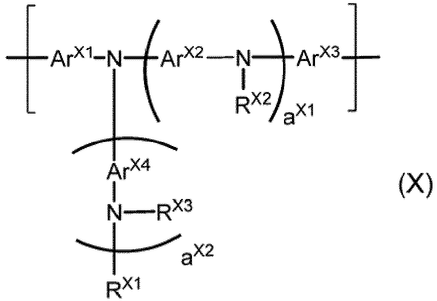 (Wherein,
a^{X1} and a^{X2} each independently denote an integer of 0 or more,
Ar^{X1} and Ar^{X3} each independently represent an arylene group or a divalent heterocyclic group, and these groups each may have a substituent,
Ar^{X2} and Ar^{X4} each independently represent an arylene group, a divalent heterocyclic group, or a divalent group in which at least one arylene group and at least one divalent heterocyclic group are directly bonded to each other, and these groups each may have a substituent; and when there are a plurality of Ar^{X2} and Ar^{X4}, they may be the same or different at each occurrence,
R^{X1}, R^{X2}, and R^{X3} each independently represent a hydrogen atom, an alkyl group, a cycloalkyl group, an aryl group, or a monovalent heterocyclic group, and these groups each may have a substituent; and when there are a plurality of R^{X2} and R^{X3}, they may be the same or different at each occurrence.)

a^{X1} is preferably 2 or less, and more preferably 1, because the external quantum efficiency of the light-emitting device according to the present embodiment is better.

a^{X2} is preferably 2 or less, and more preferably 0, because the external quantum efficiency of the light-emitting device according to the present embodiment is better.

R^{X1}, R^{X2} and R^{X3} are preferably an alkyl group, a cycloalkyl group, an aryl group, or a monovalent heterocyclic group, and more preferably an aryl group, and these groups each may have a substituent.

The arylene group represented by Ar^{X1} and Ar^{X3} is more preferably a group represented by formula (A-1) or (A-9), and still more preferably a group represented by formula (A-1), and these groups each may have a substituent.

The divalent heterocyclic group represented by Ar^{X1} and Ar^{X3} is more preferably a group represented by formula (AA-1), (AA-2), or (AA-7) to (AA-26), and these groups each may have a substituent.

Ar^{X1} and Ar^{X3} are preferably an arylene group which may have a substituent.

The arylene group represented by Ar^{X2} and Ar^{X4} is more preferably an arylene group represented by formula (A-1), (A-6), (A-7), (A-9) to (A-11), or (A-19), and these groups each may have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and still more preferable range of the arylene group and the divalent heterocyclic group in the divalent group represented by Ar^{X2} and Ar^{X4} in which at least one arylene group and at least one divalent heterocyclic group are directly bonded to each other are respectively the same as the more preferable range and still more preferable range of the arylene group and the divalent heterocyclic group represented by Ar^{X1} and Ar^{X3}.

Examples of the divalent group represented by Ar^{X2} and Ar^{X4} in which at least one arylene group and at least one divalent heterocyclic group are directly bonded to each other include the same divalent groups represented by Ar^{Y1} of formula (Y) in which at least one arylene group and at least one divalent heterocyclic group are directly bonded to each other.

Ar^{X2} and Ar^{X4} are preferably an arylene group which may have a substituent.

The optional substituent of the groups represented by Ar^{X1} to Ar^{X4} and R^{X1} to R^{X3} is preferably an alkyl group, a cycloalkyl group, or an aryl group, and these groups each may further have a substituent.

The constitutional unit represented by formula (X) is preferably a constitutional unit represented by formulas (X-1) to (X-7), more preferably a constitutional unit represented by formulas (X-1) to (X-6), and still more preferably a constitutional unit represented by formulas (X-3) to (X-6). 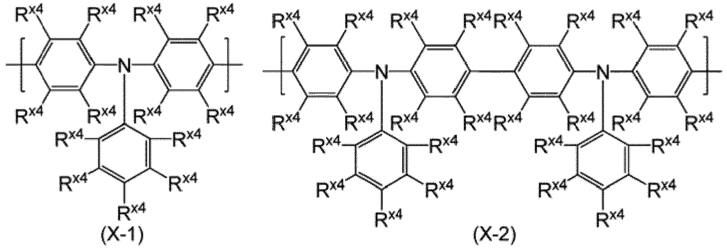 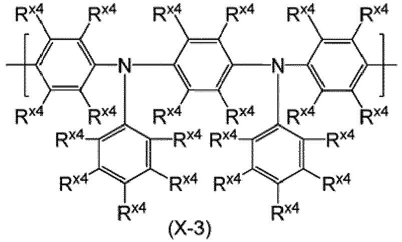 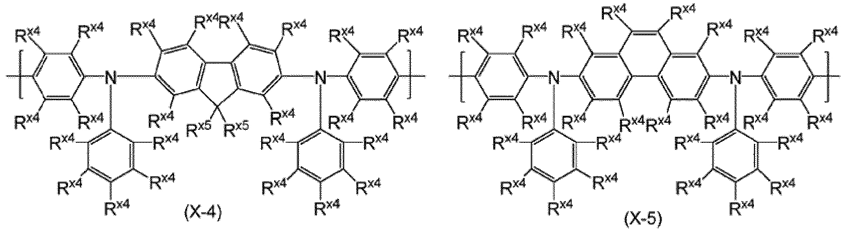 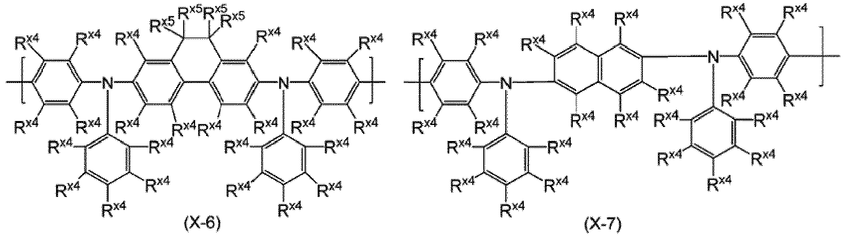 (Wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group, or a cyano group, and these groups each may have a substituent; the plurality of R^{X4} may be the same or different; and the plurality of R^{X5} may be the same or different, and adjacent R^{X5} may be bonded to each other to form a ring together with the carbon atom to which they are bonded.)

To achieve better hole transportability, the content of the constitutional unit represented by formula (X) is preferably 0.1 to 50 mol%, more preferably 1 to 40 mol%, and still more preferably 5 to 30 mol%, based on the total amount of constitutional units contained in the polymer host.

Examples of the constitutional unit represented by formula (X) include constitutional units represented by formulas (X1-1) to (X1-11). The constitutional unit represented by formula (X) is preferably a constitutional unit represented by formulas (X1-3) to (X1-10).

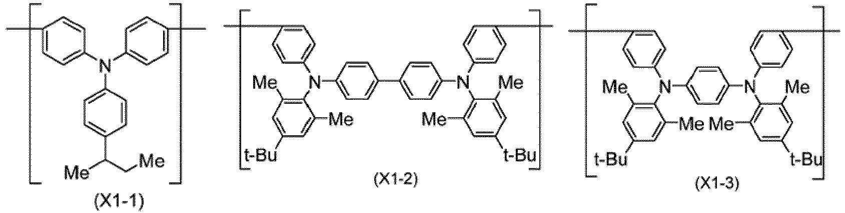

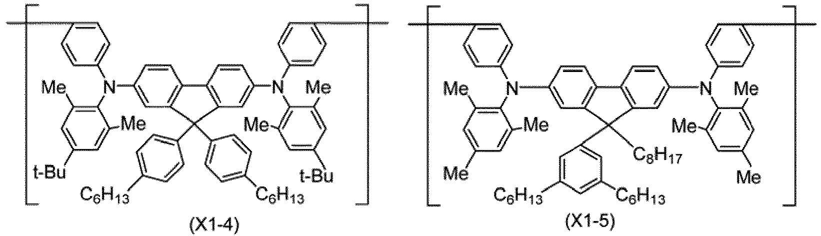

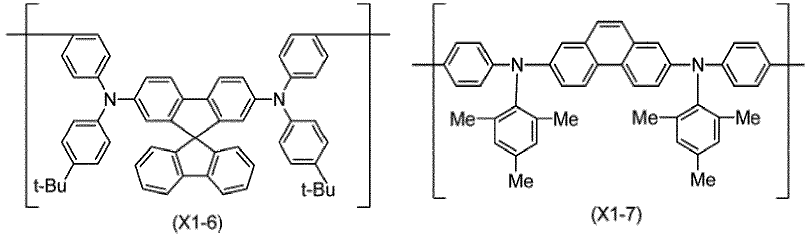

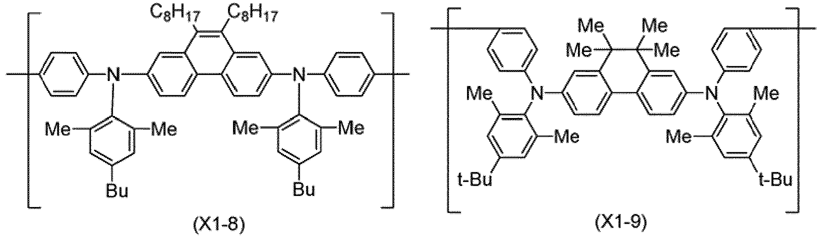

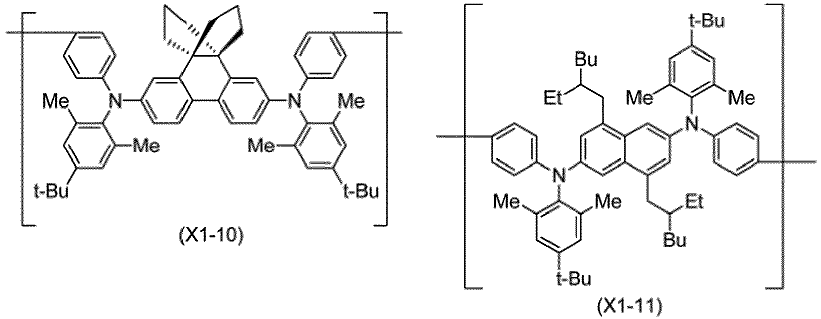

In the polymer host, only one constitutional unit represented by formula (X) may be contained or two or more of them may be contained.

Examples of the polymer host include the polymer compounds (P-1) to (P-6) in Table 1.

**[Table 1]**

| Polymer Compound | Constitutional units and Molar Ratios Thereof | | | | |
|---|---|---|---|---|---|
| | Formula (Y) | | | Formula (X) | Other |
| | Formula (Y-1) to (Y-3) | Formula (Y-4) to (Y-7) | Formula (Y-8) to (Y-10) | Formula (X-1) to (Y-7) | |
| | p | q | r | s | t |
| (P-1) | 0.1-99.9 | 0.1-99.9 | 0 | 0 | 0-30 |
| (P-2) | 0.1-99.9 | 0 | 0.1-99.9 | 0 | 0-30 |
| (P-3) | 0.1-99.8 | 0.1-99.8 | 0 | 0.1-99.8 | 0-30 |
| (P-4) | 0.1-99.8 | 0.1-99.8 | 0.1-99.8 | 0 | 0-30 |
| (P-5) | 0.1-99.8 | 0 | 0.1-99.8 | 0.1-99.8 | 0-30 |
| (P-6) | 0.1-99.7 | 0.1-99.7 | 0.1-99.7 | 0.1-99.7 | 0-30 |

In Table 1, p, q, r, s, and t represent the molar ratio of each constitutional unit, p + q + r + s + t = 100 and 100 ≥ p + q + r + s ≥ 70, the heading "Other" means a constitutional unit other than the constitutional unit represented by formula (Y) and the constitutional unit represented by formula (X).

The polymer host may be any of a block copolymer, a random copolymer, an alternating copolymer, and a graft copolymer, or may even be some other form, but it is preferable that the polymer host is a copolymer obtained by copolymerizing a plurality of raw material monomers.

### [Method for Producing Polymer host]

The polymer host can be produced by using a known polymerization method described in Chem. Rev., Vol. 109, pp. 897-1091 (2009) and the like. Examples of such a method include a polymerization method by a coupling reaction using a transition metal catalyst, such as in a Suzuki reaction, a Yamamoto reaction, a Buchwald reaction, a Stille reaction, a Negishi reaction, or a Kumada reaction.

In the polymerization method, examples of the method for charging the monomers may include a method in which all the monomers are charged all at once into the reaction system, a method in which a part of the monomers is charged and made to react, and then the remaining monomers are charged all at once, continuously, or in several stages, and a method in which the monomers are charged continuously or in several stages.

Examples of the transition metal catalyst include a palladium catalyst, a nickel catalyst and the like.

Workup is carried out by known methods, for example, a method in which water-soluble impurities are removed by liquid separation and a method in which a lower alcohol such as methanol is added to a reaction liquid after a polymerization reaction, and deposited sediments are filtered out and then dried, used singly or in combination. When the purity of the polymer host is low, the polymer host can be purified by a common method, for example, recrystallization, reprecipitation, continuous extraction with a Soxhlet extractor, column chromatography, and the like.

### [Hole Transporting Material]

The hole transporting material is classified into a low molecular weight compound and a polymer compound, and a polymer compound is preferable. The hole transporting material may have a crosslinkable group.

Examples of the low molecular weight compounds include aromatic amine compounds such as triphenylamine and derivatives thereof, N,N'-di-1-naphthyl-N,N'-diphenylbenzidine (α-NPD), and N,N'-diphenyl-N,N'-di(m-tolyl)benzidine (TPD).

Examples of the polymer compounds include polyvinylcarbazole and derivatives thereof; and polyarylene having an aromatic amine structure in a side chain or main chain and derivatives thereof. The polymer compound may be a compound to which an electron accepting site is bound. Examples of the electron accepting moiety include fullerene, tetrafluorotetracyanoquinodimethane, tetracyanoethylene, trinitrofluorenone and the like, and fullerene is preferable.

When the composition according to the present embodiment comprises the hole transporting material, the amount of the hole transporting material is, based on 100 parts by mass for the total of the phosphorescent compound represented by formula (1) and the phosphorescent compound represented by formula (2), usually 1 to 400 parts by mass, and preferably 5 to 150 parts by mass.

One hole transporting material may be used alone, or two or more hole transporting materials may be used in combination.

### [Electron Transporting Material]

The electron transporting materials are classified into a low molecular weight compound and a polymer compound. The electron transporting material may have a crosslinkable group.

Examples of the low molecular weight compound include metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, and diphenoquinone, and derivatives of these.

Examples of the polymer compound include polyphenylene, polyfluorene, and derivatives thereof. The polymer compound may be doped with a metal.

When the composition according to the present embodiment comprises the electron transporting material, the amount of the electron transporting material blended is, based on 100 parts by mass for the total of the phosphorescent compound represented by formula (1) and the phosphorescent compound represented by formula (2), usually 1 to 400 parts by mass, and preferably 5 to 150 parts by mass.

One electron transporting material may be used alone, or two or more hole transporting materials may be used in combination.

### [Hole Injecting Material and Electron Injecting Material]

The hole injecting material and the electron injecting material are each classified into a low molecular weight compound and a polymer compound. The hole injecting material and the electron injecting material may have a crosslinkable group.

Examples of the low molecular weight compound include metal phthalocyanines such as copper phthalocyanine; carbon; metal oxides of molybdenum, tungsten, and the like; and metal fluorides such as lithium fluoride, sodium fluoride, cesium fluoride, and potassium fluoride.

Examples of the polymer compound include conductive polymers such as polyaniline, polythiophene, polypyrrole, polyphenylenevinylene, polythienylenevinylene, polyquinoline, and polyquinoxaline, and derivatives of these; and polymers comprising an aromatic amine structure in the main chain or side chain.

When the composition according to the present embodiment comprises the hole injecting material and the electron injecting material, the amount of the hole injecting material and the electron injecting material blended is respectively, based on 100 parts by mass for the total of the phosphorescent compound represented by formula (1) and the phosphorescent compound represented by formula (2), usually 1 to 400 parts by mass, and preferably 5 to 150 parts by mass.

One of each of the electron transporting material and the hole transporting material may be used alone, or two or more of each of the electron transporting material and the hole transporting material may be used in combination.

### [Ion Doping]

When the hole injecting material or the electron injecting material comprises a conductive polymer, the electrical conductivity of the conductive polymer is preferably 1 × 10⁻⁵ S/cm to 1 × 10³ S/cm. The conductive polymer can be doped with an appropriate amount of ions in order to set the electrical conductivity of the conductive polymer in such a range.

The type of ion to be doped is an anion for the hole injecting material and a cation for the electron injecting material. Examples of the anion include polystyrenesulfonic acid ions, alkylbenzenesulfonic acid ions, and camphorsulfonic acid ions. Examples of the cation include lithium ions, sodium ions, potassium ions, and tetrabutylammonium ions.

One type of ion to be doped may be used alone, or two or more types of ion to be doped may be used.

### [Light-Emitting Material]

The light-emitting material (which is different from the phosphorescent compound represented by formula (1) and the phosphorescent compound represented by formula (2)) is classified into a low molecular weight compound and a polymer compound. The light-emitting material may have a crosslinkable group.

Examples of the low molecular weight compound include phosphorescent compounds such as naphthalene and derivatives thereof, anthracene and derivatives thereof, perylene and derivatives thereof, as well as a phosphorescent compound (hereinafter also referred to as "another phosphorescent compound") different from the phosphorescent compound represented by formula (1) and the phosphorescent compound represented by formula (2). Examples of the another phosphorescent compound include a phosphorescent compound having iridium, platinum, or europium as a central metal atom.

Examples of the polymer compound include a polymer compound comprising a phenylene group, a naphthalenediyl group, a fluorenediyldiyl group, a phenanthrenediyl group, a dihydrophenanthrenediyl group, a group represented by formula (X), a carbazolediyl group, a phenoxazinediyl group, a phenothiazinediyl group, an anthracenediyl group, a pirenediyl group, and the like.

The light-emitting material is preferably the another phosphorescent compound.

Examples of the another phosphorescent compound include the compounds shown below.

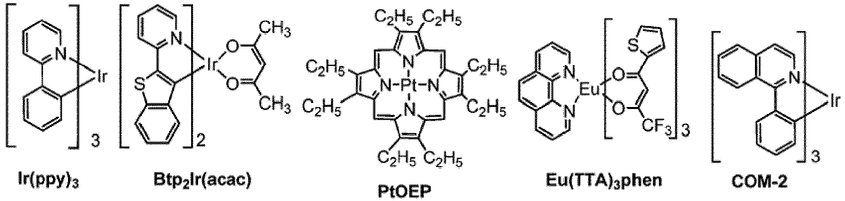

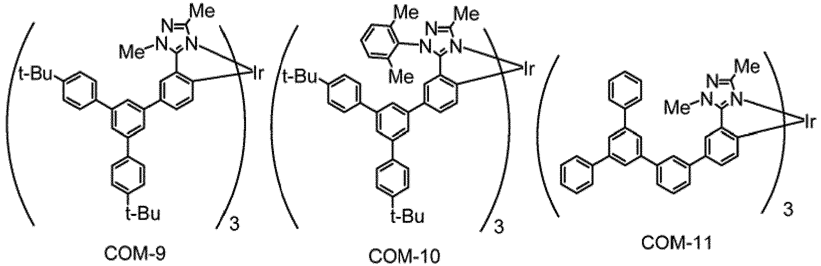

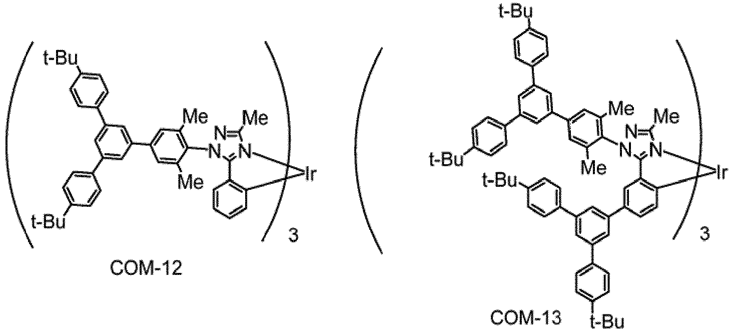

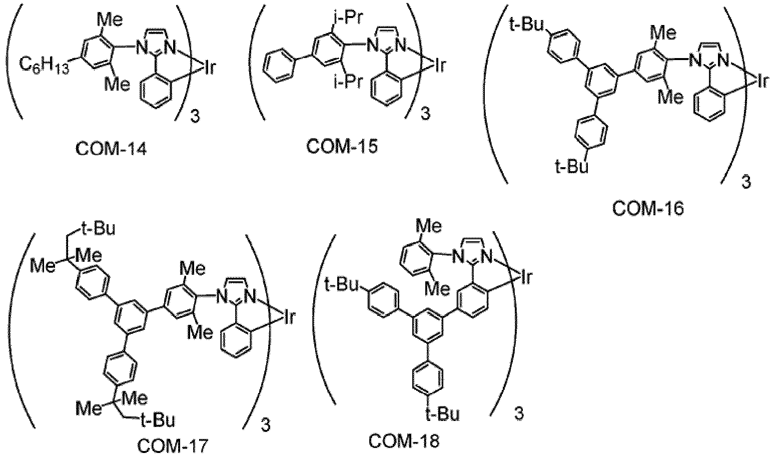

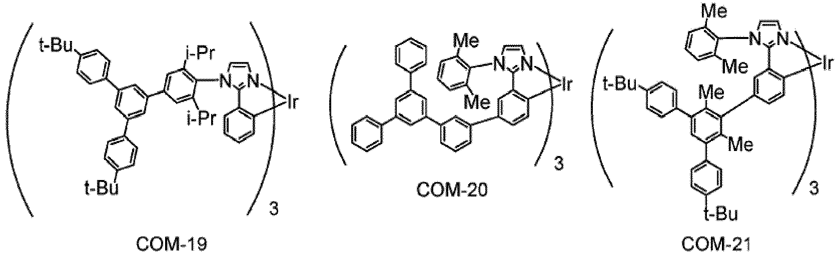

In the composition according to the present embodiment, the content of the light-emitting material is, based on 100 parts by mass for the total of the phosphorescent compound represented by formula (1) and the phosphorescent compound represented by formula (2), usually 0.001 to 10 parts by mass.

### [Antioxidant]

The antioxidant may be any compound that is soluble in the same solvent as the phosphorescent compound represent by formula (1) and the phosphorescent compound represent by formula (2), and that does not inhibit light emission and charge transporting. Examples of the antioxidant include a phenol type antioxidant and a phosphorus type antioxidant.

In the composition according to the present embodiment, the content of the antioxidant blended is, based on 100 parts by mass for the total of the phosphorescent compound represented by formula (1) and the phosphorescent compound represented by formula (2), usually 0.001 to 10 parts by mass.

One antioxidant may be used alone, or two or more antioxidants may be used in combination.

### <Ink>

The composition according to the present embodiment may also comprise a solvent. Hereinafter, the solvent-comprising composition according to the present embodiment is referred to as an "ink".

The ink according to the present embodiment can be suitably used in a coating method such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The viscosity of the ink according to the present embodiment may be adjusted according to the type of coating method. However, when a solution of an ink jet printing method is applied in a printing method that employs an ejection apparatus, the viscosity is preferably 1 to 30 mPa·s at 25°C in order to prevent clogging and curved flight during ejection.

The solvent contained in the ink according to the present embodiment is preferably a solvent capable of dissolving or uniformly dispersing the solid content in the ink. Examples of the solvent include chlorinated solvents such as 1,2-dichloroethane, 1,1,2-trichloroethane, chlorobenzene, and o-dichlorobenzene; ether solvents such as THF, dioxane, anisole, and 4-methylanisole; aromatic hydrocarbon solvents such as toluene, xylene, mesitylene, ethylbenzene, n-hexylbenzene, and cyclohexylbenzene; aliphatic hydrocarbon solvents such as cyclohexane, methylcyclohexane, n-pentane, n-hexane, n-heptane, n-octane, n-nonane, n-decane, n-dodecane, and bicyclohexyl; ketone solvents such as acetone, methyl ethyl ketone, cyclohexanone, and acetophenone; ester solvents such as ethyl acetate, butyl acetate, ethyl cellosolve acetate, methyl benzoate, and phenyl acetate; polyhydric alcohol solvents such as ethylene glycol, glycerin, and 1,2-hexanediol; alcohol solvents such as isopropyl alcohol and cyclohexanol; and sulfoxide solvents such as dimethylsulfoxide; amide solvents such as N-methyl-2-pyrrolidone and N,N-dimethylformamide. One solvent may be used alone, or two or more solvents may be used in combination.

In the ink according to the present embodiment, the content of the solvent blended is, based on 100 parts by mass for the total of the phosphorescent compound represented by formula (1) and the phosphorescent compound represented by formula (2), usually 1000 to 100000 parts by mass, and preferably 2000 to 20000.

The ink according to the present embodiment may include a component other than the phosphorescent compound represented by formula (1), the phosphorescent compound represented by formula (2), and the solvent. For example, the ink according to the present embodiment can further include at least one material selected from the group consisting of the above-mentioned host material, hole transporting material, hole injecting material, electron transporting material, electron injecting material, light-emitting material (which is different from the phosphorescent compound represented by formula (1) and the phosphorescent compound represented by formula (2)), and antioxidant.

### <Film>

The film comprises a phosphorescent compound represented by formula (1) and a phosphorescent compound represented by formula (2).

The film is suitable as a light-emitting layer in a light-emitting device.

The film can be produced by using the ink according to the present embodiment in a coating method such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The thickness of the film is usually 1 nm to 10 µm.

### <Light-Emitting Device>

The light-emitting device according to the present embodiment is a light-emitting device comprising the composition according to the present embodiment.

The light-emitting device according to the present embodiment includes, for example, an anode, a cathode, and a layer comprising the composition according to the present embodiment provided between the anode and the cathode.

### [Layer Structure]

The layer comprising the composition according to the present embodiment is usually one or more layers of the light-emitting layer, the hole transporting layer, the hole injecting layer, the electron transporting layer, and the electron injecting layer, and preferably the light-emitting layer. Each of these layers comprises the light-emitting material, the hole transporting material, the hole injecting material, the electron transporting material, and the electron injecting material. Examples of the method for forming these layers include, when using a low molecular weight compound, for example, a vacuum evaporation method from a powder and a film-formation method from a solution or a melted state can be cited, and when using a polymer compound, for example, a film-formation method from a solution or a melted state. Each layer can be formed, for example, by dissolving the light-emitting material, the hole transporting material, the hole injecting material, the electron transporting material, and the electron injecting material in the above-mentioned solvent to prepare an ink-state composition, and then using the ink-state composition to form the layers by the same coating method as for producing the above-mentioned film.

A light-emitting device has a light-emitting layer between an anode and a cathode. From the viewpoints of hole injectability and the hole transportability, the light-emitting device according to the present embodiment preferably has at least one layer hole injecting layer and at least one hole transporting layer between the anode and the light-emitting layer, and from the viewpoints of electron injectability and electron transportability, preferably has at least one electron injecting layer and at least one electron transporting layer between the cathode and the light-emitting layer.

Examples of the materials for the hole transporting layer, the electron transporting layer, the light-emitting layer, the hole injecting layer and the electron injecting layer include, in addition to the composition according to the present embodiment, each of the various hole transporting materials, electron transporting materials, light-emitting materials, hole injecting materials, and electron injecting materials described above.

When the material of the hole transporting layer, the material of the electron transporting layer, and the material of the light-emitting layer each dissolve in the solvent used when forming the layer adjacent to the hole transporting layer, the electron transporting layer, and the light-emitting layer, in order to avoid those materials dissolving in the solvent during the production of the light-emitting device, those materials preferably have a crosslinkable group. By forming the layers using a material having a crosslinkable group and then crosslinking the crosslinkable group, the layers can be made insoluble.

The order and number of layers to be laminated and the thickness of each layer can be adjusted in consideration of luminous efficiency, luminance lifetime, and the like.

When the light-emitting device according to the present embodiment comprises a hole transporting layer, the hole transporting material used to form the hole transporting layer is preferably a polymer compound (hereinafter also referred to as "polymer compound of the hole transporting layer") including a constitutional unit represented by formula (X) and at least one constitutional unit selected from the group consisting of a constitutional unit represented by formula (3) and a constitutional unit represented by formula (4). The polymer compound of the hole transporting layer may further comprise a constitutional unit represented by formula (Y).

When the light-emitting device according to the present embodiment comprises a hole transporting layer obtained using the polymer compound of the hole transporting layer, the polymer compound of the hole transporting layer may be contained in the hole transporting layer as is, or in an intramolecularly, an intermolecularly, or an intramolecularly and intermolecularly crosslinked state (i.e., as a crosslinked product). However, the hole transporting layer is preferably a layer comprising a crosslinked product of the polymer compound of the hole transporting layer. The crosslinked product of the polymer compound of the hole transporting layer may be a product in which the polymer compound of the hole transporting layer and another material are intermolecularly crosslinked.

To achieve better hold transportability of the polymer compound of the hole transporting layer, the content of the constitutional unit represented by formula (X) is preferably 1 to 99 mol%, more preferably 10 to 80 mol%, and still more preferably 20 to 70 mol%, based on the total amount of constitutional units contained in the polymer compound of the hole transporting layer.

### [Constitutional unit Represented by Formula (3)]

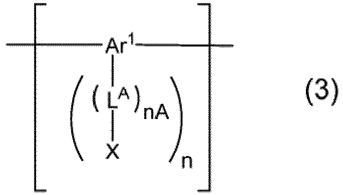

(Wherein,
nA denotes an integer of 0 to 5, and n denotes an integer of 1 to 4,
Ar¹ represents an aromatic hydrocarbon group or a heterocyclic group, and these groups each may have a substituent,
L^{A} represents an alkylene group, a cycloalkylene group, an arylene group, a divalent heterocyclic group, a group represented by -NR'-, an oxygen atom, or a sulfur atom, and these groups each may have a substituent; R' represents a hydrogen atom, an alkyl group, a cycloalkyl group, an aryl group, or a monovalent heterocyclic group, and these groups each may have a substituent; and when there are a plurality of L^{A}, they may be the same or different.
X represents a crosslinkable group selected from the group of crosslinkable group A; and when there are a plurality of X, they may be the same or different.)

To achieve a better external quantum efficiency of the light-emitting device according to the present embodiment, nA preferably denotes an integer of 0 to 3, more preferably an integer of 0 to 2, and still more preferably 1 or 2.

To achieve a better external quantum efficiency of the light-emitting device according to the present embodiment, n is preferably 2.

To achieve a better external quantum efficiency of the light-emitting device according to the present embodiment, Ar¹ is preferably an aromatic hydrocarbon group that may have a substituent.

The aromatic hydrocarbon group represented by Ar¹ usually has 6 to 60 carbon atoms, preferably 6 to 30 carbon atoms, and more preferably 6 to 18 carbon atoms, not including the carbon atoms of the substituent.

The arylene group moiety excluding the n substituents of the aromatic hydrocarbon group represented by Ar¹ is preferably a group represented by formulas (A-1) to (A-20), more preferably a group represented by formula (A-1), (A-2), (A-6) to (A-10), (A-19), or (A-20), and still more preferably a group represented by formula (A-1), (A-2), (A-7), (A-9), or (A-19), and these groups each may have a substituent.

The heterocyclic group represented by Ar¹ usually has 2 to 60 carbon atoms, preferably 3 to 30 carbon atoms, and more preferably 4 to 18 carbon atoms, not including the carbon atoms of the substituent.

The divalent heterocyclic group moiety excluding the n substituents of the heterocyclic group represented by Ar¹ is preferably a group represented by formulas (AA-1) to (AA-34).

The aromatic hydrocarbon group and the heterocyclic group represented by Ar¹ each may have a substituent. Examples of the substituent include an alkyl group, a cycloalkyl group, an alkoxy group, a cycloalkoxy group, an aryl group, an aryloxy group, a halogen atom, a monovalent heterocyclic group, or a cyano group.

The alkylene group represented by L^{A} usually has 1 to 20 carbon atoms, preferably 1 to 15 carbon atoms, and more preferably 1 to 10 carbon atoms, not including the carbon atoms of the substituent. The cycloalkylene group represented by L^{A} usually has 3 to 20 carbon atoms, not including the carbon atoms of the substituent.

The alkylene group and the cycloalkylene group each may have a substituent, and examples thereof include a methylene group, an ethylene group, a propylene group, a butylene group, a hexylene group, a cyclohexylene group, and an octylene group.

The alkylene group and the cycloalkylene group represented by L^{A} each may have a substituent.

Examples of the optional substituents of the alkylene group and the cycloalkylene group include an alkyl group, a cycloalkyl group, an alkoxy group, a cycloalkoxy group, a halogen atom, and a cyano group.

The arylene group represented by L^{A} may have a substituent. The arylene group is preferably a phenylene group or a fluorenediyl group, and more preferably an m-phenylene group, a p-phenylene group, a fluorene-2,7-diyl group, or a fluorene-9,9-diyl group. Examples of the optional substituent of the arylene group include an alkyl group, a cycloalkyl group, an alkoxy group, a cycloalkoxy group, an aryl group, an aryloxy group, a monovalent heterocyclic group, a halogen atom, a cyano group, and a crosslinkable group selected from the group of crosslinkable group A.

To facilitate synthesis of the polymer compound of the hole transporting layer, L^{A} is preferably an arylene group or an alkylene group, and more preferably a phenylene group, a fluorenediyl group, or an alkylene group, and these groups each may have a substituent.

To achieve better crosslinking properties of the polymer compound of the hole transporting layer, the crosslinkable group represented by X is preferably a crosslinkable group represented by formula (XL-1), (XL-3), (XL-7) to (XL-10), (XL-16), or (XL-17), more preferably a crosslinkable group represented by formula (XL-1), (XL-3), (XL-9,) (XL-16), or (XL-17), still more preferably a crosslinkable group represented by formula (XL-1), (XL-16), or (XL-17), and particularly preferably a crosslinkable group represented by formula (XL-1) or (XL-17).

To achieve better crosslinking properties of the polymer compound of the hole transporting layer, the content of the constitutional unit represented by formula (3) is preferably 0.5 to 90 mol%, more preferably 3 to 75 mol%, still more preferably 5 to 60 mol%, based on the total amount of constitutional units contained in the polymer compound of the hole transporting layer.

Only one constitutional unit represented by formula (3) may be contained or two or more of them may be contained in the polymer compound of the hole transporting layer.

[Constitutional unit Represented by Formula (4)] 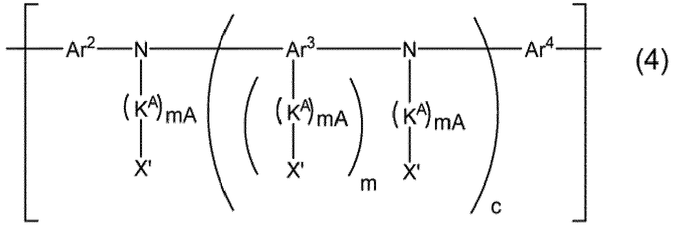 (Wherein,
mA denotes an integer of 0 to 5, m denotes an integer of 1 to 4, and c represents an integer of 0 or 1; and when there are a plurality of mA, they may be the same or different,
Ar³ represents an aromatic hydrocarbon group, a heterocyclic group, or a group in which at least one aromatic hydrocarbon ring and at least one heterocyclic ring are directly bonded to each other, and these groups may each have a substituent,
Ar² and Ar⁴ each independently represent an arylene group or a divalent heterocyclic group, and these groups each may have a substituent,
Ar², Ar³, and Ar⁴ may each be bonded either directly or via an oxygen atom or a sulfur atom to a group other than the group bonded to the nitrogen atom to which that group is bonded to form a ring,
K^{A} represents an alkylene group, a cycloalkylene group, an arylene group, a divalent heterocyclic group, a group represented by -NR"-, an oxygen atom, or a sulfur atom, and these groups each may have a substituent; R" represents a hydrogen atom, an alkyl group, a cycloalkyl group, an aryl group, or a monovalent heterocyclic group, and these groups each may have a substituent; and when there are a plurality of K^{A}, they may be the same or different,
X' represents a crosslinkable group selected from the group of crosslinkable group A, a hydrogen atom, an alkyl group, a cycloalkyl group, an aryl group, or a monovalent heterocyclic group, and these groups each may have a substituent; however, at least one X' is a crosslinkable group selected from the group of crosslinkable group A.)

To achieve a better external quantum efficiency of the light-emitting device according to the present embodiment, mA is preferably 0 or 1, and more preferably 0.

To achieve a better external quantum efficiency of the light-emitting device according to the present embodiment, m is preferably 0.

To facilitate synthesis of the polymer compound of the hole transporting layer, and achieve a better external quantum efficiency of the light-emitting device according to the present embodiment, c is preferably 0.

To achieve a better external quantum efficiency of the light-emitting device according to the present embodiment, Ar³ is preferably an aromatic hydrocarbon group which may have a substituent.

The definition and examples of the arylene group moiety excluding the m substituents of the aromatic hydrocarbon group represented by Ar³ are the same as the definition and examples of the arylene group represented by Ar^{X2} in the above-mentioned formula (X).

The definition and examples of the divalent heterocyclic group moiety excluding the m substituents of the heterocyclic group represented by Ar³ are the same as the definition and examples of the divalent heterocyclic group moiety represented by Ar^{X2} in the above-mentioned formula (X).

The definition and examples of the divalent group excluding the m substituents of the group represented by Ar³ in which at least one aromatic hydrocarbon ring and at least one heterocyclic ring are directly bonded to each other are the same as the definition and examples of the divalent group represented by Ar^{X2} in the above-mentioned formula (X) in which at least one arylene group and at least one divalent heterocyclic group are directly bonded to each other.

To achieve a better external quantum efficiency of the light-emitting device according to the present embodiment, Ar² and Ar⁴ are preferably arylene groups which may have a substituent.

The definition and examples of the arylene group represented by Ar² and Ar⁴ are the same as the definition and examples of the arylene group represented by Ar^{X1} and Ar^{X3} in the above formula (X).

The definition and examples of the divalent heterocyclic group represented by Ar² and Ar⁴ are the same as the definition and examples of the divalent heterocyclic group represented by Ar^{X1} and Ar^{X3} in the above formula (X).

The groups represented by Ar², Ar³, and Ar⁴ each may have a substituent. Preferable examples of the substituent include an alkyl group, a cycloalkyl group, an alkoxy group, a cycloalkoxy group, an aryl group, an aryloxy group, a halogen atom, a monovalent heterocyclic group and a cyano group.

The definitions and examples of the alkylene group, the cycloalkylene group, the arylene group, and the divalent heterocyclic group represented by K^{A} are each the same as the definitions and examples of the alkylene group, the cycloalkylene group, the arylene group, and the divalent heterocyclic group represented by L^{A}.

To facilitate the synthesis of the polymer compound of the hole transporting layer, K^{A} is preferably a phenylene group or a methylene group, and these groups each may have a substituent.

The definitions and examples of the crosslinkable group represented by X' are the same as the definition and examples of the crosslinkable group represented by X described above.

To achieve better hole transportability of the polymer compound of the hole transporting layer and better crosslinking properties of the polymer compound of the hole transporting layer, the content of the constitutional unit represented by formula (4) is preferably 0.5 to 80 mol%, more preferably 1 to 60 mol%, still more preferably 3 to 40 mol%, and particularly preferably 5 to 20 mol%, based on the total amount of constitutional units contained in the polymer compound of the hole transporting layer.

Only one constitutional unit represented by formula (4) may be contained or two or more of them may be contained in the polymer compound of the hole transporting layer.

Examples of constitutional unit represented by formula (3) include constitutional units represented by formulas (3-1) to (3-30), and examples of the constitutional unit represented by formula (4) include constitutional units represented by formulas (4-1) to (4-9). Among these, to achieve better crosslinking properties of the polymer compound of the hole transporting layer, such constitutional unit is preferably a constitutional unit represented by formulas (3-1) to (3-30), more preferably a constitutional unit represented by formulas (3-1) to (3-15), (3-19), (3-20), (3-23), (3-25), or (3-30), still more preferably a constitutional unit represented by formulas (3-1) to (3-13) or (3-30), and particularly preferable a constitutional unit represented by formulas (3-1) to (3-9) or (3-30).

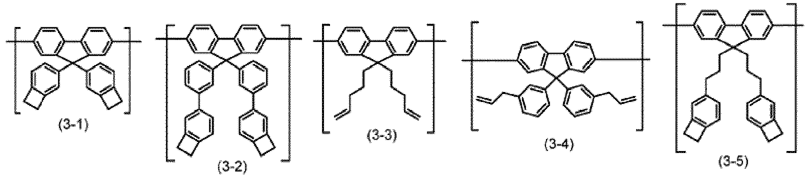

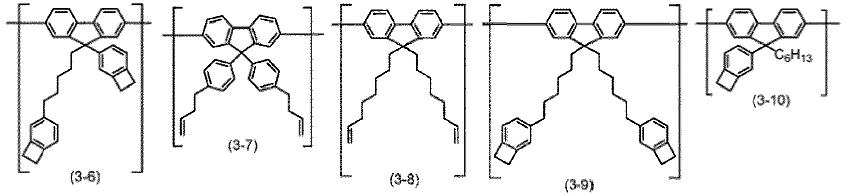

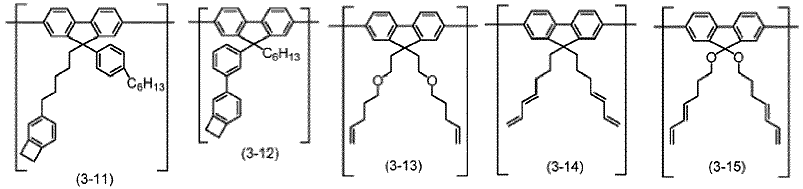

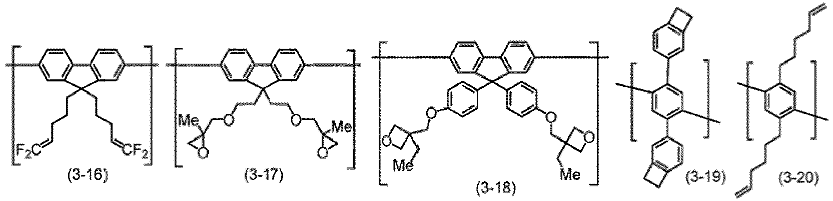

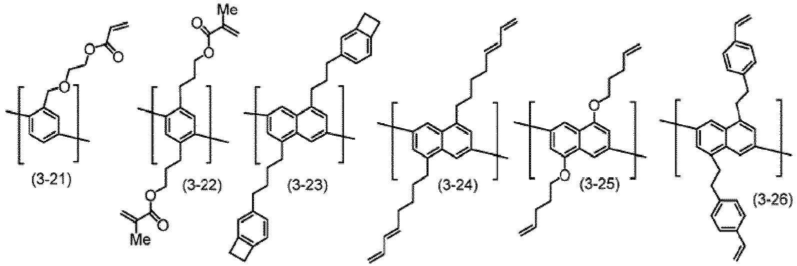

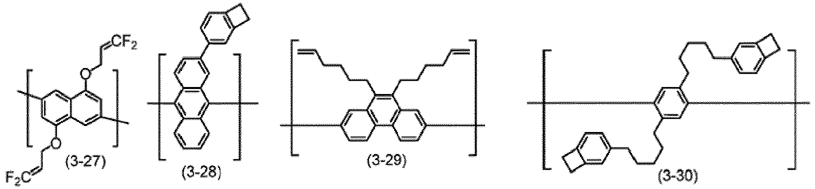

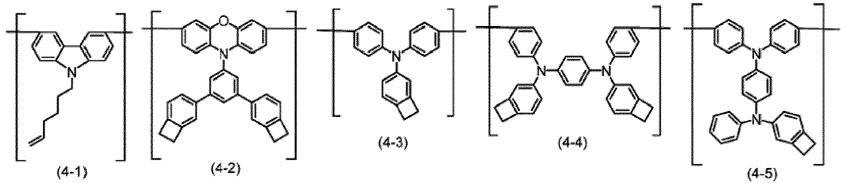

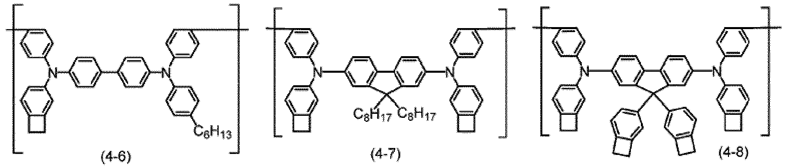

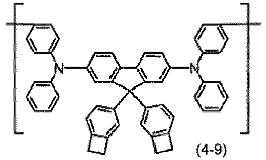

When the light-emitting device according to the present embodiment comprises an electron transporting layer, the electron transporting material contained in the electron transporting layer is preferably a polymer compound (hereinafter also referred to as "polymer compound of the electron transporting layer") comprising at least one constitutional unit selected from the group consisting of a constitutional unit represented by formula (ET-1) and a constitutional unit represented by formula (ET-2). 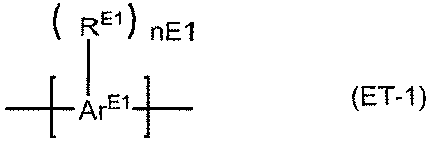 (Wherein,
nE1 denotes an integer of 1 or more,
Ar^{E1} represents an aromatic hydrocarbon group or a heterocyclic group, and these groups each may have a substituent other than R^{E1}, and
R^{E1} represents a group represented by formula (ES-1); when there are a plurality of R^{E1}, they may be the same or different.)

-R^{E3}-{(Q^{E1})_{nE3}- Y^{E1}(M^{E1})_{aE1}(Z^{E1})_{bE1}}_{mE1} (ES-1)

(Wherein,
nE3 denotes an integer of 0 or more, aE1 denotes an integer of 1 or more, bE1 denotes an integer of 0 or more, and mE1 denotes an integer of 1 or more; when there are a plurality of nE3, aE1, and bE1, they may be the same or different at each occurrence; when R^{E3} is a single bond, mE1 is 1; and aE1 and bE1 are selected so that the charge of the group represented by formula (ES-1) is zero,
R^{E3} represents a single bond, a hydrocarbon group, a heterocyclic group or O-R^{E3}' (R^{E3}' represents a hydrocarbon group or a heterocyclic group), and these groups each may have a substituent,
Q^{E1} represents an alkylene group, a cycloalkylene group, an arylene group, an oxygen atom, or a sulfur atom, and these groups each may have a substituent; and when there are a plurality of Q^{E1}, they may be the same or different,
Y^{E1} represents -CO₂⁻, -SO₃⁻, -SO₂⁻, or PO₃²⁻; and when there are a plurality of Y^{E1}, they may be the same or different,
M^{E1} represents an alkali metal cation, an alkali earth metal cation, or an ammonium cation, and the ammonium cation may have a substituent; when there are a plurality of M^{E1}, they may be the same or different, and
Z^{E1} represents F⁻, Cl⁻, Br⁻, I⁻, OH⁻, B(R^{E4})₄⁻, R^{E4}SO₃⁻, R^{E4}COO⁻, NO₃⁻, SO₄²⁻, HSO₄⁻, PO₄³⁻, HPO₄²⁻, H₂PO₄⁻, BF₄⁻, or PF₆-; R^{E4} represents an alkyl group, a cycloalkyl group, or an aryl group, and these groups each may have a substituent; and when there are a plurality of Z^{E1}, they may be the same or different.)

nE1 is usually an integer of 1 to 4, and preferably 1 or 2.

Preferable examples of the aromatic hydrocarbon group or heterocyclic group represented by Ar^{E1} are a group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group, or a 2,7-carbazolediyl group, nE1 atoms of hydrogen directly bonded to the atoms constituting the ring, and Ar^{E1} may have a substituent other than R^{E1}.

Examples of the optional substituent other than R^{E1} of Ar^{E1} include a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group, and a group represented by formula (ES-3).

-O-(C_{n'}H_{2n'}O)ₙₓ-C_{m'd}H_{2m'+1} (ES-3)

(Wherein n', m', and nx each independently denote an integer of 1 or more.)

nE3 is usually an integer of 0 to 10, preferably an integer of 0 to 8, and more preferably an integer of 0 to 2.

aE1 is usually an integer of 1 to 10, preferably an integer of 1 to 5, and more preferably 1 or 2.

bE1 is usually an integer of 0 to 10, preferably an integer of 0 to 4, and more preferably 0 or 1.

mE1 is usually an integer of 1 to 5, preferably 1 or 2, and more preferably 1.

When R^{E3} is -O-R^{E3'}, the group represented by formula (ES-1) is a group represented by the following formula.

-O-R^{E3'}-{(Q^{E1})_{nES}-Y^{E1}(M^{E1})_{aE1}(Z^{E1})_{bE1}}_{mE1}

R^{E3} is preferably a hydrocarbon group or a heterocyclic group, more preferably an aromatic hydrocarbon group or an aromatic heterocyclic group, and still more preferably an aromatic hydrocarbon group.

Examples of the optional substituent of R^{E3} include an alkyl group, a cycloalkyl group, an aryl group, a monovalent heterocyclic group, and a group represented by formula (ES-3), and a group represented by formula (ES-3) is preferable.

Q^{E1} is preferably an alkylene group, an arylene group, or an oxygen atom, and more preferably an alkylene group or an oxygen atom.

Y^{E1} is preferably -CO₂⁻, -SO₂⁻, or PO₃²⁻, and more preferably -CO₂⁻.

Examples of the alkali metal cation represented by M^{E1} include Li⁺, Na⁺, K⁺, Rb⁺, and Cs⁺, and K⁺, Rb⁺, or Cs⁺ is preferable and Cs⁺ is more preferable.

Examples of the alkali earth metal cation represented by M^{E1} include Be²⁺, Mg²⁺, Ca²⁺, Sr²⁺, Ba²⁺, and Mg²⁺, Ca²⁺, Sr²⁺, and Ba²⁺ are preferable, and Ba²⁺ is more preferable.

Preferable examples of M^{E1} include an alkali metal cation or an alkali earth metal cation, and an alkali metal cation is more preferable.

Z^{E1} is preferably F⁻, Cl⁻, Br⁻, I⁻, OH⁻, B(R^{E4})₄⁻, R^{E4}SO₃⁻, R^{E4}COO⁻, or NO₃⁻, and more preferably F⁻, Cl⁻, Br⁻, I⁻, OH⁻, R^{E4}SO₃⁻, or R^{E4}COO⁻. R^{E4} is preferably an alkyl group.

Examples of the group represented by formula (ES-1) include groups represented by the following formulas. 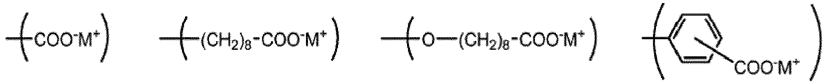 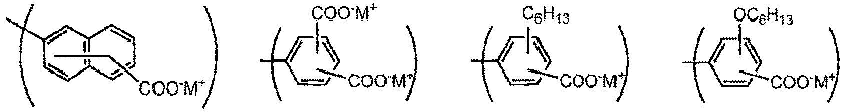 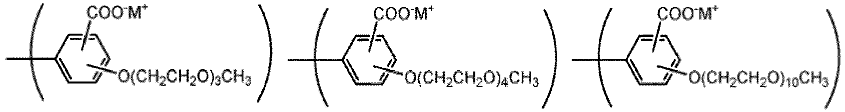 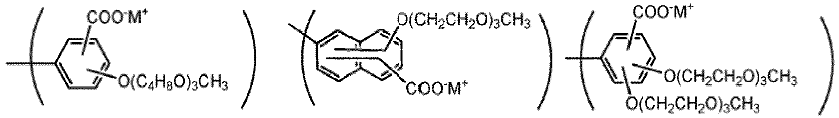 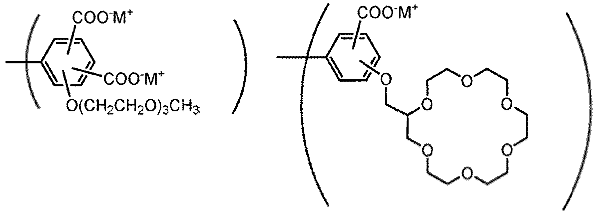 (Wherein, M⁺ represents Li⁺, Na⁺, K⁺, Cs⁺, or N(CH³)₄⁺; and when there are a plurality of M⁺, they may be the same or different.) 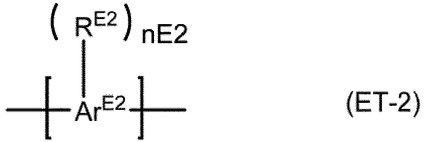 (Wherein,
nE2 denotes an integer of 1 or more,
Ar^{E2} represents an aromatic hydrocarbon group or a heterocyclic group, and these groups each may have a substituent other than R^{E2}, and
R^{E2} represents a group represented by formula (ES-2); when there are a plurality of R^{E2}, they may be the same or different.)

-R^{E5}-{(Q^{E2})_{nE4}-^{yE2}(M^{E2})_{aE2}(Z^{E2})_{bE2}}_{mE2} (ES-2)

(Wherein,
nE4 denotes an integer of 0 or more, aE2 denotes an integer of 1 or more, bE2 denotes an integer of 0 or more, and mE2 denotes an integer of 1 or more; when there are a plurality of nE4, aE2, and bE2, they may be the same or different at each occurrence; however, when R^{E5} is a single bond, mE2 is 1; and aE2 and bE2 are selected so that the charge of the group represented by formula (ES-2) is zero,
R^{E5} represents a single bond, a hydrocarbon group, a heterocyclic group or O-R^{E5}' (R^{E5}' represents a hydrocarbon group or a heterocyclic group), and these groups each may have a substituent,
Q^{E2} represents an alkylene group, a cycloalkylene group, an arylene group, an oxygen atom, or a sulfur atom, and these groups each may have a substituent; and when there are a plurality of Q^{E2}, they may be the same or different,
Y^{E2} represents -C⁺R^{E6}₂, -N⁺R^{E6}₃, -P⁺R^{E6}₃, -S⁺R^{E6}₂, or -I⁺R^{E6}₂; R^{E6} represents a hydrogen atom, an alkyl group, a cycloalkyl group, or an aryl group, and these groups each may have a substituent: the plurality of R^{E6} may be the same or different; and when there are a plurality of Y^{E2}, they may be the same or different,
M^{E2} represents F⁻, Cl⁻, Br⁻, I⁻, OH⁻, B(R^{E7})₄⁻, R^{E7}SO₃⁻, R^{E7}COO⁻, BF₄⁻, SbCl₆⁻, or SbF₆⁻; R^{E7} represents an alkyl group, a cycloalkyl group, or an aryl group, and these groups each may have a substituent,
when there are a plurality of M^{E2}, they may be the same or different, and
Z^{E2} represents an alkali metal cation or an alkali earth metal cation; and when there are a plurality of Z^{E2}, they may be the same or different.)

nE2 is usually an integer of 1 to 4, and preferably 1 or 2.

Preferable examples of the aromatic hydrocarbon group or heterocyclic group represented by Ar^{E2} are a group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group, or a 2,7-carbazolediyl group, nE2 atoms of hydrogen directly bonded to the atoms constituting the ring, and Ar^{E2} may have a substituent other than R^{E2}.

The examples of the optional substituent other than R^{E2} of Ar^{E2} are the same as the examples of the optional substituent other than R^{E1} of Ar^{E1}.

nE4 is usually an integer of 0 to 10, preferably an integer of 0 to 8, and more preferably an integer of 0 to 2.

aE2 is usually an integer of 1 to 10, preferably an integer of 1 to 5, and more preferably 1 or 2.

bE2 is usually an integer of 0 to 10, preferably an integer of 0 to 4, and more preferably 0 or 1.

mE2 is usually an integer of 1 to 5, preferably 1 or 2, and more preferably 1.

When R^{E5} is -O-R^{E5}' the group represented by formula (ES-2) is a group represented by the following formula.

-O-R^{E5}'-{(Q^{E1})_{nE3}-y^{E1}(M^{E1})_{aE1}(Z^{E1})_{bE1}}_{mE1}

R^{E5} is preferably a hydrocarbon group or a heterocyclic group, more preferably an aromatic hydrocarbon group or an aromatic heterocyclic group, and still more preferably an aromatic hydrocarbon group.

Examples of the optional substituent of R^{E5} include an alkyl group, a cycloalkyl group, an aryl group, a monovalent heterocyclic group, and a group represented by formula (ES-3), and a group represented by formula (ES-3) is preferable.

Q^{E2} is preferably an alkylene group, an arylene group, or an oxygen atom, and more preferably an alkylene group or an oxygen atom.

Y^{E2} is preferably -C⁺R^{E6}₂, -N⁺R^{E6}₃, -P⁺R^{E6}₃, or -S⁺R^{E6}₂, and more preferably -N⁺R^{E6}₃. R^{E6} is preferably a hydrogen atom, an alkyl group, or an aryl group, and more preferably a hydrogen atom or an alkyl group.

M^{E2} is preferably F⁻, Cl⁻, Br⁻, I⁻, B(R^{E7})₄⁻, R^{E7}SO₃⁻, R^{E7}COO⁻, BF₄⁻, or SbF₆⁻, and more preferably Br⁻, I⁻, B(R^{E7})₄⁻, R^{E7}COO⁻, or SbF₆⁻. R^{E7} is preferably an alkyl group.

Examples of the alkali metal cation represented by Z^{E2} include Li⁺, Na⁺, K⁺, Rb⁺, and Cs⁺, and Li⁺, Na⁺, or K⁺ is preferable.

Examples of the alkali earth metal cation represented by Z^{E2} include Be²⁺, Mg²⁺, Ca²⁺, Sr²⁺, and Ba²⁺, and Mg²⁺ or Ca²⁺ is more preferable.

Z^{E2} is preferably an alkali metal cation.

Examples of the group represented by formula (ES-2) include groups represented by the following formulas. 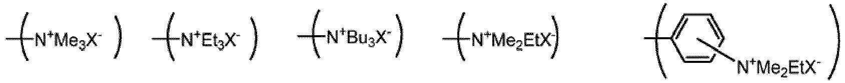 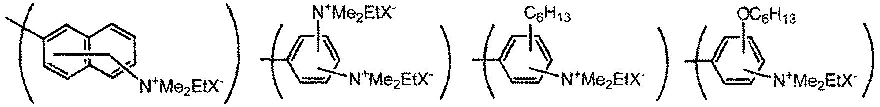 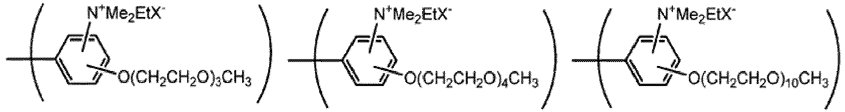 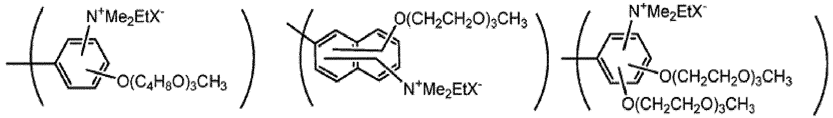 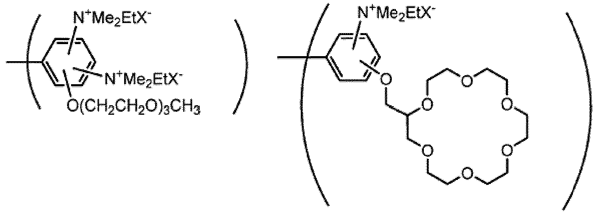 (Wherein, X⁻ represents F⁻, Cl⁻, Br⁻, I⁻, B(C₆H₅)₄⁻, CH₃COO⁻, or CF₃SO₃⁻; and when there are a plurality of X⁻, they may be the same or different.)

Examples of the constitutional unit represented by formula (ET-1) or (ET-2) include the constitutional units represented by formulas (ET-31) to (ET-38).

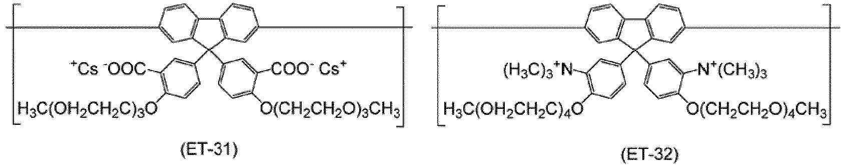

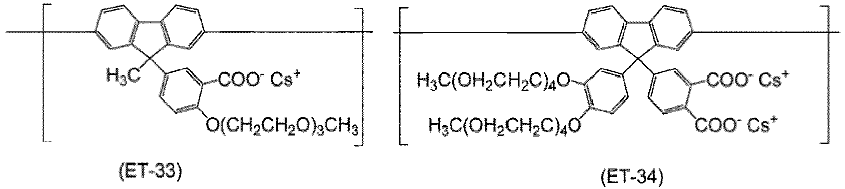

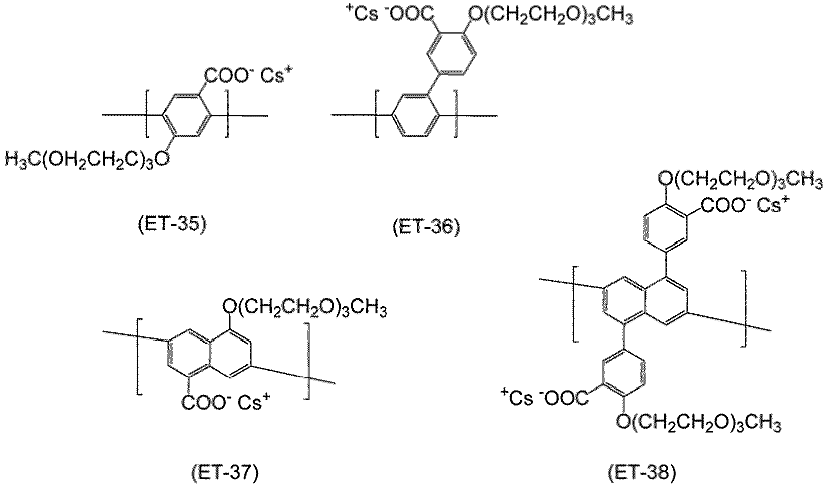

The polymer compound of the electron transporting layer can be synthesized according to the methods described in, for example, Japanese Unexamined Patent Publication No. 2009-239279, Japanese Unexamined Patent Publication No. 2012-033845, Japanese Unexamined Patent Publication No. 2012-216821, Japanese Unexamined Patent Publication No. 2012-216822, and Japanese Unexamined Patent Publication No. 2012-216815.

### [Substrate/Electrodes]

The light-emitting device according to the present embodiment may have a substrate. The substrate in the light-emitting device may be any material that is capable of forming an electrode and that does not chemically change when forming an organic layer (e.g., the light-emitting layer, the hole transporting layer, the hole injecting layer, the electron transporting layer, the electron injecting layer, etc.). The substrate may be made of a material such as glass, plastic, and silicon. In the case of an opaque substrate, it is preferable that the electrode farthest from the substrate be transparent or translucent.

Examples of the material of the anode include conductive metal oxides and translucent metals. The anode material is preferably indium oxide, zinc oxide, or tin oxide; a conductive compound such as indium tin oxide (ITO) or indium zinc oxide; a complex of silver, palladium, and copper (APC); NESA, gold, platinum, silver, or copper.

Examples of the material of the cathode include metals such as lithium, sodium, potassium, rubidium, cesium, beryllium, magnesium, calcium, strontium, barium, aluminum, zinc, and indium; alloys of two or more of those metals; alloys of one or more of those metals with one or more of silver, copper, manganese, titanium, cobalt, nickel, tungsten, and tin; and graphite and graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy, and the like.

Each of the anode and the cathode may have a stacked structure of two or more layers.

### [Light-emitting device Applications]

To obtain planar light emission using a light-emitting device, a planar anode and a planar cathode may be arranged so as to overlap each other. Examples of methods for obtaining patterned light emission include a method in which a mask having a patterned window is disposed on the surface of a planar light-emitting device, a method in which a layer that is not intended to emit light is formed very thickly so as to substantially prevent light emission, and a method in which the anode or the cathode, or both electrodes, are formed in a pattern shape.

By forming a pattern by any of these methods and arranging such that several electrodes can be independently switched ON/OFF, a segment type display device capable of displaying numerals, letters, and the like is obtained. To obtain a dot matrix display device, the anodes and the cathodes are formed in a striped shape so as to be orthogonal to each other. Partial color display and multi-color display can be achieved by a method in which a plurality of polymer compounds having different emission colors are used for separate paining or a method in which a color filter or a fluorescence conversion filter are used. A dot matrix display device can be driven passively, or can be driven actively in combination with TFT and the like. These display devices can be used as a display in computers, television sets, mobile terminals, and the like. A planar light-emitting device can be suitably used as a planar light source for a backlight in a liquid crystal display or as a planar illumination light source. When a flexible substrate is used, the light-emitting device can also be used as a curved light source and a curved display.

### Examples

The present invention will now be described in more detail by the following Examples, but the present invention is not limited to these Examples.

In the Examples, the polystyrene-equivalent number-average molecular weight (Mn) and the polystyrene-equivalent weight-average molecular weight (Mw) of the polymer compounds were determined by any one of the below size-exclusion chromatography (SEC) columns using tetrahydrofuran for the mobile phase. The SEC measurement conditions were as follows.

The polymer compound to be measured was dissolved at a concentration of about 0.05% by mass in tetrahydrofuran, and 10 µL of the solution was injected into the SEC column. The mobile phase flow rate was 0.6 mL/min. A TSK guard column Super AW-H, a TSKgel Super AWM-H, or a TSKgel Super AW 3000 (all manufactured by Tosoh Corporation) were each connected in series and used for the column. A UV-VIS detector (trade name: UV-8320 GPC, manufactured by Tosoh Corporation) was used as the detector.

LC-MS was measured by the following method.

The measurement sample was dissolved in chloroform or tetrahydrofuran so as to have a concentration of about 2 mg/mL, and about 1 µL was injected into an LC-MS (trade name: 1100 LC-MSD, manufactured by Agilent). The LC-MS mobile phase was flowed at a rate of 0.2 mL/min while varying the ratio of acetonitrile and tetrahydrofuran. An L-column 2 ODS (3 µm) (manufactured by the Chemicals Evaluation and Research Institute, inner diameter: 2.1 mm, length: 100 mm, particle diameter 3 µm) was used for the column.

TLC-MS was measured by the following method.

The measurement sample was dissolved in a solvent of either toluene, tetrahydrofuran, or chloroform at an arbitrary concentration, and the solution was coated on a TLC plate for DART (trade name: YSK5-100, manufactured by Techno Applications), and then measurement was carried out using TLC-MS (trade name: JMS-T100TD (The AccuTOF TLC), manufactured by JEOL Ltd.). The helium gas temperature during the measurement was adjusted in the range of 200 to 400°C.

NMR was measured by the following method.

A measurement sample of 5 to 10 mg was dissolved in about 0.5 mL of deuterated chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol, or heavy methylene chloride, and measured using an NMR apparatus (trade name: INOVA 300 or MERCURY 400 VX, manufactured by Agilent).

As an index of the purity of the compound, the value of the high-performance liquid chromatography (HPLC) area percentage was used. Unless noted otherwise, this value is the value at UV=254 nm in the HPLC apparatus (product name: LC-20A, manufactured by Shimadzu Corporation). At this time, the compound to be measured was dissolved in tetrahydrofuran or chloroform so as to have a concentration of 0.01 to 0.2% by mass, and 1 to 10 µL was injected into the HPLC apparatus in accordance with the concentration. For the HPLC mobile phase, the ratio of acetonitrile/tetrahydrofuran was varied between 100/0 to 0/100 (volume ratio) while flowing at a flow rate of 1.0 mL/min. As the column, a Kaseisorb LC ODS 2000 (manufactured by Tokyo Chemical Industry) or an ODS column having equivalent performance was used. For the detector, a photodiode array detector (trade name: SPD-M20A, manufactured by Shimadzu Corporation) was used.

In this Example, the maximum peak wavelength of the emission spectrum of the phosphorescent compound was measured at room temperature by a spectrophotometer (FP-6500, manufactured by JASCO Corporation). A xylene solution in which the phosphorescent compound was dissolved in xylene at a concentration of about 0.8 × 10⁻⁴ % by mass was used as the sample. For the excitation light, UV light with a wavelength of 325 nm was used.

### <Synthesis Example 1>

### Synthesis of Compound MC1 (Phosphorescent Compound)

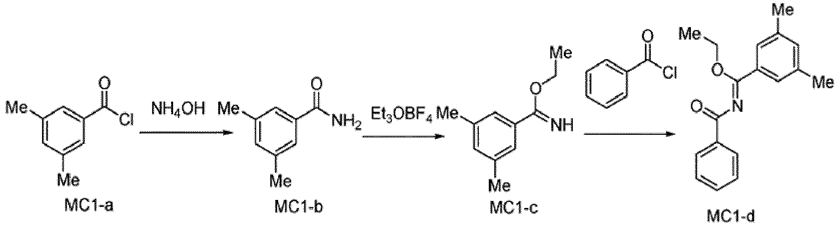

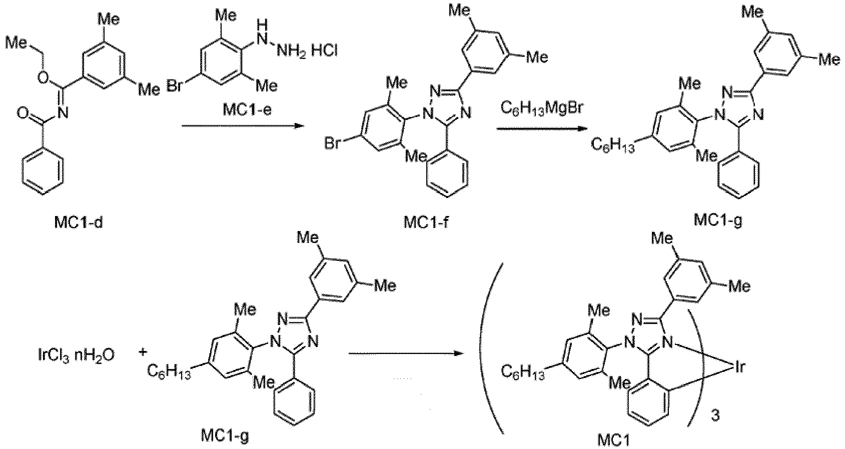

The atmosphere within a reaction vessel was replaced with argon gas, then the reaction vessel was charged with compound MC1-a (33.7 g) and dichloromethane (400 mL), and placed in an ice bath to cool. The reaction vessel was then charged with a 25% by mass solution of aqueous ammonia (40.8 g), and the reaction vessel was stirred for 1 hour while cooling in an ice bath. Then, the reaction vessel was charged with ion-exchanged water (200 mL) and dichloromethane (150 mL), and the organic layer was extracted. The obtained organic layer was dried over anhydrous magnesium sulfate, then heptane (400 mL) was added, and the dichloromethane was concentrated under reduced pressure to obtain a solution containing a white solid. The obtained solution containing the white solid was filtered, and then the resultant white solid was dried under reduced pressure to obtain compound MC1-b (27.8 g, yield 93%) as a white solid. The HPLC area percentage value of compound MC1-b was 99.3%. The required amount of compound MC1-b was obtained by repeating this operation.
TLC/MS (DART, positive): m/z = 150 [M+H]⁺
The atmosphere within a reaction vessel was replaced with argon gas and then the reaction vessel was charged with compound MC1-b (34.3 g) and dichloromethane (1.38 L). Then, the reaction vessel was charged with a solution of triethyloxonium tetrafluoroborate (1 mol/L, 276 mL) in dichloromethane, and the mixture was stirred at room temperature for 34 hours. Then, the reaction vessel was charged with an aqueous sodium hydrogen carbonate solution (1 mol/L, 352 mL), and the mixture was stirred at room temperature for 30 minutes. After extracting the organic layer of the obtained reaction solution, the resultant organic layer was washed with saturated brine (300 mL) to obtain an organic layer. Heptane (200 mL) was added to the obtained organic layer, and then the dichloromethane was concentrated under reduced pressure to obtain a solution containing a white solid. The obtained solution containing the white solid was filtered, and then the resultant filtrate was concentrated to obtain compound MC1-c (33.6 g, yield 82%) as a yellow oily substance. The HPLC area percentage value of compound MC1-c was 98.0%.
TLC/MS (DART, positive): m/z = 178 [M+H]⁺
The atmosphere within a reaction vessel was replaced with argon gas, then the reaction vessel was charged with compound MC1-c (33.5 g), benzoyl chloride (26.6 g), and chloroform (570 mL). Next, the reaction vessel was charged with triethylamine (26.4 mL), and the mixture was stirred for 66 hours at room temperature. The obtained reaction solution was concentrated under reduced pressure, ion-exchanged water (210 mL) and chloroform (210 mL) were added to the obtained residue, and the organic layer was extracted. The obtained organic layer was washed with saturated brine (150 mL), dried over anhydrous magnesium sulfate, and then concentrated under reduced pressure to obtain compound MC1-d (54.2 g, yield 88%) as an orange oily substance. The HPLC area percentage value of compound MC1-d was 86.0%.
TLC/MS (DART, positive): m/z = 282 [M+H]⁺
¹H-NMR (300 MHz, CDCl₃-d₁): δ (ppm) = 8.01-7.98 (m, 2H), 7.56-7.51 (m, 1H), 7.46-7.41 (m, 2H), 7.19 (s, 2H), 7.03 (s, 1H), 4.48-4.41 (m, 2H), 2.23 (s, 6H), 1.48 (t, 3H).

The atmosphere within a reaction vessel was replaced with argon gas, then the reaction vessel was charged with compound MC1-e (55.8 g) and toluene (925 mL), and the reaction vessel was placed in an ice bath to cool. Then, the reaction vessel was charged with an aqueous sodium hydroxide solution (1 mol/L, 222 mL), and the mixture was stirred for 30 minutes while cooling in an ice bath. The organic layer of the obtained reaction solution was extracted to obtain a toluene solution as an organic layer.

The atmosphere of a separately-prepared reaction vessel was replaced with argon gas, then the reaction vessel was charged with compound MC1-d (52.0 g) and chloroform (925 mL), and placed in an ice bath to cool. Then, the reaction vessel was charged with the above-obtained toluene solution, the mixture was stirred for 7 hours while cooling in an ice bath, and then stirred at room temperature for 100 hours. Ion-exchanged water (500 mL) was added to the obtained reaction solution, the organic layer was extracted, and the obtained organic layer was concentrated under reduced pressure. The resultant residue was purified by silica gel column chromatography (mixed solvent of chloroform and hexane), then recrystallized from a mixed solvent of chloroform and heptane, and then dried under reduced pressure at 50°C to obtain compound MC1-f (17.6 g, yield 22%) as a white solid. The HPLC area percentage value of compound MC1-e was 99.5% or more. The required amount of compound MC1-f was obtained by repeating this operation.
TLC/MS (DART, positive): m/z = 432 [M+H]⁺
¹H-NMR (300 MHz, CD₂Cl₂-d₂): δ (ppm) = 7.84 (s, 2H), 7.56-7.54 (m, 2H), 7.43-7.32 (m, 5H), 7.09 (s, 1H), 2.40 (s, 6H), 1.99 (s, 6H).

The atmosphere within a reaction vessel was replaced with argon gas, then the reaction vessel was charged with compound MC1-f (17.3 g), cyclopentyl methyl ether (240 mL), and [1,1'-bis(diphenylphosphino)ferrocene]palladium(II) dichloride (98 mg), and the temperature was increased to 50°C. Then, the reaction vessel was charged with a solution of hexyl magnesium bromide (2 mol/L, 40 mL) in diethyl ether, and the mixture was stirred at 50°C for 2 hours. Then, the reaction vessel was charged with an aqueous hydrochloric acid solution (1 mol/L, 80 mL), and the organic layer was extracted. The obtained organic layer was washed twice with ion-exchanged water (100 mL), dried over anhydrous magnesium sulfate, filtered and the resultant filtrate was concentrated under reduced pressure to obtain an oily substance. Toluene and activated carbon were added to the obtained oily substance, and the resultant mixture was stirred at 50°C for 30 minutes. Then, the mixture was filtered through a filter lined with silica gel and Celite, and the resultant filtrate was concentrated under reduced pressure to obtain a solid. The obtained solid was purified by silica gel column chromatography (mixed solvent of hexane and ethyl acetate) and then recrystallized from methanol. Then, the recrystallized product was dried under reduced pressure at 50°C to obtain compound MC1-g (12.1 g, yield 69%) as a white solid. The HPLC area percentage value of compound MC1-g was 99.5% or more.
TLC/MS (DART, positive): m/z = 438 [M+H]⁺
¹H-NMR (300 MHz, CD₂Cl₂-d₂) δ (ppm) = 7.92 (s, 2H), 7.65-7.62 (m, 2H), 7.48-7.35 (m, 3H), 7.15 (s, 1H), 7.09 (s, 2H), 2.70 (t, 2H), 2.46 (s, 6H), 2.03 (s, 6H), 1.77-1.67 (m, 2H), 1.46-1.36 (m, 6H), 1.00-0.95 (m, 3H).

The atmosphere within a reaction vessel was replaced with argon gas, then the reaction vessel was charged with iridium chloride n-hydrate (2.50 g), compound MC1-g (6.43 g), ion-exchanged water (28 mL), and 2-ethoxyethanol (112 mL), and the mixture was stirred under reflux for 25 hours. Then, toluene was added and the mixture was washed with ion-exchanged water. The organic layer of the obtained washing solution was extracted, and the obtained organic layer was concentrated under reduced pressure to obtain a solid. The obtained solid was purified by silica gel column chromatography (mixed solvent of toluene and methanol) to obtain a solid (4.82 g).

The atmosphere of a separately-prepared reaction vessel was replaced with argon gas, then the reaction vessel was charged with the solid obtained above (4.81 g), silver trifluoromethanesulfonate (1.43 g), compound MC1-g (4.81 g), and tridecane (1.1 mL), and the mixture was heated and stirred at 150°C for 15 hours. Then, toluene was added, and the mixture was filtered through a filter lined with silica gel and Celite, and the obtained filtrate was washed with ion-exchanged water to obtain an organic layer. The obtained organic layer was concentrated under reduced pressure to obtain a solid. The obtained solid was purified by silica gel column chromatography (mixed solvent of hexane and toluene) and then recrystallized from a mixed solvent of ethyl acetate and ethanol.

Then, the recrystallized product was dried under reduced pressure at 50°C to give compound MC1 (2.32 g, yield 35%) as a yellow solid. The HPLC area percentage value of compound MC1 was 99.5% or more.
LC-MS (APCI, positive): m/z = 1502.8 [M+H]⁺
¹H-NMR (300 MHz, CD₂Cl₂-d₂) δ (ppm) = 7.96 (s, 6H), 7.07 (s, 6H), 6.91 (s, 3H), 6.60 (t, 3H), 6.51 (t, 3H), 6.41 (d, 3H), 6.29 (d, 3H), 2.70 (t, 6H), 2.09 (s, 18H), 1.85 (s, 9H), 1.76-1.67 (m, 6H), 1.60 (s, 9H), 1.44-1.35 (m, 18H), 1.00-0.95 (m, 9H).

The maximum peak wavelength of the emission spectrum of compound MC1 was 453 nm.

### <Synthesis Example 2> Synthesis of Compound MC2 (Phosphorescent Compound)

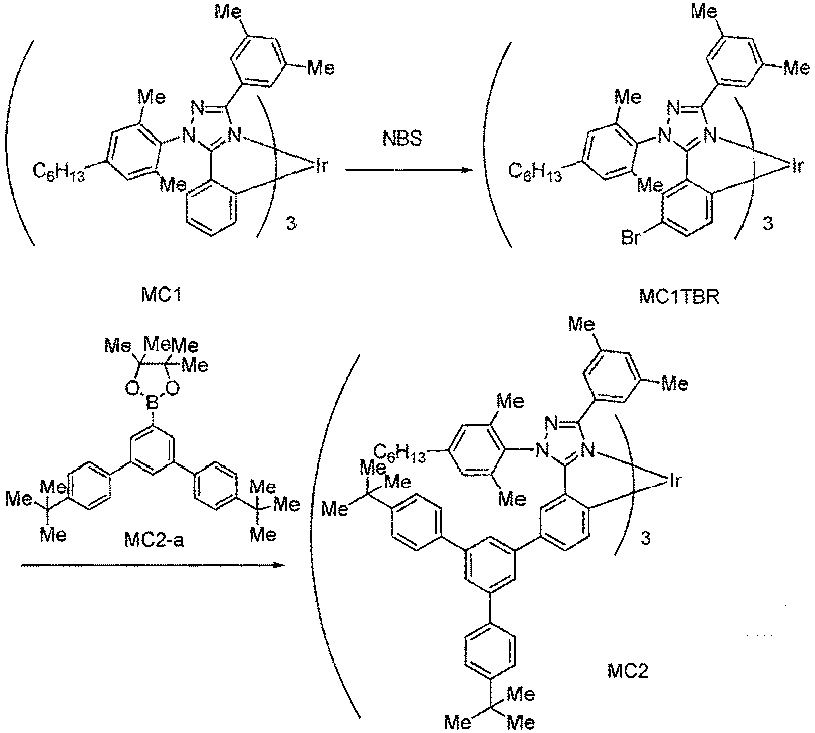

The atmosphere within a reaction vessel was replaced with argon gas, then the reaction vessel was charged with compound MC1 (0.50 g), dichloromethane (25 mL), and N-bromosuccinimide (203 mg), and the mixture was stirred at room temperature for 27.5 hours. Then, the reaction vessel was charge with a 10% by mass solution of aqueous sodium sulfite (4.20 g), then ion-exchanged water (8.40 mL) was added, and the mixture was stirred at room temperature for 30 minutes. An organic layer was extracted from the obtained reaction solution, and the obtained organic layer was filtered with a filter lined with silica gel. Methanol was added to the resultant filtrate to cause a precipitate to form. The obtained precipitate was filtered and vacuum dried at 50°C to obtain compound MC1 TBR (0.55 g, yield 95%) as a yellow solid. The HPLC area percentage value of compound MC1 TBR was 99.5% or more.
LC-MS (APCI, positive): m/z = 1736.5 [M+H]⁺
¹H-NMR (300 MHz, CD₂Cl₂-d₂) δ (ppm) = 7.94 (s, 6H), 7.71 (d, 6H), 6.94 (s, 3H), 6.73-6.70 (m, 3H), 6.29 (d, 3H), 6.25 (d, 3H), 2.72 (t, 6H), 2.10 (s, 18H), 1.84 (s, 9H), 1.77-1.67 (m, 6H), 1.57 (s, 9H), 1.45-1.34 (m, 18H), 0.99-0.94 (m, 9H).

The atmosphere within a reaction vessel was replaced with argon gas, then the reaction vessel was charged with compound MC1 TBR (0.50 g), compound MC2-a (0.44 g), toluene (30 mL), tris(dibenzylideneacetone)dipalladium(0) (7.9 mg), and 2-dicyclohexylphosphino-2',6'-dimethoxybiphenyl (8.5 mg), and the temperature was increased to 80°C. Then, the reaction vessel was charged with a 20% by mass solution of aqueous tetraethylammonium hydroxide (4.2 mL), and the mixture was stirred under reflux for 6 hours. Then, toluene was added, and the organic layer was extracted. The obtained organic layer was washed with ion-exchanged water, dried over anhydrous magnesium sulfate, filtered through a filter lined with silica gel and Celite, and the obtained filtrate was concentrated under reduced pressure to obtain a solid. The obtained solid was purified by silica gel column chromatography (mixed solvent of hexane and toluene) to give compound MC2 (0.54 g, yield 74%) as a yellow solid.

The HPLC area percentage value of compound MC2 was 99.5% or more.
LC-MS (APCI, positive): m/z = 2523.5 [M+H]⁺
¹H-NMR (300 MHz, CD₂Cl₂-d₂) δ (ppm) = 8.05 (s (br), 6H), 7.70-7.50 (m, 27H), 7.38 (s (br), 6H), 7.13-7.01 (m, 9H), 6.95 (s, 3H), 6.82 (s (br), 3H), 6.65 (s (br), 3H), 2.25 (t, 6H), 2.11 (s, 18H), 2.02 (s, 9H) 1.71-1.64 (m, 9H), 1.48-1.20 (m, 78H), 0.96-0.86 (m, 9H).

The maximum peak wavelength of the emission spectrum of compound MC2 was 470 nm.

### <Synthesis Example 3> Synthesis of Compound MC3

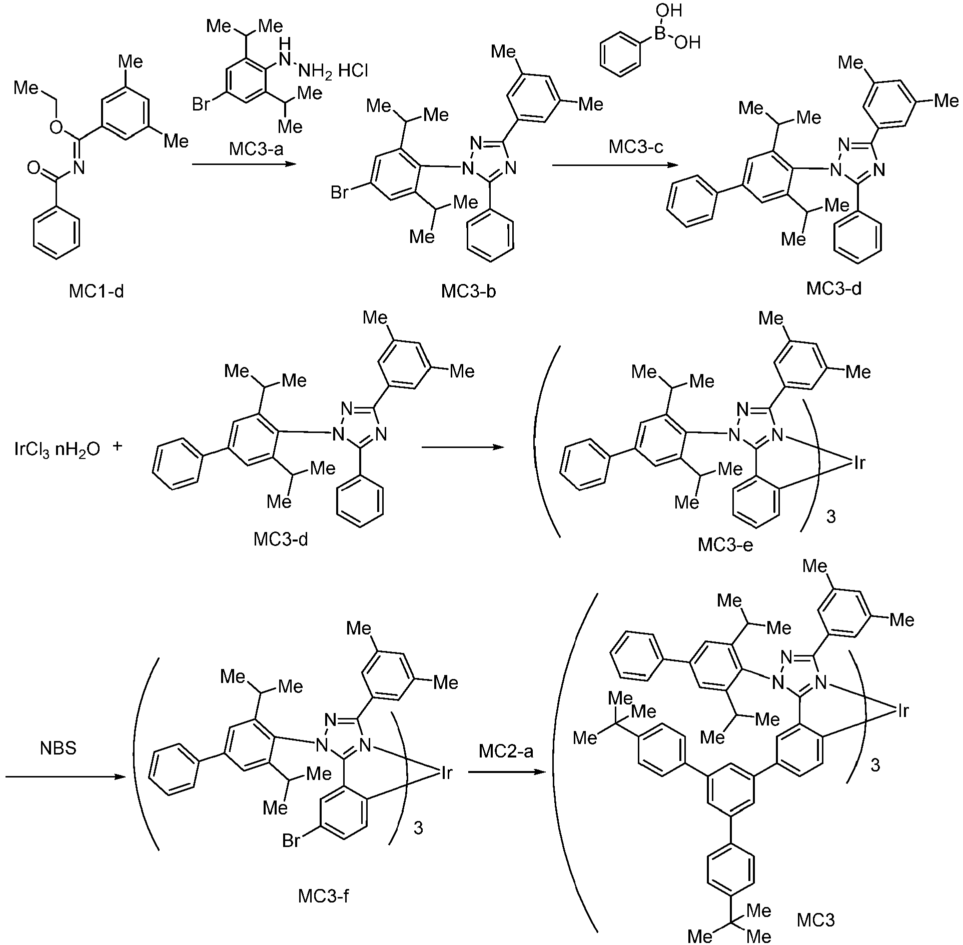

The atmosphere within a reaction vessel was replaced with argon gas, then the reaction vessel was charged with compound MC3-a (13.1 g) and tert-butyl methyl ether (110 mL), and the reaction vessel was placed in an ice bath to cool. Then, the reaction vessel was charged with an aqueous sodium hydroxide solution (1 mol/L, 125 mL), and the mixture was stirred for 30 minutes while cooling in an ice bath. The organic layer of the obtained reaction solution was extracted to obtain a tert-butyl methyl ether solution as an organic layer.

The atmosphere of a separately-prepared reaction vessel was replaced with argon gas, then the reaction vessel was charged with compound MC1-d (11.0 g) and chloroform (220 mL), and placed in an ice bath to cool. Then, the reaction vessel was charged with the above-obtained tert-butyl methyl ether solution, the mixture was stirred for 7 hours while cooling in an ice bath, and then stirred at room temperature for 110 hours. Ion-exchanged water (330 mL) was added to the obtained reaction solution, the organic layer was extracted, and the obtained organic layer was concentrated under reduced pressure. The resultant residue was purified by silica gel column chromatography (mixed solvent of chloroform and hexane), then, recrystallized from a mixed solvent of chloroform and heptane, and then, dried under reduced pressure at 50°C to obtain compound MC3-b (10.2 g, yield 55%) as a white solid. The HPLC area percentage value of compound MC3-b was 99.5% or more. The required amount of compound MC3-b was obtained by repeating this operation.
LC-MS (ESI, positive): m/z = 488.2 [M+H]⁺
¹H-NMR (CD₂Cl₂, 300 MHz): δ (ppm) = 7.92 (s, 2H), 7.66-7.62 (m, 2H), 7.52 (s, 2H), 7.52-7.36 (m, 3H), 7.16 (s, 1H), 2.57-2.46 (m, 8H), 1.20 (d, 6H), 0.97 (d, 6H).

The atmosphere within a reaction vessel was replaced with argon gas, then the reaction vessel was charged with compound MC3-b (10.2 g), compound MC3-c (2.8 g), bis[tri(2-methoxyphenyl)phosphine]palladium(II) dichloride (92.1 mg), toluene (102 mL), and a 20% by mass solution of aqueous tetraethylammonium hydroxide (36.9 g), and the mixture was stirred under reflux for 4 hours. Then, toluene was added, and the organic layer was extracted. The obtained organic layer was washed with ion-exchanged water to obtain an organic layer. The obtained organic layer was dried over anhydrous sodium sulfate, then silica gel (10 g) was added and the mixture was filtered. The obtained filtrate was concentrated under reduced pressure to obtain a solid. The obtained solid was recrystallized from a mixed solvent of heptane and chloroform. Then, the recrystallized product was dried under reduced pressure at 50°C to obtain compound MC3-d (8.55 g, yield 84%) as a white solid. The HPLC area percentage value of compound MC3-d was 99.5% or more.
LC-MS (ESI, positive): m/z = 486.3 [M+H]⁺
¹H-NMR (CD₂Cl₂, 300 MHz): δ (ppm) = 7.96 (s, 2H), 7.75 (t, 4H), 7.60-7.55 (m, 4H), 7.51-7.41 (m, 4H), 7.17 (s, 1H), 2.63-2.58 (m, 2H), 2.47 (d, 6H), 1.27 (d, 6H), 1.05 (d, 6H).

The atmosphere within a reaction vessel was replaced with argon gas, then the reaction vessel was charged with iridium chloride n-hydrate (1.96 g), compound MC3-d (5.61 g), ion-exchanged water (20 mL), and digylme (80 mL), and the mixture was heated and stirred at 150°C for 18 hours. Then, toluene was added and the mixture was washed with ion-exchanged water to obtain an organic layer. The obtained organic layer was concentrated under reduced pressure to obtain a solid. The obtained solid was purified by silica gel column chromatography (mixed solvent of toluene and methanol). The purified product was then dried under reduced pressure at 50°C to obtain a solid (5.16 g).

The atmosphere of a separately-prepared reaction vessel was replaced argon gas, then the reaction vessel was charged with the solid obtained above (4.5 g), silver trifluoromethanesulfonate (1.93 g), compound MC3-d (2.78 g), digylme (4.5 mL), decane (4.5 mL), and 2,6-lutidine (1.1 mL), and the mixture was heated and stirred at 160°C for 31 hours. Then, dichloromethane was added, and the mixture was filtered through a filter lined with Celite. The obtained filtrate was washed with ion-exchanged water to obtain an organic layer. The obtained organic layer was dried over anhydrous magnesium sulfate, then silica gel (18.6 g) was added and the mixture was filtered, and the obtained filtrate was concentrated under reduced pressure to obtain a solid. The obtained solid was purified by silica gel column chromatography (mixed solvent of cyclohexane and dichloromethane) and then recrystallized from a mixed solvent of toluene and acetonitrile. Then, the recrystallized product was dried under reduced pressure at 50°C to give compound MC3-e (1.9 g, yield 24%) as a yellow solid. The HPLC area percentage value of compound MC3-e was 98.9%.
LC-MS (APCI, positive): m/z = 1646.8 [M+H]⁺
¹H-NMR (CD₂Cl₂, 300 MHz): δ (ppm) = 9.12-7.10 (m, 27H), 7.00 (s, 3H), 6.72 (t, 3H), 6.62-6.33 (m, 9H), 2.74-1.67 (m, 24H), 1.25 (d, 9H), 1.15-1.00 (m, 18H), 0.84 (d, 9H).

The atmosphere within a reaction vessel was replaced with argon gas, then the reaction vessel was charged with compound MC3-e (0.70 g), dichloromethane (35 mL), and N-bromosuccinimide (825 mg), and the mixture was stirred at room temperature for 40 hours. Then, the reaction vessel was charged with a 10% by mass sodium sulfite aqueous solution (7.7 g), then with ion-exchanged water (15 mL), and the mixture was stirred at room temperature for 30 minutes. The organic layer was extracted from the obtained reaction solution, and the obtained organic layer was filtered with a filter lined with silica gel. Ethanol was added to the obtained filtrate to cause a precipitate to form. The obtained precipitate was filtered and vacuum dried at 50°C to obtain compound MC3-f (0.73 g, yield 91%) as a yellow solid. The HPLC area percentage value of compound MC3-f was 96%.
LC-MS (APCI, positive): m/z = 1880.5 [M+H]⁺
¹H-NMR (CD₂Cl₂, 300 MHz): δ (ppm) = 8.25-7.83 (m, 6H), 7.76 (d, 6H), 7.76-7.46 (m, 15H), 7.04 (s, 3H), 6.83 (d, 3H), 6.50 (s, 3H), 6.31 (d, 3H), 2.33-1.85 (m, 24H), 1.25 (d, 9H), 1.12-1.07 (m, 18H), 0.84 (d, 9H).

The atmosphere within a reaction vessel was replaced with argon gas, then the reaction vessel was charged with MC3-f (0.31 g), compound MC2-a (0.31 g), toluene (9.3 mL), and bis(di-tert-butyl(4-dimethylaminophenyl)phosphine)dichloropalladium( II) (3.5 mg), and the temperature was increased to 90°C. Then, the reaction vessel was charged with a 20% by mass tetraethylammonium hydroxide aqueous solution (2.7 mL), and the mixture was stirred under reflux for 5 hours. Then, toluene was added, and the organic layer was extracted. The obtained organic layer was washed with ion-exchanged water, dried over anhydrous magnesium sulfate, filtered through a filter lined with silica gel, and the obtained filtrate was concentrated under reduced pressure to obtain a solid. The obtained solid was purified by silica gel column chromatography (mixed solvent of cyclohexane and dichloromethane) and then recrystallized from a mixed solvent of dichloromethane and hexane. Then, the recrystallized product was dried under reduced pressure at 50°C to give compound MC3 (0.26 g, yield 60%) as a yellow solid. The HPLC area percentage value of compound MC3 was 99.5% or more.
LC-MS (APCI, positive): m/z = 2667.5 [M+H]⁺
¹H-NMR (CD₂Cl₂, 300 MHz): δ (ppm) = 8.40-7.32 (m, 60H), 7.15 (d, 3H), 7.05-7.03 (m, 6H), 6.76 (s, 3H), 2.54-2.50 (m, 3H), 2.18-2.13 (m, 18H), 1.38 (s, 54H), 1.31-1.13 (m, 30H), 0.90 (d, 9H).

The maximum peak wavelength of the emission spectrum of compound MC3 was 469 nm.

### (Synthesis Example 4) Synthesis of Compound MC4

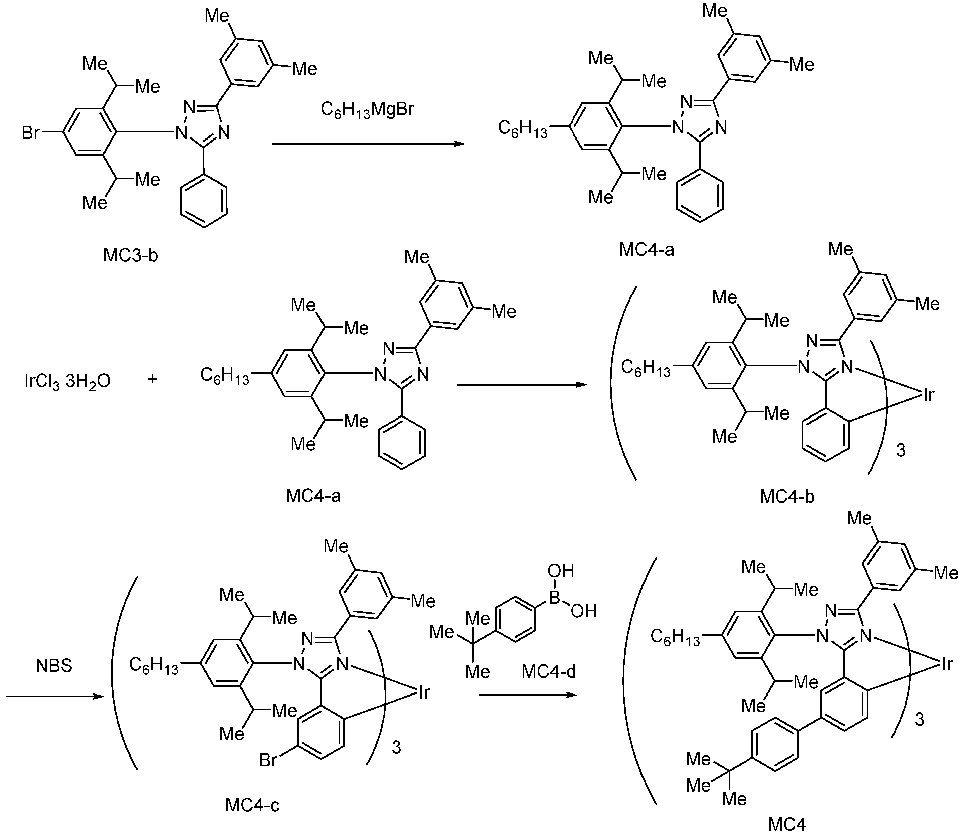

The atmosphere within a reaction vessel was replaced with argon gas, then the reaction vessel was charged with compound MC3-b (17.0 g), cyclopentyl methyl ether (150 mL), and [1,1'-bis(diphenylphosphino)ferrocene]palladium(II) dichloride (172 mg), and the temperature was increased to 50°C. Then, the reaction vessel was charged with a solution of hexyl magnesium bromide (2 mol/L, 35 mL) in diethyl ether, and the mixture was stirred at 50°C for 5 hours. Then, the reaction vessel was charged with an aqueous hydrochloric acid solution (1 mol/L, 35 mL), and the organic layer was extracted. The obtained organic layer was washed twice with ion-exchanged water (85 mL), dried over anhydrous magnesium sulfate, filtered and the resultant filtrate was concentrated under reduced pressure to obtain an oily substance. Toluene and silica gel were added to the obtained oily substance, and the resultant mixture was stirred at room temperature for 30 minutes. Then, the mixture was filtered through a filter lined with Celite, and the resultant filtrate was concentrated under reduced pressure to obtain a solid. The obtained solid was recrystallized from acetonitrile. Then, the recrystallized product was dried under reduced pressure at 50°C to obtain compound MC4-a (13.7 g, yield 80%) as a white solid. The HPLC area percentage value of compound MC4-a was 99.5% or more.
TLC/MS (DART, positive): m/z = 494 [M+H]⁺
¹H-NMR (300 MHz, CD₂Cl₂-d₂) δ (ppm) = 7.92 (s, 2H), 7.67-7.63 (m, 2H), 7.46-7.33 (m, 3H), 7.18 (s, 2H), 7.14 (s, 1H), 2.76 (t, 2H), 2.57-2.46 (m, 8H), 1.77-1.70 (m, 2H), 1.48-1.42 (m, 6H), 1.21-1.19 (m, 6H), 0.98-0.96 (m, 9H).

The atmosphere within a reaction vessel was replaced with argon gas, then the reaction vessel was charged with iridium chloride trihydrate (2.96 g), compound MC4-a (8.65 g), ion-exchanged water (30 mL), and diglyme (74 mL), and the mixture was stirred under reflux for 18 hours. Then, the mixture was cooled to room temperature, toluene was added, and the mixture was washed with ion-exchanged water. The organic layer of the obtained washing solution was extracted, and the obtained organic layer was concentrated under reduced pressure to obtain a solid. The obtained solid was purified by silica gel column chromatography (mixed solvent of toluene and ethanol) to obtain solid (7.51 g).

The atmosphere of a separately-prepared reaction vessel was replaced with argon gas, then the reaction vessel was charged with the solid obtained above (7.40 g), silver trifluoromethanesulfonate (3.19 g), compound MC4-a (4.59 g), 2,6-lutidine (1.66 g), and decane (15 mL), and the mixture was heated and stirred at 150°C for 20 hours. Then, the mixture was cooled to room temperature, toluene was added, and the mixture was filtered through a filter lined with silica gel and Celite, and the obtained filtrate was washed with ion-exchanged water to obtain an organic layer. The obtained organic layer was concentrated under reduced pressure to obtain a solid. The obtained solid was purified by silica gel column chromatography (mixed solvent of dichloromethane and cyclohexane) and then recrystallized from a mixed solvent of toluene and methanol. Then, the recrystallized product was dried under reduced pressure at 50°C to give compound MC4-b (1.47 g, yield 14%) as a yellow solid. The HPLC area percentage value of compound MC4-b was 99.4%.
LC-MS (APCI, positive): m/z = 1671.0 [M+H]⁺
¹H-NMR (300 MHz, CD₂Cl₂-d₂) δ (ppm) = 8.03 (br, 6H), 7.17 (s, 6H), 6.96 (s, 3H), 6.66 (t, 3H), 6.51-6.41 (m, 6H), 6.32 (d, 3H), 2.76 (t, 6H), 2.23-1.92 (m, 21H), 1.76-1.69 (m, 6H), 1.58 (s, 3H), 1.53-1.42 (m, 18H), 1.16 (d, 9H), 1.01-0.96 (m, 27H), 0.73 (d, 9H).

The atmosphere within a reaction vessel was replaced with argon gas, then the reaction vessel was charged with compound MC4-b (1.36 g), dichloromethane (68 mL), and N-bromosuccinimide (1.23 g), and the mixture was stirred at room temperature for 32 hours. Then, the reaction vessel was charged with a 10% by mass solution of aqueous sodium sulfite (8.71 g), then ion-exchanged water (70 mL) was added, and the mixture was stirred at room temperature for 30 minutes. An organic layer was extracted from the obtained reaction solution, and the obtained organic layer was filtered with a filter lined with silica gel. The obtained filtrate was concentrated under reduced pressure to obtain a solid. The obtained solid was dissolved in toluene, and methanol was added to the mixture to cause a precipitate to form. The obtained precipitate was filtered and vacuum dried at 50°C to obtain compound MC4-c (1.47 g, yield 95%) as a yellow solid. The HPLC area percentage value of compound MC4-c was 99.5% or more.
LC-MS (APCI, positive): m/z = 1903.7 [M+H]⁺
¹H-NMR (300 MHz, CD₂Cl₂-d₂) δ (ppm) = 8.00 (br, 6H), 7.20 (s, 6H), 6.99 (s, 3H), 6.67 (d, 3H), 6.36 (d, 3H), 6.25 (d, 3H), 2.78 (t, 6H), 2.06-1.69 (m, 30H), 1.46-1.41 (m, 18H), 1.16 (d, 9H), 1.03-0.94 (m, 27H), 0.74 (d, 9H).

The atmosphere within a reaction vessel was replaced with argon gas, then the reaction vessel was charged with compound MC4-c (1.30 g), compound MC4-d (0.44 g), toluene (65 mL), and (di-tert-butyl(4-dimethylaminophenyl)phosphine)dichloropalladium(II) (16 mg), and the temperature was increased to 80°C. Then, the reaction vessel was charged with a 20% by mass tetrabutylammonium hydroxide aqueous solution (23 mL), and the mixture was stirred under reflux for 36 hours. Then, the mixture was cooled to room temperature, toluene was added, and the organic layer was extracted. The obtained organic layer was washed with ion-exchanged water, dried over anhydrous magnesium sulfate, filtered through a filter lined with silica gel and Celite, and the obtained filtrate was concentrated under reduced pressure to obtain a solid. The obtained solid was purified by silica gel column chromatography (mixed solvent of dichloromethane and cyclohexane) and then recrystallized from a mixed solvent of ethyl acetate and acetonitrile. Then, the recrystallized product was dried under reduced pressure at 50°C to give compound MC4 (0.93 g, yield 72%) as a yellow solid. The HPLC area percentage value of compound MC4 was 99.5% or more.
LC-MS (APCI, positive): m/z = 2067.3 [M+H]⁺
¹H-NMR (300 MHz, CD₂Cl₂-d₂) δ (ppm) = 8.04 (br, 6H), 7.30-7.26 (m, 12H), 7.06-6.98 (m, 12H), 6.70 (s, 3H), 6.54 (d, 3H), 2.82 (t, 6H), 2.32-1.78 (m, 27H), 1.59-1.42 (m, 21H), 1.34 (s, 27H), 1.20 (d, 9H), 1.10 (d, 9H), 1.04-0.98 (m, 18H), 0.73 (d, 9H).

The maximum peak wavelength of the emission spectrum of compound MC4 was 469 nm.

### <Synthesis Example 5> Synthesis of Compound MC5

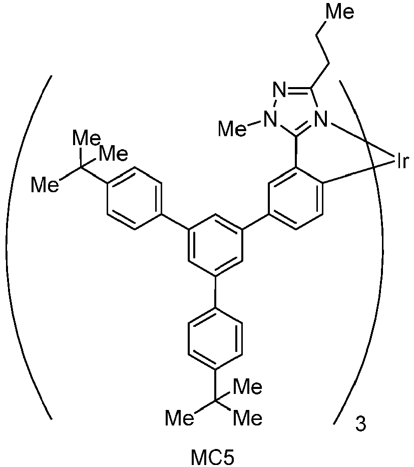

Compound MC5 was synthesized according to the methods described in Japanese Unexamined Patent Publication No. 2013-147551.

The maximum peak wavelength of the emission spectrum of compound MC5 was 475 nm.

### <Preparation of Compounds G1, G2, G3, G4, G5 and G6>

Compound G1 (COM-1) was synthesized according to the methods described in Japanese Unexamined Patent Publication No. 2013-237789.

Compounds G2 and G5 were synthesized according to the methods described in International Publication No. 2004/026886.

Compound G3 was synthesized according to the methods described in International Publication No. 2009/131255.

Compound G4 (Ir(ppy)₃) was purchased from Luminescence Technology Corp.

Compound G6 was synthesized according to the methods described in Japanese Unexamined Patent Publication No. 2014/224101 and International Publication No. 2009/131255.

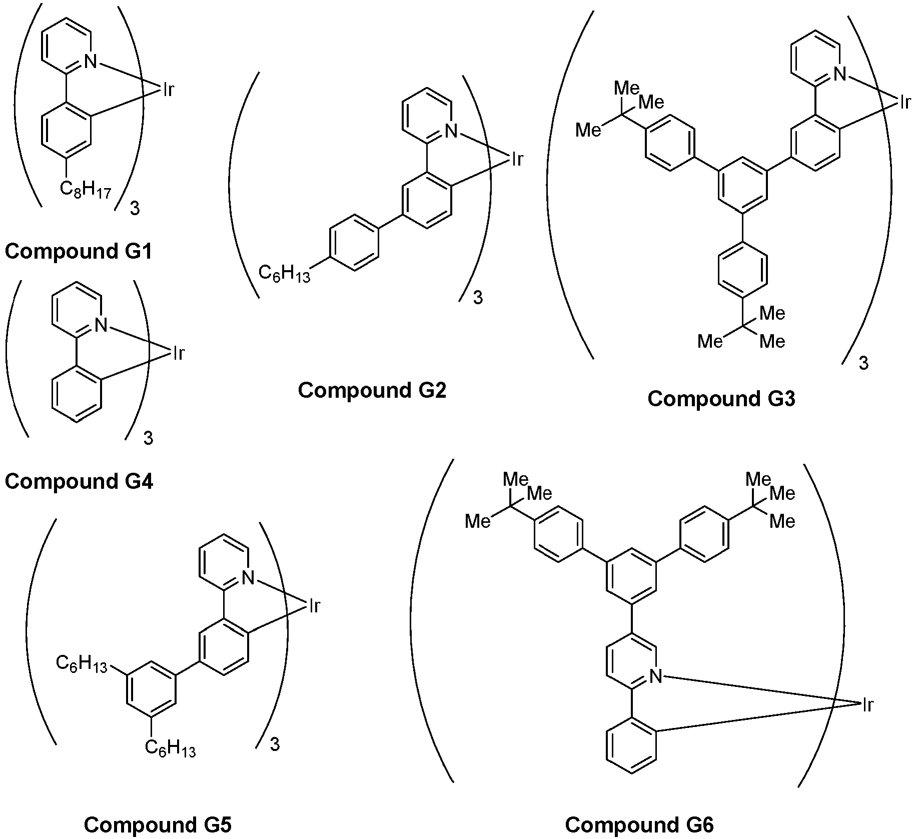

The maximum peak wavelength of the emission spectrum of compound G1 was 508 nm.

The maximum peak wavelength of the emission spectrum of compound G2 was 518 nm.

The maximum peak wavelength of the emission spectrum of compound G3 was 514 nm.

The maximum peak wavelength of the emission spectrum of compound G4 was 510 nm.

The maximum peak wavelength of the emission spectrum of compound G5 was 517 nm.

The maximum peak wavelength of the emission spectrum of compound G6 was 544 nm.

### <Preparation of Compounds R1, R2, R3, R4, R5 and R6>

Compound R1 was synthesized according to the methods described in International Publication No. 2002/44189.

Compound R2 (COM-5) was synthesized according to the methods described in Japanese Unexamined Patent Publication No. 2006-188673.

Compound R3 (COM-2) was purchased from American Dye Source.

Compound R4 was purchased from Luminescence Technology Corp.

Compound R5 (COM-3) was synthesized according to the methods described in Japanese Unexamined Patent Publication No. 2006-188673.

Compound R6 was synthesized according to the method described in Japanese Unexamined Patent Publication No. 2008-179617.

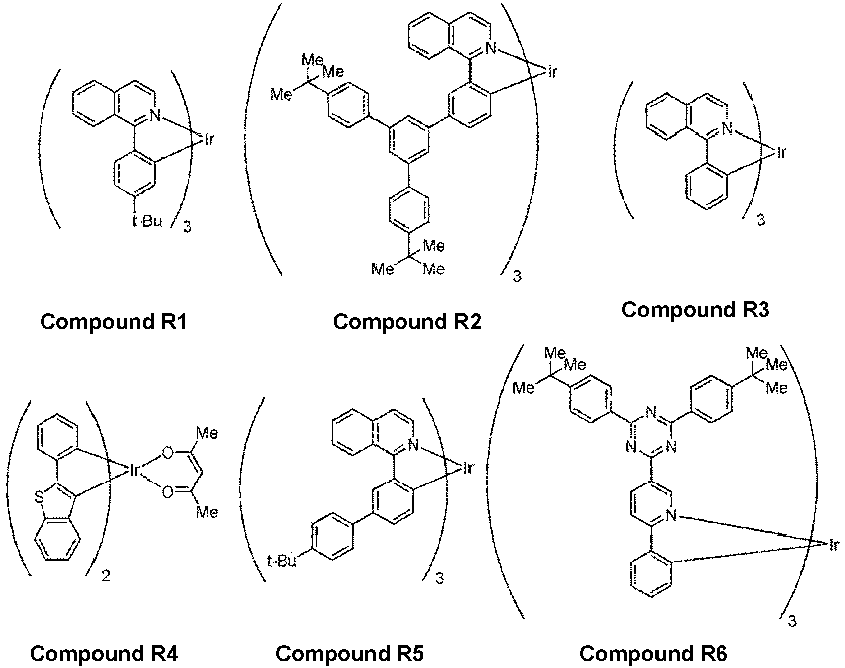

The maximum peak wavelength of the emission spectrum of compound R1 was 617 nm.

The maximum peak wavelength of the emission spectrum of compound R2 was 619 nm.

The maximum peak wavelength of the emission spectrum of compound R3 was 618 nm.

The maximum peak wavelength of the emission spectrum of compound R4 was 614 nm.

The maximum peak wavelength of the emission spectrum of compound R5 was 626 nm.

The maximum peak wavelength of the emission spectrum of compound R6 was 595 nm.

### <Synthesis Example 6> Synthesis of Polymer Compound HTL-1

Polymer compound HTL-1 was synthesized by the following steps 1 to 4.
(Step 1) The atmosphere within a reaction vessel was replaced with inert gas, then the reaction vessel was charged with compound CM7 (0.917 g) described in International Publication No. 2005/049546, compound CM8 (0.0496 g) described in International Publication No. 2013/146806, compound CM10 (0.923 g) synthesized according to the method described in International Publication No. 2015/145871, dichlorobis(tris-o-methoxyphenylphosphine)palladium (1.76 mg), and toluene (34 ml), and the mixture was heated to 105°C. 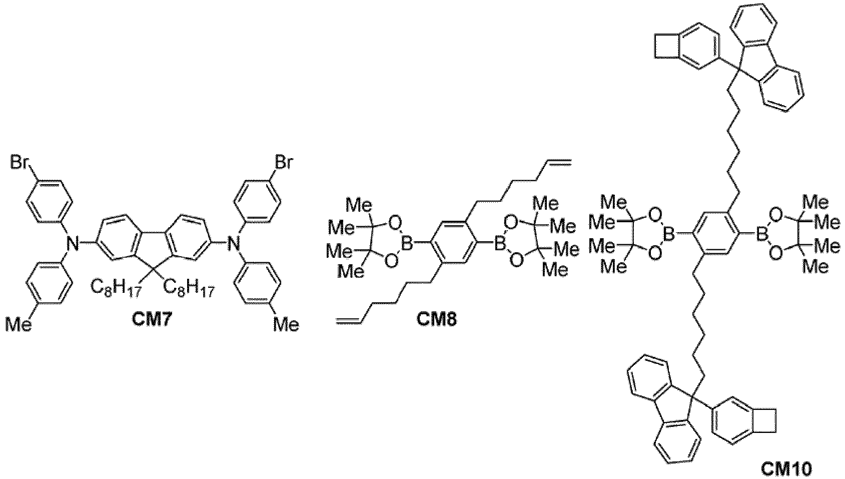
(Step 2) A 20% by mass solution of aqueous tetraethylammonium hydroxide (6.7 mL) was added dropwise to the reaction solution, and the mixture was refluxed for 6 hours.
(Step 3) After the reaction, phenylboronic acid (48.8 mg), dichlorobis(tris-o-methoxyphenylphosphine)palladium (0.88 mg) were added, and the mixture was refluxed for 14.5 hours.
(Step 4) Then, an aqueous sodium diethyldithiocarbamate solution was added, and the mixture was stirred at 80°C for 2 hours. The reaction solution was cooled, then washed twice with water, twice with 3% by mass aqueous acetic acid solution, and twice with water, and the resultant solution was dropped into methanol, which caused a precipitate to form. The resultant precipitate was dissolved in toluene and purified by passing through an alumina column and a silica gel column in that order. The obtained solution was dropped into methanol, and the mixture was stirred, which caused a precipitate to form. The obtained precipitate was collected by filtration and dried to obtain 1.23 g of the polymer compound HTL-1.

The polystyrene-equivalent number-average molecular weight of the polymer compound HTL-1 was 2.3 × 10⁴, and the polystyrene-equivalent weight-average molecular weight was 1.2 × 10⁵.

The polymer compound HTL-1 was a copolymer having, based on the theoretical values obtained from the amounts of the charged raw materials, a molar ratio among the constitutional unit derived from compound CM7, the constitutional unit derived from compound CM8, and the constitutional unit derived from compound CM10 of 50:5:45.

### <Synthesis Example 7> Synthesis of Polymer Compound ETL-1 (Synthesis of Polymer Compound ETL-1a)

The polymer compound ETL-1a was synthesized according to the synthesis methods described in Japanese Unexamined Patent Publication No. 2012-33845 using the compound ET1-1 synthesized according to the methods described in Japanese Unexamined Patent Publication No. 2012-33845 and the compound M4 synthesized according to the synthesis methods described in Japanese Unexamined Patent Publication No. 2012-33845.

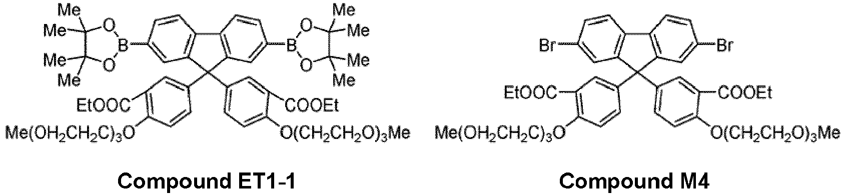

The Mn of the polymer compound ETL-1a was 5.2 × 10⁴.

The polymer compound ETL-1a was a copolymer having, based on the theoretical values obtained from the amounts of the charged raw materials, a molar ratio among the constitutional unit derived from compound ET1-1 and the constitutional unit derived from compound M4 of 50:50.

### (Synthesis of Polymer Compound ETL-1)

The atmosphere within a reaction vessel was replaced with inert gas, then the reaction vessel was charged with polymer compound ETL-1a (200 mg), tetrahydrofuran (20 mL), and ethanol (20 mL), and the mixture was heated to 55°C. Then, cesium hydroxide (200 mg) dissolved in water (2 mL) was added, and the mixture was stirred at 55°C for 6 hours. Then, the mixture was cooled to room temperature, and concentrated under reduced pressure to obtain a solid. The obtained solid was washed with water and then dried under reduced pressure to obtain polymer compound ETL-1 (150 mg, pale yellow solid). From the NMR spectrum of the obtained polymer compound ETL-1, it was confirmed that the signal derived from the ethyl group at the ethyl ester site of the polymer compound ETL-1a had completely disappeared.

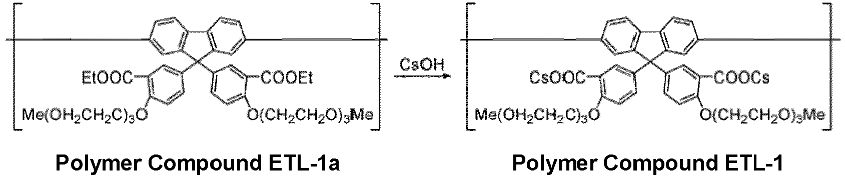

### <Example D1> Fabrication and Evaluation of Light-Emitting Device D1

### (Fabrication of Light-Emitting Device D1)

### [Formation of Anode and Hole Injection Layer]

An ITO film with a thickness of 45 nm was attached to a glass substrate by a sputtering method to form an anode. On the anode, a polythiophene-sulfonic acid type hole injection material AQ-1200 (manufactured by Plextronics) was spin-coated to form a film with a thickness of 35 nm, and the film was heated on a hot plate at 170°C for 15 minutes under an air atmosphere to form a hole injection layer.

### [Formation of Hole Transporting Layer]

A polymer compound HTL-1 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere to form a hole transporting layer.

### [Formation of Light-Emitting Layer]

Low molecular weight compound HM-1 (compound represented by formula (H-113)) (manufactured by Luminescence Technology Corp), compound MC1, and compound R1 (low molecular weight compound HM-1/compound MC1/compound R1=74% by mass/25% by mass/1% by mass) were dissolved in toluene at a concentration of 2.0% by mass. The resultant toluene solution was spin-coated on the hole transporting layer to form a film with a thickness of 75 nm, and the film was heated at 130°C for 10 minutes under a nitrogen gas atmosphere to form a light-emitting layer.

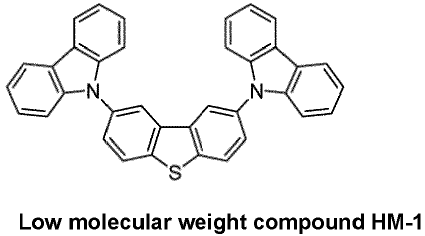

### [Formation of Electron Transporting Layer]

A polymer compound ETL-1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the light-emitting layer to form a film with a thickness of 10 nm, and the film was heated at 130°C for 10 minutes under a nitrogen gas atmosphere to form an electron transporting layer.

### [Formation of Cathode]

The cathode was formed by placing the substrate on which the electron transporting layer had been formed in a vapor deposition machine, then reducing the pressure to 1.0 × 10⁻⁴ Pa or less, followed by vapor-depositing sodium fluoride to a thickness of about 4 nm on the electron transporting layer, and then vapor-deposited aluminum to a thickness of about 80 nm on the sodium fluoride layer.

After the cathode had been formed, sealing was performed using a glass substrate to fabricate a light-emitting device D1.

### (Evaluation of Light-Emitting Device D1)

EL emission was observed by applying a voltage to the light-emitting device D1. The external quantum efficiency (hereinafter, referred to as "EQE") at 500 cd/m² was 8.76 [%], and the CIE chromaticity coordinate (x, y) was (0.594, 0.308). The results are shown in Table 2.

After setting the current value so that the initial luminance of the light-emitting device CD1 was 1000 cd/m², the light-emitting device CD1 was driven at a constant current, and the time until the luminance reached 75% of the initial luminance (hereinafter, referred to as "LT75") was measured to be 20.8 hours.

### <Comparative Example CD1> Fabrication and Evaluation of Light-Emitting Device CD1

A light-emitting device CD1 was fabricated in the same manner as in Example D1, except that a low molecular weight compound HM-1, compound MC1, and compound R3 (low molecular weight compound HM-1/compound MC1/compound R3= 74% by mass/25% by mass/1% by mass) was used in place of a low molecular weight compound HM-1, compound MC1, and compound R1 (low molecular weight compound HM-1/compound MC1/compound R= 74% by mass/25% by mass/1% by mass) in the (Formation of Light-Emitting Layer) of Example D1.

EL emission was observed by applying a voltage to the light-emitting device CD1. The EQE at 500 cd/m² was 6.26 [%], and the CIE chromaticity coordinate (x, y) was (0.292, 0.252). The results are shown in Table 2. Further, the LT75 at 1000 cd/m² was 5.3 hours.

### <Comparative Example CD2> Fabrication and Evaluation of Light-Emitting Device CD2

A light-emitting device CD2 was fabricated in the same manner as in Example D1, except that a low molecular weight compound HM-1, compound MC1, and compound R4 (low molecular weight compound HM-1/compound MC1/compound R4= 74% by mass/25% by mass/1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device CD2. The EQE at 500 cd/m² was 4.67 [%], and the CIE chromaticity coordinate (x, y) was (0.460, 0.283). The results are shown in Table 2. Further, the LT75 at 1000 cd/m² was 2.9 hours.

**[Table 2]**

| | Light-Emitting Device | Light-Emitting Layer | | EQE [%] | CIE Chromaticity Coordinate (x, y) |
|---|---|---|---|---|---|
| | | Composition | Composition Ratio (% by mass) | (500 cd/m²) | (500 cd/m²) |
| Example D1 | D1 | HM-1/MC1/R1 | 74/25/1 | 8.76 | (0.594, 0.308) |
| Comparative Example CD 1 | CD1 | HM-1/MC1/R3 | 74/25/1 | 6.26 | (0.292, 0.252) |
| Comparative Example CD2 | CD2 | HM-1/MC1/R4 | 74/25/1 | 4.67 | (0.460, 0.283) |

### <Example D2> Fabrication and Evaluation of Light-Emitting Device D2

A light-emitting device D2 was fabricated in the same manner as in Example D1, except that a low molecular weight compound HM-1, compound MC1, compound G1, and compound R4 (low molecular weight compound HM-1/compound MC1/compound G1/compound R4= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D2. The EQE at 500 cd/m² was 9.32 [%], and the CIE chromaticity coordinate (x, y) was (0.266, 0.550). The results are shown in Table 3.

### <Example D3> Fabrication and Evaluation of Light-Emitting Device D3

A light-emitting device D3 was fabricated in the same manner as in Example D1, except that a low molecular weight compound HM-1, compound MC1, compound G1, and compound R1 (low molecular weight compound HM-1/compound MC1/compound G1/compound R1= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D3. The EQE at 500 cd/m² was 10.6 [%], and the CIE chromaticity coordinate (x, y) was (0.329, 0.510). The results are shown in Table 3. Further, the LT75 at 1000 cd/m² was 30.8 hours.

### <Example D4> Fabrication and Evaluation of Light-Emitting Device D4

A light-emitting device D4 was fabricated in the same manner as in Example D1, except that a low molecular weight compound HM-1, compound MC2, compound G1, and compound R2 (low molecular weight compound HM-1/compound MC2/compound G1/compound R2= 73.9% by mass/25% by mass/1% by mass/0.1% by mass) was used in place of "a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D4. The EQE at 500 cd/m² was 13.0 [%], and the CIE chromaticity coordinate (x, y) was (0.279, 0.534). The results are shown in Table 3.

### <Example D5> Fabrication and Evaluation of Light-Emitting Device D5

A light-emitting device D5 was fabricated in the same manner as in Example D1, except that a low molecular weight compound HM-1, compound MC2, compound G1, and compound R5 (low molecular weight compound HM-1/compound MC2/compound G1/compound R5 = 73.9% by mass/25% by mass/1% by mass/0.1% by mass) was used in place of a low molecular weight compound HM-1, compound MC1, and compound R1 (low molecular weight compound HM-1/compound MC1/compound R1 = 74% by mass/25% by mass/1% by mass) in the (Formation of Light-Emitting Layer) of Example D1.

EL emission was observed by applying a voltage to the light-emitting device D5. The EQE at 500 cd/m² was 12.1 [%], and the CIE chromaticity coordinate (x, y) was (0.297, 0.522). The results are shown in Table 3. Further, the LT75 at 1000 cd/m² was 33.4 hours.

### <Example D6> Fabrication and Evaluation of Light-Emitting Device D6

A light-emitting device D6 was fabricated in the same manner as in Example D1, except that a low molecular weight compound HM-1, compound MC1, compound G2, and compound R2 (low molecular weight compound HM-1/compound MC1/compound G2/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D6. The EQE at 500 cd/m² was 9.03 [%], and the CIE chromaticity coordinate (x, y) was (0.316, 0.534). The results are shown in Table 3.

### <Example D7> Fabrication and Evaluation of Light-Emitting Device D7

A light-emitting device D7 was fabricated in the same manner as in Example D1, except that a low molecular weight compound HM-1, compound MC2, compound G2, and compound R2 (low molecular weight compound HM-1/compound MC2/compound G2/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D7. The EQE at 500 cd/m² was 11.3 [%], and the CIE chromaticity coordinate (x, y) was (0.304, 0.537). The results are shown in Table 3.

### <Example D8> Fabrication and Evaluation of Light-Emitting Device D8

A light-emitting device D8 was fabricated in the same manner as in Example D1, except that a low molecular weight compound HM-1, compound MC1, compound G2, and compound R6 (low molecular weight compound HM-1/compound MC1/compound G2/compound R6= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D8. The EQE at 500 cd/m² was 9.39 [%], and the CIE chromaticity coordinate (x, y) was (0.398, 0.498). The results are shown in Table 3. Further, the LT75 at 1000 cd/m² was 45.5 hours.

### <Example D9> Fabrication and Evaluation of Light-Emitting Device D9

A light-emitting device D9 was fabricated in the same manner as in Example D1, except that a low molecular weight compound HM-1, compound MC2, compound G2, and compound R6 (low molecular weight compound HM-1/compound MC2/compound G2/compound R6= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D9. The EQE at 500 cd/m² was 11.5 [%], and the CIE chromaticity coordinate (x, y) was (0.384, 0.506). The results are shown in Table 3.

### <Example D10> Fabrication and Evaluation of Light-Emitting Device D10

A light-emitting device D10 was fabricated in the same manner as in Example D1, except that a low molecular weight compound HM-1, compound MC2, compound G3, and compound R2 (low molecular weight compound HM-1/compound MC2/compound G3/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D10. The EQE at 500 cd/m² was 9.74 [%], and the CIE chromaticity coordinate (x, y) was (0.274, 0.472). The results are shown in Table 3.

### <Comparative Example CD3> Fabrication and Evaluation of Light-Emitting Device CD3

A light-emitting device CD3 was fabricated in the same manner as in Example D1, except that a low molecular weight compound HM-1, compound MC1, compound G4, and compound R4 (low molecular weight compound HM-1/compound MC1/compound G4/compound R4= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device CD3. The EQE at 500 cd/m² was 8.69 [%], and the CIE chromaticity coordinate (x, y) was (0.275, 0.540). The results are shown in Table 3. Further, the LT75 at 1000 cd/m² was 19.5 hours.

### <Comparative Example CD4> Fabrication and Evaluation of Light-Emitting Device CD4

A light-emitting device CD4 was fabricated in the same manner as in Example D1, except that a low molecular weight compound HM-1, compound MC1, compound G4, and compound R3 (low molecular weight compound HM-1/compound MC1/compound G4/compound R3= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass in the (Formation of Light-Emitting Layer) of Example D1).

EL emission was observed by applying a voltage to the light-emitting device CD4. The EQE at 500 cd/m² was 8.41 [%], and the CIE chromaticity coordinate (x, y) was (0.323, 0.500). The results are shown in Table 3. Further, the LT75 at 1000 cd/m² was 25.3 hours.

**[Table 3]**

| | Light-Emitting Device | Light-Emitting Layer | | EQE [%] | CIE Chromaticity Coordinate (x, y) |
|---|---|---|---|---|---|
| | | Composition | Composition Ratio (% by mass) | (500 cd/m²) | (500 cd/m²) |
| Example D2 | D2 | HM-1/MC1/G1/R4 | 73.9/25/1/0.1 | 9.32 | (0.266, 0.550) |
| Example D3 | D3 | HM-1/MC1/G1/R1 | 73.9/25/1/0.1 | 10.6 | (0.329, 0.510) |
| Example D4 | D4 | HM-1/MC2/G1/R2 | 73.9/25/1/0.1 | 13.0 | (0.279, 0.534) |
| Example D5 | D5 | HM-1/MC2/G1/R5 | 73.9/25/1/0.1 | 12.1 | (0.297, 0.522) |
| Example D6 | D6 | HM-1/MC1/G2/R2 | 73.9/25/1/0.1 | 9.03 | (0.316, 0.534) |
| Example D7 | D7 | HM-1/MC2/G2/R2 | 73.9/25/1/0.1 | 11.3 | (0.304, 0.537) |
| Example D8 | D8 | HM-1/MC1/G2/R6 | 73.9/25/1/0.1 | 9.39 | (0.398, 0.498) |
| Example D9 | D9 | HM-1/MC2/G2/R6 | 73.9/25/1/0.1 | 11.5 | (0.384, 0.506) |
| Example D10 | D10 | HM-1/MC2/G3/R2 | 73.9/25/1/0.1 | 9.74 | (0.274, 0.472) |
| Comparative Example CD3 | CD3 | HM-1/MC1/G4/R4 | 73.9/25/1/0.1 | 8.69 | (0.275, 0.540) |
| Comparative Example CD4 | CD4 | HM-1/MC1/G4/R3 | 73.9/25/1/0.1 | 8.41 | (0.323, 0.500) |

### <Example D11> Fabrication and Evaluation of Light-Emitting Device D11

A light-emitting device D11 was fabricated in the same manner as in Example D1, except that a low molecular weight compound HM-1, compound MC3, compound G5, and compound R2 (low molecular weight compound HM-1/compound MC3/compound G5/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D11. The EQE at 100 cd/m² was 8.89 [%], and the CIE chromaticity coordinate (x, y) was (0.416, 0.475). The results are shown in Table 4.

After setting the current value so that the initial luminance of the light-emitting device D11 was 1000 cd/m², the light-emitting device D11 was driven at a constant current, and the time until the luminance reached 90% of the initial luminance (hereinafter, referred to as "LT90") was measured to be 7.32 hours.

### <Comparative Example CD5> Fabrication and Evaluation of Light-Emitting Device CD5

A light-emitting device CD5 was fabricated in the same manner as in Example D1, except that a low molecular weight compound HM-1, compound MC5, compound G5, and compound R2 (low molecular weight compound HM-1/compound MC5/compound G5/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device CD5. The EQE at 100 cd/m² was 8.53 [%], and the CIE chromaticity coordinate (x, y) was (0.392, 0.435). The results are shown in Table 4. Further, the LT90 at 1000 cd/m² was 0.961 hours.

**[Table 4]**

| | Light-Emitting Device | Light-Emitting Layer | | EQE [%] | CIE Chromaticity Coordinate (x, y) |
|---|---|---|---|---|---|
| | | Composition | Composition Ratio (% by mass) | (100 cd/m²) | (100 cd/m²) |
| Example D11 | D11 | HM-1/MC3/G5/R2 | 73.9/25/1/0.1 | 8.89 | (0.416, 0.475) |
| Comparative Example CD5 | CD5 | HM-1/MC5/G5/R2 | 73.9/25/1/0.1 | 8.53 | (0.392, 0.435) |

### <Example D12> Fabrication and Evaluation of Light-Emitting Device D12

A light-emitting device D12 was fabricated in the same manner as in Example D1, except that a low molecular weight compound HM-1, compound MC3, compound G6, and compound R2 (low molecular weight compound HM-1/compound MC3/compound G6/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D12. The EQE at 10 kcd/m² was 8.46 [%], and the CIE chromaticity coordinate (x, y) was (0.393, 0.448). The results are shown in Table 5. Further, the LT90 at 1000 cd/m² was 2.98 hours.

### <Example D13> Fabrication and Evaluation of Light-Emitting Device D13

A light-emitting device D13 was fabricated in the same manner as in Example D1, except that a low molecular weight compound HM-1, compound MC4, compound G1, and compound R5 (low molecular weight compound HM-1/compound MC4/compound G1/compound R5= 73.9% by mass/25% by mass/1% by mass/0.1% by mass) was used in place of a low molecular weight compound HM-1, compound MC1, and compound R1 (low molecular weight compound HM-1/compound MC1/compound R1= 74% by mass/25% by mass/1% by mass) in the (Formation of Light-Emitting Layer) of Example D1.

EL emission was observed by applying a voltage to the light-emitting device D13. The EQE at 10 kcd/m² was 9.35 [%], and the CIE chromaticity coordinate (x, y) was (0.307, 0.494). The results are shown in Table 5. Further, the LT90 at 1000 cd/m² was 2.24 hours.

### <Example D14> Fabrication and Evaluation of Light-Emitting Device D14

A light-emitting device D14 was fabricated in the same manner as in Example D1, except that a low molecular weight compound HM-1, compound MC3, compound G3, and compound R2 (low molecular weight compound HM-1/compound MC3/compound G3/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D14. The EQE at 10 kcd/m² was 7.48 [%], and the CIE chromaticity coordinate (x, y) was (0.282, 0.484). The results are shown in Table 5. Further, the LT90 at 1000 cd/m² was 4.48 hours.

### <Example D15> Fabrication and Evaluation of Light-Emitting Device D15

A light-emitting device D15 was fabricated in the same manner as in Example D1, except that a low molecular weight compound HM-1, compound MC4, compound G3, and compound R2 (low molecular weight compound HM-1/compound MC4/compound G3/compound R2= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D15. The EQE at 10 kcd/m² was 8.59 [%], and the CIE chromaticity coordinate (x, y) was (0.275, 0.461). The results are shown in Table 5.

### <Example D16> Fabrication and Evaluation of Light-Emitting Device D16

A light-emitting device D16 was fabricated in the same manner as in Example D1, except that a low molecular weight compound HM-1, compound MC4, compound G3, and compound R6 (low molecular weight compound HM-1/compound MC4/compound G3/compound R6= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D16. The EQE at 10 kcd/m² was 8.07 [%], and the CIE chromaticity coordinate (x, y) was (0.387, 0.453). The results are shown in Table 5.

### <Example D17> Fabrication and Evaluation of Light-Emitting Device D17

A light-emitting device D17 was fabricated in the same manner as in Example D1, except that a low molecular weight compound HM-1, compound MC4, compound G3, and compound R4 (low molecular weight compound HM-1/compound MC4/compound G3/compound R4= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D17. The EQE at 10 kcd/m² was 6.59 [%], and the CIE chromaticity coordinate (x, y) was (0.253, 0.480). The results are shown in Table 5. Further, the LT90 at 1000 cd/m² was 0.964 hours.

### <Comparative Example CD6> Fabrication and Evaluation of Light-Emitting Device CD6

A light-emitting device CD6 was fabricated in the same manner as in Example D1, except that a low molecular weight compound HM-1, compound MC4, compound G4, and compound R4 (low molecular weight compound HM-1/compound MC4/compound G4/compound R4= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device CD6. The EQE at 10 kcd/m² was 6.05 [%], and the CIE chromaticity coordinate (x, y) was (0.255, 0.477). The results are shown in Table 5. Further, the LT90 at 1000 cd/m² was 0.878 hours.

### <Example D18> Fabrication and Evaluation of Light-Emitting Device D18

A light-emitting device D18 was fabricated in the same manner as in Example D1, except that a low molecular weight compound HM-1, compound MC4, compound G3, and compound R3 (low molecular weight compound HM-1/compound MC4/compound G3/compound R3= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device D18. The EQE at 10 kcd/m² was 7.44 [%], and the CIE chromaticity coordinate (x, y) was (0.322, 0.437). The results are shown in Table 5.

### <Comparative Example CD7> Fabrication and Evaluation of Light-Emitting Device CD7

A light-emitting device CD7 was fabricated in the same manner as in Example D1, except that a low molecular weight compound HM-1, compound MC4, compound G4, and compound R3 (low molecular weight compound HM-1/compound MC4/compound G4/compound R3= 73.9% by mass/25% by mass/1% by mass/0.1% by mass) was used in place of a low molecular weight compound HM-1, compound MC1, and compound R1 (low molecular weight compound HM-1/compound MC1/compound R1=74% by mass/25% by mass/1% by mass) in the (Formation of Light-Emitting Layer) of Example D1.

EL emission was observed by applying a voltage to the light-emitting device CD7. The EQE at 10 kcd/m² was 5.58 [%], and the CIE chromaticity coordinate (x, y) was (0.344, 0.423). The results are shown in Table 5.

**[Table 5]**

| | Light-Emitting Device | Light-Emitting Layer | | EQE [%] | CIE Chromaticity Coordinate (x, y) |
|---|---|---|---|---|---|
| | | Composition | Composition Ratio (% by mass) | (10 kcd/m²) | (10 kcd/m²) |
| Example D12 | D12 | HM-1/MC3/G6/R2 | 73.9/25/1/0.1 | 8.46 | (0.393, 0.448) |
| Example D13 | D13 | HM-1/MC4/G1/R5 | 73.9/25/1/0.1 | 9.35 | (0.307, 0.494) |
| Example D14 | D14 | HM-1/MC3/G3/R2 | 73.9/25/1/0.1 | 7.48 | (0.282, 0.484) |
| Example D15 | D15 | HM-1/MC4/G3/R2 | 73.9/25/1/0.1 | 8.59 | (0.275, 0.461) |
| Example D16 | D16 | HM-1/MC4/G3/R6 | 73.9/25/1/0.1 | 8.07 | (0.387, 0.453) |
| Example D17 | D17 | HM-1/MC4/G3/R4 | 73.9/25/1/0.1 | 6.59 | (0.253, 0.480) |
| Comparative Example CD6 | CD6 | HM-1/MC4/G4/R4 | 73.9/25/1/0.1 | 6.05 | (0.255, 0.477) |
| Example D18 | D18 | HM-1/MC4/G3/R3 | 73.9/25/1/0.1 | 7.44 | (0.322, 0.437) |
| Comparative Example CD7 | CD7 | HM-1/MC4/G4/R3 | 73.9/25/1/0.1 | 5.58 | (0.344, 0.423) |

### Industrial Applicability

According to the present invention, a composition that is useful in fabricating a light-emitting device which shows excellent external quantum efficiency can be provided. Further, according to the present invention, a light-emitting device comprising such composition can be provided.

## Claims

1. A composition, comprising:
a phosphorescent compound represented by formula (1); and
a phosphorescent compound represented by formula (2): 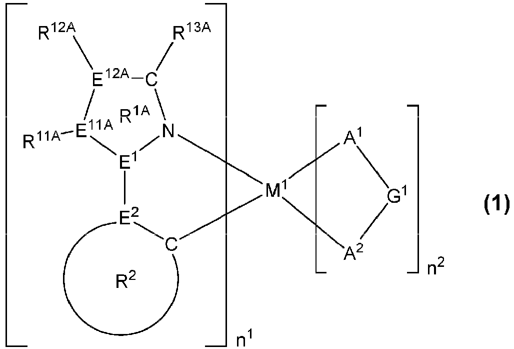 wherein
M¹ represents a rhodium atom, a palladium atom, an iridium atom or a platinum atom,
n¹ denotes an integer of 1 or more, n² denotes an integer of 0 or more, and n¹ + n² is 2 or 3,
when M¹ is a rhodium atom or an iridium atom, n¹ + n² is 3, and when M¹ is a palladium atom or a platinum atom, n¹ + n² is 2,
ring R^{1A} represents a triazole ring or a diazole ring constituted of a nitrogen atom, E¹, E^{11A}, E^{12A}, and a carbon atom,
ring R² represents an aromatic hydrocarbon ring or an aromatic heterocyclic ring, and these rings each may have a substituent; when there are a plurality of such substituents, those substituents may be the same or different and may be bonded to each other to form a ring together with the atoms to which they are bonded; and when there are a plurality of rings R², those rings may be the same or different,
E¹, E², E^{11A}, and E^{12A} each independently represent a nitrogen atom or a carbon atom; when there are a plurality of E¹, E², E^{11A} and E^{12A}, they may be the same or different at each occurrence; provided that at least one of E¹ and E² is a carbon atom,
R^{11A} and R^{12A} each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent; when there are a plurality of R^{11A} and R^{12A}, they may be the same or different at each occurrence; R^{11A} and R^{12A} may be bonded to each other to form a ring together with the atoms to which they are bonded; and R^{11A} and an optional substituent of the ring R² are not bonded to each other to form a ring together with the atoms to which they are bonded,
when E^{11A} is a nitrogen atom, R^{11A} may be present or absent, and when E^{12A} is a nitrogen atom, R^{12A} may be present or absent,
R^{13A} represents an aryl group, a monovalent heterocyclic group, or a substituted amino group, and these groups each may have a substituent; when there are a plurality of R^{13A}, they may be the same or different; and R^{12A} and R^{13A} may be bonded to each other to form a ring together with the atoms to which they are bonded, and
A¹-G¹-A² represents an anionic bidentate ligand, A¹ and A² each independently represent a carbon atom, an oxygen atom or a nitrogen atom, and these atoms may be atoms constituting a ring; G¹ represents a single bond or an atomic group constituting the bidentate ligand together with A¹ and A²; and when there are a plurality of A¹-G¹-A², they may be the same or different; 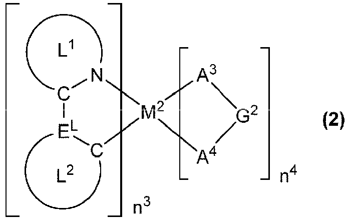
wherein
M² represents a rhodium atom, a palladium atom, an iridium atom or a platinum atom,
n³ denotes an integer of 1 or more, n⁴ denotes an integer of 0 or more, and n³ + n⁴ is 2 or 3; when M² is a rhodium atom or an iridium atom, n³ + n⁴ is 3; and when M² is a palladium atom or a platinum atom, n³ + n⁴ is 2,
E^{L} represents a carbon atom or a nitrogen atom,
ring L¹ represents a 6-membered aromatic heterocyclic ring, which may have a substituent; when there are a plurality of such substituents, they may be the same or different and may be bonded to each other to form a ring together with the atoms to which they are bonded; and when there are a plurality of rings L¹, they may be the same or different,
ring L² represents an aromatic hydrocarbon ring or an aromatic heterocyclic ring, and these rings each may have a substituent; when there are a plurality of such substituents, they may be the same or different and may be bonded to each other to form a ring together with the atoms to which they are bonded; and when there are a plurality of rings L², they may be the same or different,
an optional substituent of the ring L¹ and an optional substituent of the ring L² may combine with each other to form a ring together with the atoms to which they are bonded,
provided that at least one ring selected from the group consisting of ring L¹ and ring L² has at least one group represented by formula (1-T); and when there are a plurality of groups represented by formula (1-T), they may be the same or different,
A³-G²-A⁴ represents an anionic bidentate ligand, A³ and A⁴ each independently represent a carbon atom, an oxygen atom or a nitrogen atom, and these atoms may be atoms constituting a ring; G² represents a single bond or an atomic group constituting the bidentate ligand together with A³ and A⁴; and when there are a plurality of A³-G²-A⁴, they may be the same or different;
-R^{1T} **(1-T)**
wherein
R^{1T} represents an alkyl group, a cycloalkyl group, an alkoxy group, a cycloalkoxy group, an aryloxy group, a halogen atom, an aryl group, a monovalent heterocyclic group, or a substituted amino group, and these groups each may have a substituent.

2. The composition according to claim 1, wherein the phosphorescent compound represented by formula (2) is a phosphorescent compound represented by formula (2-B): 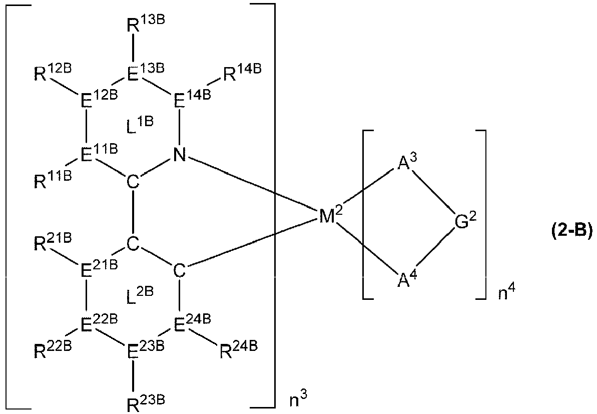 wherein
M², n³, n⁴, and A³-G²-A⁴ have the same meaning as described above,
E^{11B}, E^{12B}, E^{13B}, E^{14B}, E^{21B}, E^{22B}, E^{23B}, and E^{24B} each independently represent a nitrogen atom or a carbon atom; when there are a plurality of E^{11B}, E^{12B}, E^{13B}, E^{14B}, E^{21B}, E^{22B}, E^{23B}, and E^{24B}, they may be the same or different at each occurrence; when E^{11B} is a nitrogen atom, R^{11B} is absent; when E^{12B} is a nitrogen atom, R^{12B} is absent, when E^{13B} is a nitrogen atom, R^{13B} is absent; when E^{14B} is a nitrogen atom, R^{14B} is absent; when E^{21B} is a nitrogen atom, R^{21B} is absent; when E^{22B} is a nitrogen atom, R^{22B} is absent; when E^{23B} is a nitrogen atom, R^{23B} is absent; and when E^{24B} is a nitrogen atom, R^{24B} is absent,
R^{11B}, R^{12B}, R^{13B}, R^{14B}, R^{21B}, R^{22B}, R^{23B} , and R^{24B} each independently represent a hydrogen atom or a group represented by formula (1-T); when there are a plurality of R^{11B}, R^{12B}, R^{13B}, R^{14B}, R^{21B}, R^{22B}, R^{23B}, and R^{24B}, they may be the same or different at each occurrence; and R^{11B} and R^{12B}, R^{12B} and R^{13B}, R^{13B} and R^{14B}, R^{11B} and R^{21B}, R^{21B} and R^{22B}, R^{22B} and R^{23B}, and R^{23B} and R^{24B} each may be bonded to each other to form a ring together with the atoms to which they are bonded, provided that at least one selected from the group consisting of R^{11B}, R^{12B}, R^{13B}, R^{14B}, R^{21B}, R^{22B}, R^{23B}, and R^{24B} is a group represented by formula (1-T),
ring L^{1B} represents a pyridine ring or a pyrimidine ring constituted of a nitrogen atom, a carbon atom, E^{11B}, E^{12B}, E^{13B}, and E^{14B}, and
ring L^{2B} represents a benzene ring, a pyridine ring, or a pyrimidine ring constituted of two carbon atoms, E^{21B}, E^{22B}, E^{23B}, and E^{24B}.

3. The composition according to claim 2, wherein the phosphorescent compound represented by formula (2-B) is a phosphorescent compound represented by formula (2-B1), a phosphorescent compound represented by formula (2-B2), a phosphorescent compound represented by formula (2-B3), a phosphorescent compound represented by formula (2-B4), or a phosphorescent compound represented by formula (2-B5): 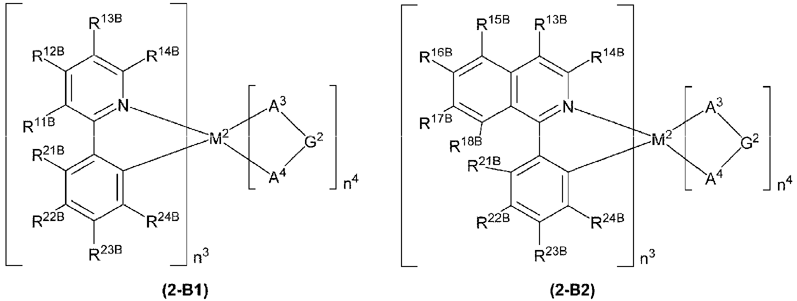 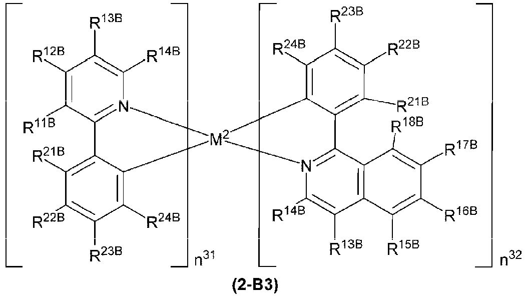 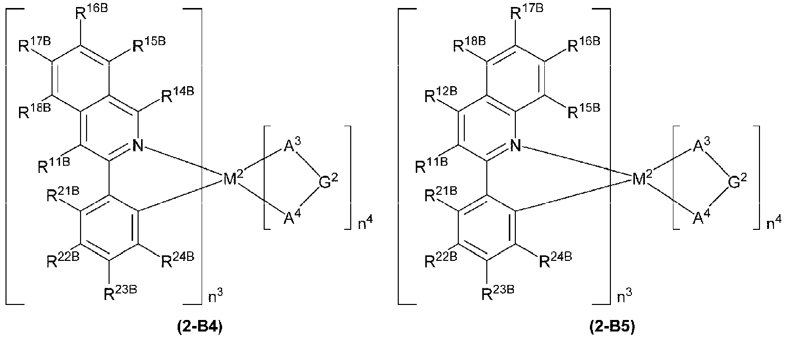 wherein
M², n³, n⁴, R^{11B}, R^{12B}, R^{13B}, R^{14B}, R^{21B}, R^{22B}, R^{23B}, R^{24B}, and A³-G²-A⁴ have the same meanings as described above,
n³¹ and n³² each independently denote an integer of 1 or more, and n³¹ + n³² is 2 or 3; when M² is a rhodium atom or an iridium atom, n³¹ + n³² is 3; and when M² is a palladium atom or a platinum atom, n³¹ + n³² is 2, and
R^{15B}, R^{16B}, R^{17B}, and R^{18B} each independently represent a hydrogen atom or a group represented by formula (1-T); when there are a plurality of R^{15B}, R^{16B}, R^{17B}, and R^{18B}, they may be the same or different at each occurrence; R^{15B} and R^{16B}, R^{16B} and R^{17B} and R^{17B} and R^{18B} each may be bonded to each other to form a ring together with the atoms to which they are bonded,
provided that, in formulas (2-B1) and (2-B3), at least one selected from the group consisting of R^{11B}, R^{12B}, R^{13B}, R^{14B}, R^{21B}, R^{22B}, R^{23B}, and R^{24B} is a group represented by formula (1-T); in formula (2-B2), at least one selected from the group consisting of R^{13B}, R^{14B}, R^{21B}, R^{22B}, R^{23B}, and R^{24B} is a group represented by formula (1-T); in formula (2-B4), at least one selected from the group consisting of R^{11B}, R^{14B}, R^{21B}, R^{22B}, R^{23B}, and R^{24B} is a group represented by formula (1-T); and in formula (2-B5), at least one selected from the group consisting of R^{11B}, R^{12B}, R^{21B}, R^{22B}, R^{23B}, and R^{24B} is a group represented by formula (1-T).

4. The composition according to any one of claims 1 to 3, wherein R^{1T} is an alkyl group, a cycloalkyl group, a group represented by formula (D-A), a group represented by formula (D-B), or a group represented by formula (D-C): 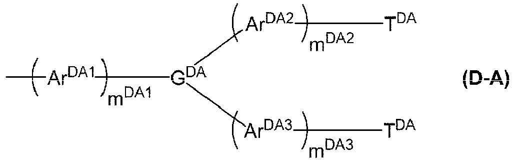 wherein
m^{DA1}, m^{DA2}, and m^{DA3} each independently denote an integer of 0 or more,
G^{DA} represents a nitrogen atom, an aromatic hydrocarbon group, or a heterocyclic group, and these groups each may have a substituent,
Ar^{DA1}, Ar^{DA2}, and Ar^{DA3} each independently represent an arylene group or a divalent heterocyclic group, and these groups each may have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups each may have a substituent; and the plurality of T^{DA} may be the same or different; 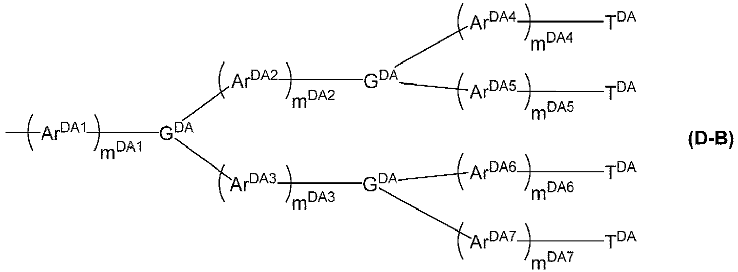
wherein
m^{DA1}, m^{DA2}, m^{DA3}, m^{DA4}, m^{DA5}, m^{DA6}, and m^{DA7} each independently denote an integer of 0 or more,
G^{DA} represents a nitrogen atom, an aromatic hydrocarbon group, or a heterocyclic group, and these groups each may have a substituent; and the plurality of G^{DA} may be the same or different,
Ar^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups each may have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups each may have a substituent; and the plurality of T^{DA} may be the same or different; 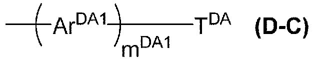
wherein
m^{DA1} denotes an integer of 0 or more,
Ar^{DA1} represents an arylene group or a divalent heterocyclic group, and these groups each may have a substituent; and when there are a plurality of Ar^{DA1}, they may be the same or different, and
T^{DA} represents an aryl group or a monovalent heterocyclic group, and these groups each may have a substituent.

5. The composition according to claim 4,
wherein R^{1T} is a group represented by formula (D-A), and
wherein the group represented by formula (D-A) is a group represented by formula (D-A1), a group represented by formula (D-A2), a group represented by formula (D-A3), or a group represented by formula (D-A4): 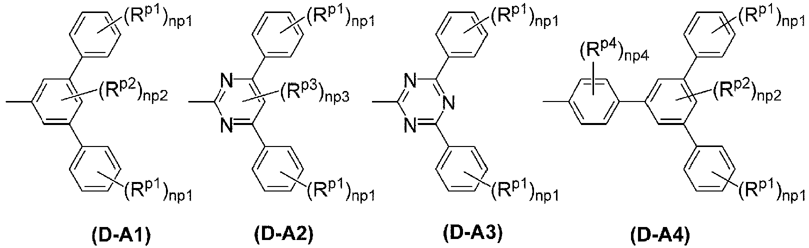 wherein
R^{p1}, R^{p2}, R^{p3}, and R^{p4} each independently represent an alkyl group, a cycloalkyl group, an alkoxy group, a cycloalkoxy group, or a halogen atom; and when there are a plurality of R^{p1}, R^{p2}, and R^{p4}, they may be the same or different at each occurrence, and
np1 denotes an integer of 0 to 5, np2 denotes an integer of 0 to 3, np3 represents 0 or 1, and np4 denotes an integer of 0 to 4; and the plurality of np1 may be the same or different.

6. The composition according to claim 4,
wherein R^{1T} is a group represented by formula (D-B), and
wherein the group represented by formula (D-B) is a group represented by formula (D-B1), a group represented by formula (D-B2), or a group represented by formula (D-B3): 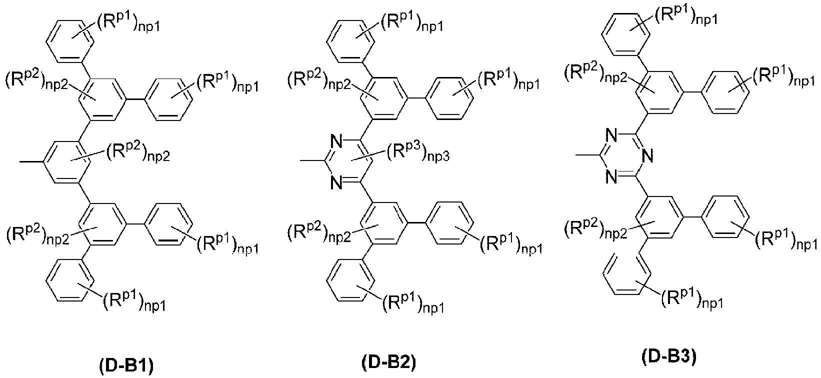 wherein
R^{p1}, R^{p2}, and R^{p3} each independently represent an alkyl group, a cycloalkyl group, an alkoxy group, a cycloalkoxy group, or a halogen atom; and when there are a plurality of R^{p1} and R^{p2}, they may be the same or different at each occurrence, and
np1 denotes an integer of 0 to 5, np2 denotes an integer of 0 to 3, and np3 represents 0 or 1; and when there are a plurality of np1 and np2, they may be the same or different at each occurrence.

7. The composition according to claim 4,
wherein R^{1T} is a group represented by formula (D-C), and
wherein the group represented by formula (D-C) is a group represented by formula (D-C1), a group represented by formula (D-C2), a group represented by formula (D-C3), or a group represented by formula (D-C4): 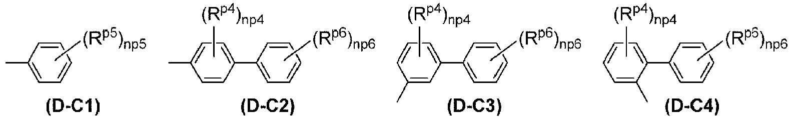 wherein
R^{p4}, R^{p5}, and R^{p6} each independently represent an alkyl group, a cycloalkyl group, an alkoxy group, a cycloalkoxy group, or a halogen atom; and when there are a plurality of R^{p4}, R^{p5}, and R^{p6}, they may be the same or different at each occurrence, and
np4 denotes an integer of 0 to 4, np5 denotes an integer of 0 to 5, and np6 denotes an integer of 0 to 5.

8. The composition according to any one of claims 1 to 7, wherein the phosphorescent compound represented by formula (1) is a phosphorescent compound represented by formula (1-A): 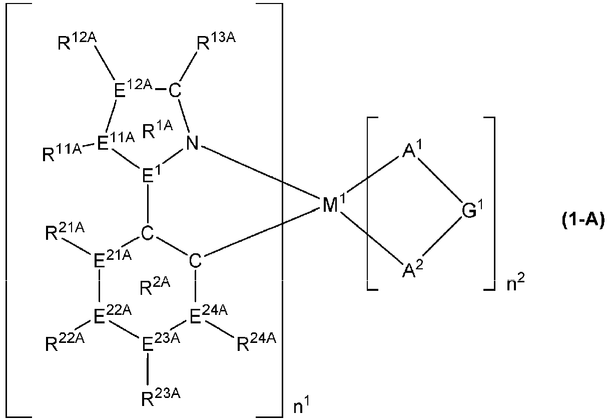 wherein
M¹, n¹, n², ring R^{1A}, E¹, E^{11A}, E^{12A}, R^{11A}, R^{12A}, R^{13A}, and A¹-G¹-A² have the same meanings as described above,
ring R^{2A} represents a benzene ring, a pyridine ring, or a pyrimidine ring constituted of two carbon atoms, E^{21A}, E^{22A}, E^{23A}, and E^{24A},
E^{21A}, E^{22A}, E^{23A}, and E^{24A} each independently represent a nitrogen atom or a carbon atom; when there are a plurality of E^{21A}, E^{22A}, E^{23A}, and E^{24A}, they may be the same or different at each occurrence; when E^{21A} is a nitrogen atom, R^{21A} is absent; when E^{22A} is a nitrogen atom, R^{22A} is absent; when E^{23A} is a nitrogen atom, R^{23A} is absent; and when E^{24A} is a nitrogen atom, R^{24A} is absent, and
R^{21A}, R^{22A}, R^{23A}, and R^{24A} each represent a hydrogen atom, an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent; when there are a plurality of R^{21A}, R^{22A}, R^{23A}, and R^{24A}, they may be the same or different at each occurrence; R^{21A} and R^{22A} may be bonded to each other to form a ring together with the atoms to which they are bonded; R^{22A} and R^{23A} may be bonded to each other to form a ring together with the atoms to which they are bonded; R^{23A} and R^{24A} may be bonded to each other to form a ring together with the atoms to which they are bonded; and R^{11A} and R^{21A} are not bonded to each other to form a ring together with the atoms to which they are bonded.

9. The composition according to claim 8, wherein the phosphorescent compound represented by formula (1-A) is a phosphorescent compound represented by formula (1-A1), a phosphorescent compound represented by formula (1-A2), a phosphorescent compound represented by formula (1-A3), or a phosphorescent compound represented by formula (1-A4): 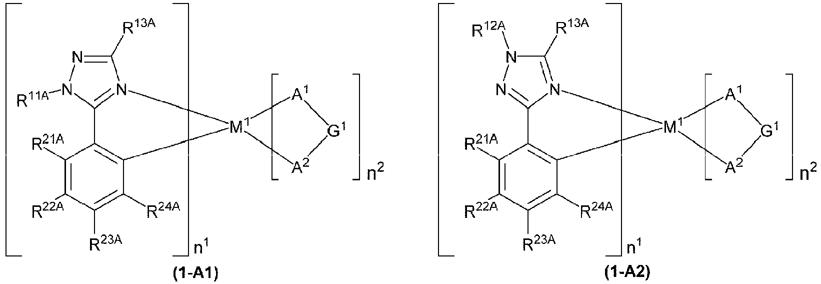 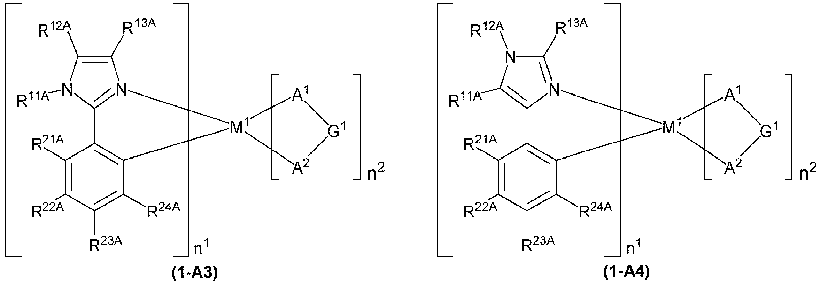 wherein M¹, n¹, n², R^{11A}, R^{12A}, R^{13A}, R^{21A}, R^{22A}, R^{23A}, R^{24A}, and A¹-G¹-A² have the same meanings as described above.

10. The composition according to any one of claims 1 to 9, wherein R^{13A} is an aryl group which may have a substituent.

11. The composition according to any one of claims 1 to 10, wherein the composition comprises two or more phosphorescent compounds represented by formula (2).

12. The composition according to any one of claims 1 to 11,
wherein the maximum peak wavelength of the emission spectrum of the phosphorescent compound represented by formula (1) is 380 nm or more and less than 495 nm, and
wherein the maximum peak wavelength of the emission spectrum of the phosphorescent compound represented by formula (2) is 495 nm or more and less than 750 nm.

13. The composition according to any one of claims 1 to 12, further comprising a compound represented by formula (H-1): 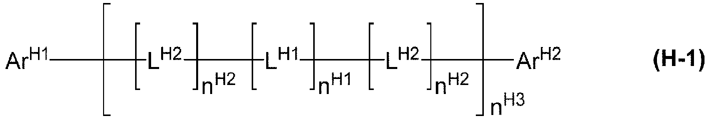 wherein,
Ar^{H1} and Ar^{H2} each independently represent an aryl group or a monovalent heterocyclic group, and these groups each may have a substituent,
n^{H1} and n^{H2} each independently denote 0 or 1; when there are a plurality of n^{H1}, they may be the same or different; and the plurality of n^{H2} may be the same or different,
n^{H3} denotes an integer of 0 or more,
L^{H1} represents an arylene group, a divalent heterocyclic group, or a group represented by -[C(R^{H11})₂]n^{H11}-, and these groups each may have a substituent; when there are a plurality of L^{H1}, they may be the same or different,
n^{H11} denotes an integer of 1 or more and 10 or less; R^{H11} represents a hydrogen atom, an alkyl group, a cycloalkyl group, an alkoxy group, a cycloalkoxy group, an aryl group, or a monovalent heterocyclic group, and these groups each may have a substituent; and the plurality of R^{H11} may be the same or different and may be bonded to each other to form a ring together with the carbon atom to which they are bonded,
L^{H2} represents a group represented by -N(-L^{H21}-R^{H21})-; when there are a plurality of L^{H2}, they may be the same or different, and
L^{H21} represents a single bond, an arylene group, or a divalent heterocyclic group, and these groups each may have a substituent; R^{H21} represents a hydrogen atom, an alkyl group, a cycloalkyl group, an aryl group, or a monovalent heterocyclic group, and these groups each may have a substituent.

14. The composition according to any one of claims 1 to 13, further comprising at least one material selected from the group consisting of a hole transporting material, a hole injecting material, an electron transporting material, an electron injecting material, a light emitting material, an antioxidant, and a solvent.

15. A light-emitting device, comprising:
an anode;
a cathode; and
a layer provided between the anode and the cathode, and comprising the composition according to any one of claims 1 to 14.

## Patentansprüche

1. Zusammensetzung, umfassend:
eine phosphoreszierende Verbindung, dargestellt durch Formel (1); und
eine phosphoreszierende Verbindung, dargestellt durch Formel (2): 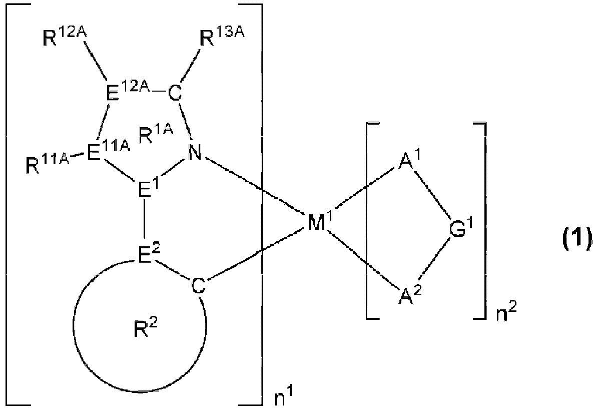 wobei
M₁ ein Rhodiumatom, ein Palladiumatom, ein Iridiumatom oder ein Platinatom darstellt,
n¹ eine ganze Zahl von 1 oder mehr bezeichnet, n² eine ganze Zahl von 0 oder mehr bezeichnet, und n¹ + n² 2 oder 3 ist,
wenn M¹ ein Rhodiumatom oder ein Iridiumatom ist, n¹ + n² gleich 3 ist, und
wenn M¹ ein Palladiumatom oder ein Platinatom ist, n¹ + n² gleich 2 ist,
Ring R^{1A} einen Triazolring oder einen Diazolring darstellt, bestehend aus einem Stickstoffatom, E¹, E^{11A}, E^{12A} und einem Kohlenstoffatom,
Ring R² einen aromatischen Kohlenwasserstoffring oder einen aromatischen heterocyclischen Ring darstellt, und diese Ringe jeweils einen Substituenten aufweisen können; wenn es eine Vielzahl solcher Substituenten gibt, können diese Substituenten gleich oder verschieden sein und können aneinander gebunden sein, um zusammen mit den Atomen, an die sie gebunden sind, einen Ring zu bilden; und wenn es eine Vielzahl von Ringen R² gibt, können diese Ringe gleich oder verschieden sein,
E¹, E², E^{11A} und E^{12A} jeweils unabhängig ein Stickstoffatom oder ein Kohlenstoffatom darstellen; wenn es eine Vielzahl von E¹, E², E^{11A} und E^{12A} gibt, können sie bei jedem Vorkommen gleich oder verschieden sein; vorausgesetzt, dass mindestens eines von E¹ und E² ein Kohlenstoffatom ist,
R^{11A} und R^{12A} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen, und diese Gruppen jeweils einen Substituenten aufweisen können; wenn es eine Vielzahl von R^{11A} und R^{12A} gibt, können sie bei jedem Vorkommen gleich oder verschieden sein; R^{11A} und R^{12A} können aneinander gebunden sein, um zusammen mit den Atomen, an die sie gebunden sind, einen Ring zu bilden; und R^{11A} und ein optionaler Substituent des Rings R² sind nicht aneinander gebunden, um zusammen mit den Atomen, an die sie gebunden sind, einen Ring zu bilden,
wenn E^{11A} ein Stickstoffatom ist, kann R^{11A} vorhanden oder nicht vorhanden sein, und wenn E^{12A} ein Stickstoffatom ist, kann R^{12A} vorhanden oder nicht vorhanden sein,
R^{13A} eine Arylgruppe, eine monovalente heterocyclische Gruppe oder eine substituierte Aminogruppe darstellt und diese Gruppen jeweils einen Substituenten aufweisen können; wenn es eine Vielzahl von R^{13A} gibt, können sie gleich oder verschieden sein; und R^{12A} und R^{13A} können aneinander gebunden sein, um zusammen mit den Atomen, an die sie gebunden sind, einen Ring zu bilden, und
A¹-G¹-A² einen anionischen zweizähnigen Liganden darstellt, A¹ und A² jeweils unabhängig ein Kohlenstoffatom, ein Sauerstoffatom oder ein Stickstoffatom darstellen, und diese Atome Atome sein können, die einen Ring bilden; G¹ eine Einfachbindung oder eine Atomgruppe darstellt, die zusammen mit A¹ und A² den zweizähnigen Liganden bildet; und wenn es eine Vielzahl von A¹-G¹-A² gibt, können diese gleich oder verschieden sein; 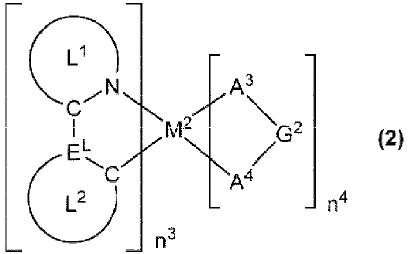
wobei
M² ein Rhodiumatom, ein Palladiumatom, ein Iridiumatom oder ein Platinatom darstellt,
n³ eine ganze Zahl von 1 oder mehr bezeichnet, n⁴ eine ganze Zahl von 0 oder mehr bezeichnet und n³ + n⁴ 2 oder 3 ist; wenn M² ein Rhodiumatom oder ein Iridiumatom ist, ist n³ + n⁴ 3; und wenn M² ein Palladiumatom oder ein Platinatom ist, ist n³ + n⁴ 2,
E^{L} ein Kohlenstoffatom oder ein Stickstoffatom darstellt,
Ring L¹ einen 6-gliedrigen aromatischen heterocyclischen Ring darstellt, der einen Substituenten aufweisen kann; wenn es eine Vielzahl solcher Substituenten gibt, können sie gleich oder verschieden sein und können aneinander gebunden sein, um zusammen mit den Atomen, an die sie gebunden sind, einen Ring zu bilden; und wenn es eine Vielzahl von Ringen L¹ gibt, können sie gleich oder verschieden sein,
Ring L² einen aromatischen Kohlenwasserstoffring oder einen aromatischen heterocyclischen Ring darstellt, und diese Ringe jeweils einen Substituenten aufweisen können; wenn es eine Vielzahl solcher Substituenten gibt, können sie gleich oder verschieden sein und können aneinander gebunden sein, um zusammen mit den Atomen, an die sie gebunden sind, einen Ring zu bilden; und wenn es eine Vielzahl von Ringen L² gibt, können sie gleich oder verschieden sein,
ein optionaler Substituent des Rings L¹ und ein optionaler Substituent des Rings L² sich miteinander verbinden können, um zusammen mit den Atomen, an die sie gebunden sind, einen Ring zu bilden,
vorausgesetzt, dass mindestens ein Ring, ausgewählt aus der Gruppe, bestehend aus Ring L¹ und Ring L², mindestens eine Gruppe aufweist, die durch Formel (1-T) dargestellt ist; und wenn es eine Vielzahl von Gruppen gibt, die durch Formel (1-T) dargestellt sind, können sie gleich oder verschieden sein,
A³-G²-A⁴ einen anionischen zweizähnigen Liganden darstellt, A³ und A⁴ jeweils unabhängig ein Kohlenstoffatom, ein Sauerstoffatom oder ein Stickstoffatom darstellen, und diese Atome Atome sein können, die einen Ring bilden; G² eine Einfachbindung oder eine Atomgruppe darstellt, die zusammen mit A³ und A⁴ den zweizähnigen Liganden bildet; und wenn es eine Vielzahl von A³-G²-A⁴ gibt, können diese gleich oder verschieden sein;
-R^{1T} (1-T)
wobei
R^{1T} eine Alkylgruppe, eine Cycloalkylgruppe, eine Alkoxygruppe, eine Cycloalkoxygruppe, eine Aryloxygruppe, ein Halogenatom, eine Arylgruppe, eine einwertige heterocyclische Gruppe oder eine substituierte Aminogruppe darstellt und diese Gruppen jeweils einen Substituenten aufweisen können.

2. Zusammensetzung nach Anspruch 1, wobei die durch Formel (2) dargestellte phosphoreszierende Verbindung eine durch Formel (2-B) dargestellte phosphoreszierende Verbindung ist: 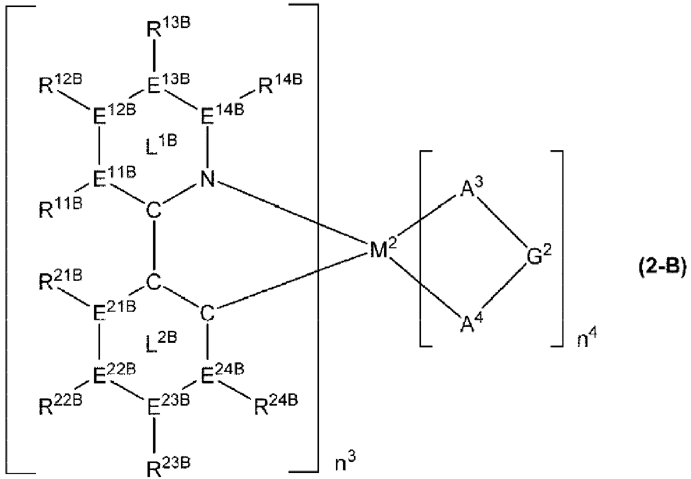 wobei
M², n³, n⁴, and A³-G²-A⁴ die gleiche Bedeutung haben, wie es oben beschrieben ist,
E^{11B}, E^{12B}, E^{13B}, E^{14B}, E^{21B}, E^{22B}, E^{23B} und E^{24B} jeweils unabhängig ein Stickstoffatom oder ein Kohlenstoffatom darstellen; wenn es eine Vielzahl von E^{11B}, E^{12B}, E^{13B}, E^{14B}, E^{21B}, E^{22B}, E^{23B} und E^{24B} gibt, können sie bei jedem Vorkommen gleich oder verschieden sein; wenn E^{11B} ein Stickstoffatom ist, fehlt R^{11B} nicht vorhanden; wenn E^{12B} ein Stickstoffatom ist, ist R^{12B} nicht vorhanden; wenn E^{13B} ein Stickstoffatom ist, ist R^{13B} nicht vorhanden; wenn E^{14B} ein Stickstoffatom ist, ist R^{14B} nicht vorhanden; wenn E^{21B} ein Stickstoffatom ist, ist R^{21B} nicht vorhanden; wenn E^{22B} ein Stickstoffatom ist, ist R^{22B} nicht vorhanden; wenn E^{23B} ein Stickstoffatom ist, ist R^{23B} nicht vorhanden; und wenn E^{24B} ein Stickstoffatom ist, ist R^{24B} nicht vorhanden,
R^{11B} , R^{12B}, R^{13B}, R^{14B}, R^{21B}, R^{22B}, R^{23B} und R^{24B} jeweils unabhängig voneinander ein Wasserstoffatom oder eine durch die Formel (1-T) dargestellte Gruppe darstellen; wenn es eine Vielzahl von R^{11B}, R^{12B}, R^{13B}, R^{14B}, R^{21B}, R^{22B}, R^{23B} und R^{24B} gibt, können sie bei jedem Vorkommen gleich oder verschieden sein; und R^{11B} und R^{12B}, R^{12B} und R^{13B}, R^{13B} und R^{14B}, R^{11B} und R^{21B}, R^{21B} und R^{22B}, R^{22B} und R^{23B} und R^{23B} und R^{23B} und R^{24B} können jeweils aneinander gebunden sein, um zusammen mit den Atomen, an die sie gebunden sind, einen Ring zu bilden, vorausgesetzt, dass mindestens eines, ausgewählt aus der Gruppe, bestehend aus R^{11B}, R^{12B}, R^{13B}, R^{14B}, R^{21B}, R^{22B}, R^{23B} und R^{24B}, eine durch Formel (1-T) dargestellte Gruppe ist,
Ring L^{1B} einen Pyridinring oder einen Pyrimidinring darstellt, der aus einem Stickstoffatom, einem Kohlenstoffatom, E^{11B}, E^{12B}, E^{13B} und E^{14B} besteht, und
Ring L^{2B} einen Benzolring, einen Pyridinring oder einen Pyrimidinring bestehend aus zwei Kohlenstoffatomen E^{21B} , E^{22B} , E^{23B} und E^{24B} darstellt.

3. Zusammensetzung nach Anspruch 2, wobei die durch Formel (2-B) dargestellte phosphoreszierende Verbindung eine durch Formel (2-B1) dargestellte phosphoreszierende Verbindung, eine durch Formel (2-B2) dargestellte phosphoreszierende Verbindung, eine durch Formel (2-B3) dargestellte phosphoreszierende Verbindung, eine durch Formel (2-B4) dargestellte phosphoreszierende Verbindung oder eine durch Formel (2-B5) dargestellte phosphoreszierende Verbindung ist: 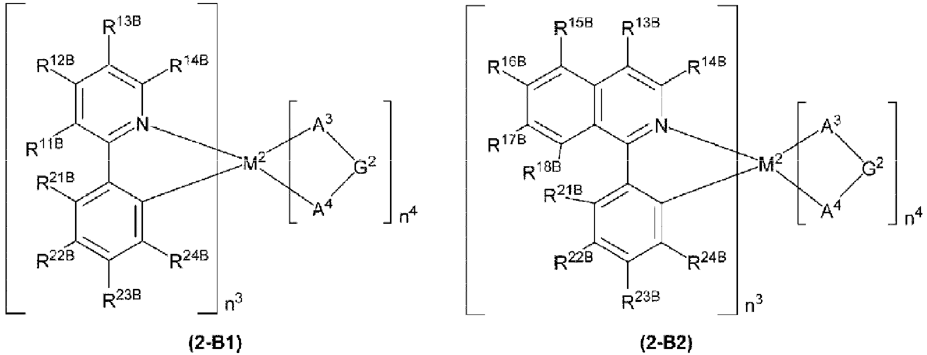 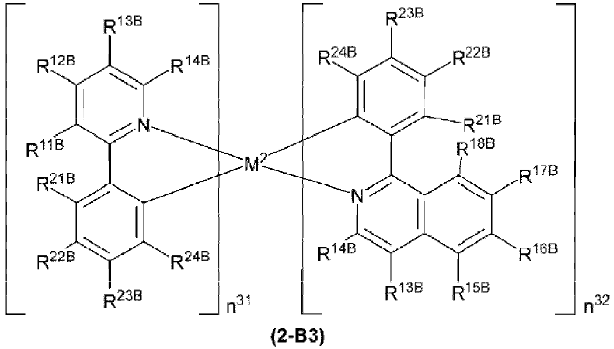 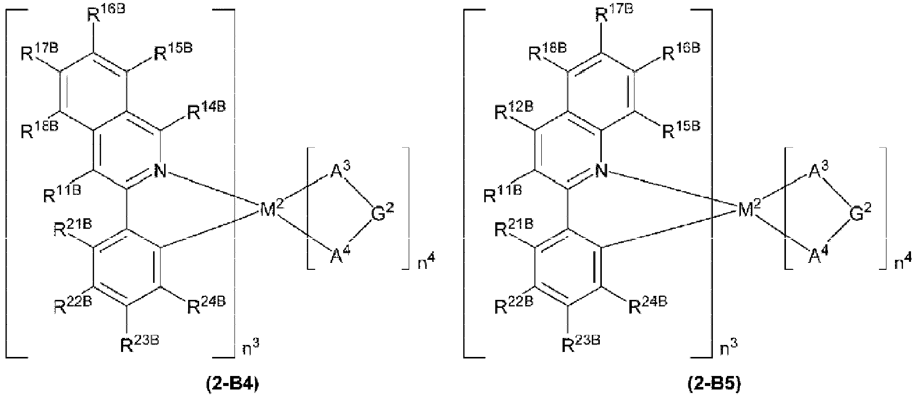 wobei
M², n³, n⁴, and R^{11B}, R^{12B}, R^{13B}, R^{14B}, R^{21B}, R^{22B}, R^{23B}, and R^{24B} und A³-G²-A⁴ die gleichen Bedeutungen haben, wie es oben beschrieben ist,
n³¹ und n³² jeweils unabhängig eine ganze Zahl von 1 oder mehr bezeichnen, und n³¹ + n³² 2 oder 3 ist; wenn M² ein Rhodiumatom oder ein Iridiumatom ist, ist n³¹ + n³² gleich 3; und wenn M² ein Palladiumatom oder ein Platinatom ist, ist n³¹ + n³² gleich 2, und
R^{15B}, R^{16B}, R^{17B} und R^{18B} jeweils unabhängig ein Wasserstoffatom oder eine durch Formel (1-T) dargestellte Gruppe darstellen; wenn es eine Vielzahl von R^{15B}, R^{16B}, R^{17B} und R^{18B} gibt, können sie bei jedem Vorkommen gleich oder verschieden sein; R^{15B} und R^{16B}, R^{16B} und R^{17B}, R^{17B} und R^{18B} können jeweils aneinander gebunden sein, um zusammen mit den Atomen, an die sie gebunden sind, einen Ring zu bilden,
vorausgesetzt, dass in den Formeln (2-B1) und (2-B3) mindestens eines, ausgewählt aus der Gruppe, bestehend aus R^{11B}, R^{12B}, R^{13B}, R^{14B}, R^{21B}, R^{22B}, R^{23B} und R^{24B}, eine durch Formel (1-T) dargestellte Gruppe ist; in Formel (2-B2) mindestens eines, ausgewählt aus der Gruppe, bestehend aus R^{13B}, R^{14B}, R^{21B}, R^{22B}, R^{23B} und R^{24B}, eine durch die Formel (1-T) dargestellte Gruppe ist; in Formel (2-B4) mindestens eines, ausgewählt aus der Gruppe, bestehend aus R^{11B}, R^{14B}, R^{21B}, R^{22B}, R^{23B} und R^{24B}, eine durch die Formel (1-T) dargestellte Gruppe ist; und in Formel (2-B5) mindestens eines, ausgewählt aus der Gruppe, bestehend aus R^{11B}, R^{12B}, R^{21B}, R^{22B}, R^{23B} und R^{24B}, eine durch die Formel (1-T) dargestellte Gruppe ist.

4. Zusammensetzung nach einem der Ansprüche 1 bis 3, wobei R^{1T} eine Alkylgruppe, eine Cycloalkylgruppe, eine durch Formel (D-A) dargestellte Gruppe, eine durch Formel (D-B) dargestellte Gruppe oder eine durch Formel (D-C) dargestellte Gruppe ist: 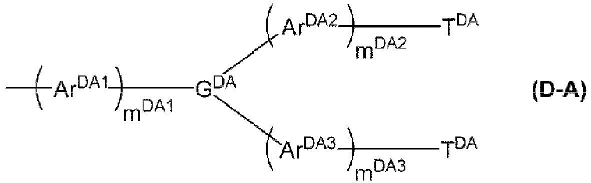 wobei
m^{Da1}, m^{DA2} und m^{DA3} jeweils unabhängig eine ganze Zahl von 0 oder mehr bezeichnen,
G^{DA} ein Stickstoffatom, eine aromatische Kohlenwasserstoffgruppe oder eine heterocyclische Gruppe darstellt, und diese Gruppen jeweils einen Substituenten aufweisen können,
Ar^{DA1}, Ar^{DA2} und Ar^{DA3} jeweils unabhängig eine Arylengruppe oder eine zweiwertige heterozyklische Gruppe darstellen, und diese Gruppen jeweils einen Substituenten aufweisen können; und wenn es eine Vielzahl von Ar^{DA1}, Ar^{DA2}, and Ar^{DA3} gibt, können sie bei jedem Vorkommen gleich oder verschieden sein, und
T^{DA} eine Arylgruppe oder eine monovalente heterocyclische Gruppe darstellt, und diese Gruppen jeweils einen Substituenten aufweisen können; und die Vielzahl von T^{DA} kann gleich oder verschieden sein; 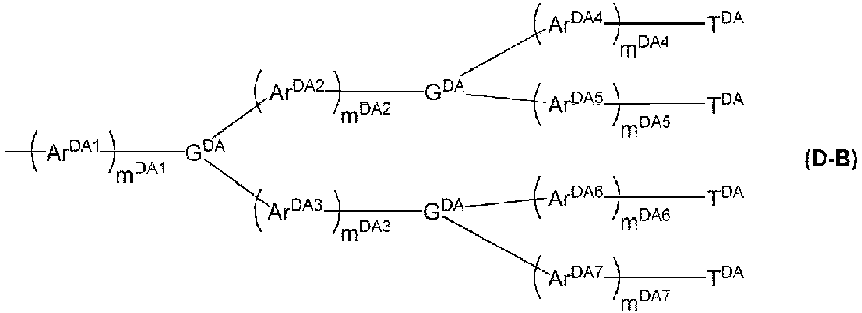
wobei
m^{DA1}, m^{DA2}, m^{DA3}, m^{DA4}, m^{DA5}, m^{DA6} und m^{DA7} jeweils unabhängig eine ganze Zahl von 0 oder mehr bezeichnen,
G^{DA} ein Stickstoffatom, eine aromatische Kohlenwasserstoffgruppe oder eine heterocyclische Gruppe darstellt, und diese Gruppen jeweils einen Substituenten aufweisen können; und die Vielzahl der G^{DA} kann gleich oder verschieden sein,
Ar^{DA1}, Ar^{DA2}, Ar^{DA3}, Ar^{DA4}, Ar^{DA5}, Ar^{DA6} und Ar^{DA7} jeweils unabhängig eine Arylengruppe oder eine zweiwertige heterozyklische Gruppe darstellen, und diese Gruppen jeweils einen Substituenten aufweisen können; und wenn es eine Vielzahl von Ar^{DA1}, Ar^{DA2}, Ar^{DA3}, Ar^{DA4}, Ar^{DA5}, Ar^{DA6} und Ar^{DA7} gibt, können sie bei jedem Vorkommen gleich oder verschieden sein, und
T^{DA} eine Arylgruppe oder eine monovalente heterocyclische Gruppe darstellt, und diese Gruppen jeweils einen Substituenten aufweisen können; und die Vielzahl von T^{DA} kann gleich oder verschieden sein; 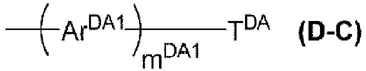
wobei
m^{DA1} eine ganze Zahl von 0 oder mehr bezeichnet,
Ar^{DA1} eine Arylengruppe oder eine zweiwertige heterocyclische Gruppe darstellt, und diese Gruppen jeweils einen Substituenten aufweisen können; und wenn es eine Vielzahl von Ar^{DA1} gibt, können sie gleich oder verschieden sein, und
T^{DA} eine Arylgruppe oder eine monovalente heterocyclische Gruppe darstellt, und diese Gruppen jeweils einen Substituenten aufweisen können.

5. Zusammensetzung nach Anspruch 4,
wobei R^{1T} eine durch Formel (D-A) dargestellte Gruppe ist, und
wobei die durch Formel (D-A) dargestellte Gruppe eine durch Formel (D-A1) dargestellte Gruppe, eine durch Formel (D-A2) dargestellte Gruppe, eine durch Formel (D-A3) dargestellte Gruppe oder eine durch Formel (D-A4) dargestellte Gruppe ist: 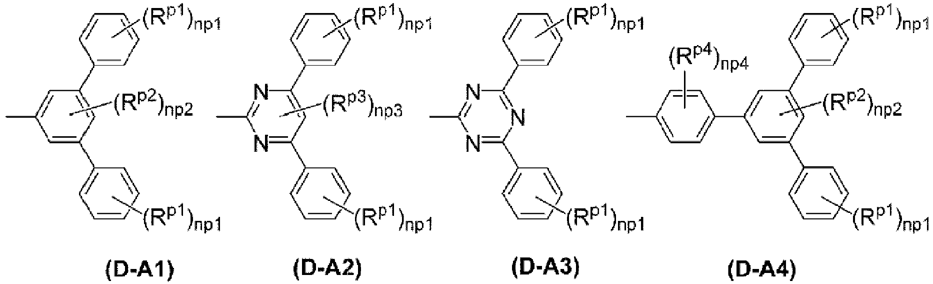 wobei
R^{p1}, R^{p2} , R^{p3} und R^{p4} jeweils unabhängig eine Alkylgruppe, eine Cycloalkylgruppe, eine Alkoxygruppe, eine Cycloalkoxygruppe oder ein Halogenatom darstellen; und wenn es eine Vielzahl von R^{p1}, R^{p2} und R^{p4} gibt, können sie bei j edem Vorkommen gleich oder verschieden sein, und
np1 eine ganze Zahl von 0 bis 5 bezeichnet, np2 eine ganze Zahl von 0 bis 3 bezeichnet, np3 0 oder 1 darstellt, und np4 eine ganze Zahl von 0 bis 4 bezeichnet; und die Vielzahl von np1 kann gleich oder verschieden sein.

6. Zusammensetzung nach Anspruch 4,
wobei R^{1T} eine durch Formel (D-B) dargestellte Gruppe ist, und
wobei die durch Formel (D-B) dargestellte Gruppe eine durch Formel (D-B1) dargestellte Gruppe, eine durch Formel (D-B2) dargestellte Gruppe oder eine durch Formel (D-B3) dargestellte Gruppe ist: 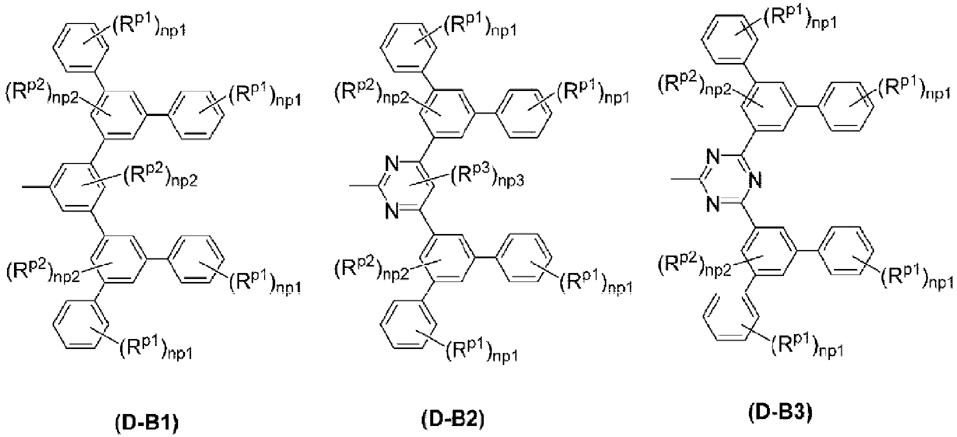 wobei
R^{p1}, R^{p2} und R^{p3} jeweils unabhängig eine Alkylgruppe, eine Cycloalkylgruppe, eine Alkoxygruppe, eine Cycloalkoxygruppe oder ein Halogenatom darstellen; und wenn es eine Vielzahl von R^{p1} und R^{p2} gibt, können sie bei jedem Vorkommen gleich oder verschieden sein, und
np1 eine ganze Zahl von 0 bis 5 bezeichnet, np2 eine ganze Zahl von 0 bis 3 bezeichnet, und np3 0 oder 1 darstellt; und wenn es eine Vielzahl von np1 und np2 gibt, können sie bei jedem Vorkommen gleich oder verschieden sein.

7. Zusammensetzung nach Anspruch 4,
wobei R^{1T} eine durch Formel (D-C) dargestellte Gruppe ist, und
wobei die durch die Formel (D-C) dargestellte Gruppe eine durch Formel (D-C1) dargestellte Gruppe, eine durch Formel (D-C2) dargestellte Gruppe, eine durch Formel (D-C3) dargestellte Gruppe oder eine durch Formel (D-C4) dargestellte Gruppe ist: 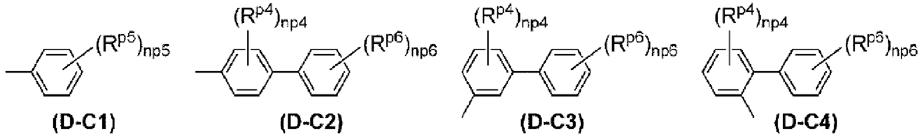 wobei
R^{p4}, R^{p5} und R^{p6} jeweils unabhängig eine Alkylgruppe, eine Cycloalkylgruppe, eine Alkoxygruppe, eine Cycloalkoxygruppe oder ein Halogenatom darstellen; und wenn es eine Vielzahl von R^{p4}, R^{p5} und R^{p6} gibt, können sie bei j edem Vorkommen gleich oder verschieden sein, und
np4 eine ganze Zahl von 0 bis 4 bezeichnet, np5 eine ganze Zahl von 0 bis 5 bezeichnet und np6 eine ganze Zahl von 0 bis 5 bezeichnet.

8. Zusammensetzung nach einem der Ansprüche 1 bis 7, wobei die durch Formel (1) dargestellte phosphoreszierende Verbindung eine durch Formel (1-A) dargestellte phosphoreszierende Verbindung ist: 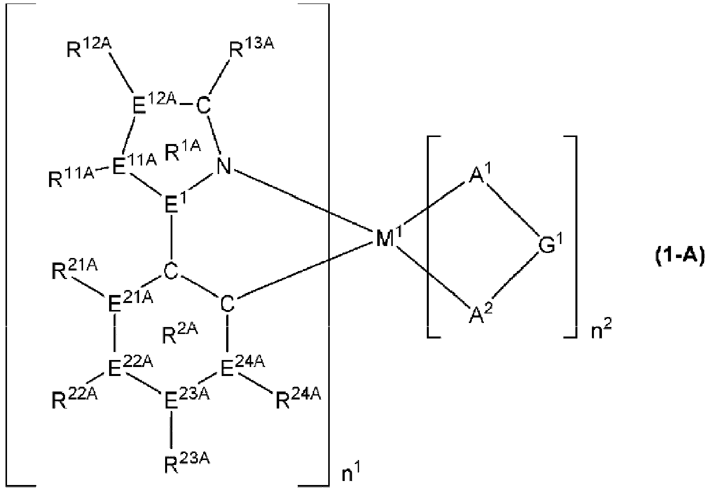 wobei
M¹, n¹, n², Ring R^{1A}, E¹, E^{11A}, E^{12A}, R^{11A}, R^{12A}, R^{13A} and A¹-G¹-A² die gleichen Bedeutungen haben, wie es oben beschrieben ist,
Ring R^{A2} einen Benzolring, einen Pyridinring oder einen Pyrimidinring bestehend aus zwei Kohlenstoffatomen E^{21A}, E^{22A}, E^{23A} und E^{24A} darstellt.
E^{21A}, E^{22A}, E^{23A} und E^{24A} jeweils unabhängig ein Stickstoffatom oder ein Kohlenstoffatom darstellen; wenn es mehrere E^{21A}, E^{22A}, E^{23A} und E^{24A} gibt, können sie bei jedem Vorkommen gleich oder verschieden sein; wenn E^{21A} ein Stickstoffatom ist, ist R^{21A} nicht vorhanden; wenn E^{22A} ein Stickstoffatom ist, ist R^{22A} nicht vorhanden; wenn E^{23A} ein Stickstoffatom ist, ist R^{23A} nicht vorhanden; und wenn E^{24A} ein Stickstoffatom ist, ist R^{24A} nicht vorhanden, und
R^{21A}, R^{22A}, R^{23A} und R^{24A} jeweils ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen, und diese Gruppen jeweils einen Substituenten aufweisen können; wenn es eine Vielzahl von R^{21A}, R^{22A}, R^{23A} und R^{24A} gibt, können sie bei jedem Vorkommen gleich oder verschieden sein; R^{21A} und R^{22A} können aneinander gebunden sein, um zusammen mit den Atomen, an die sie gebunden sind, einen Ring zu bilden; R^{22A} und R^{23A} können aneinander gebunden sein, um zusammen mit den Atomen, an die sie gebunden sind, einen Ring zu bilden; R^{23A} und R^{24A} können aneinander gebunden sein, um zusammen mit den Atomen, an die sie gebunden sind, einen Ring zu bilden; und R^{11A} und R^{21A} sind nicht aneinander gebunden, um zusammen mit den Atomen, an die sie gebunden sind, einen Ring zu bilden.

9. Zusammensetzung nach Anspruch 8, wobei die durch Formel (1-A) dargestellte phosphoreszierende Verbindung eine durch Formel (1-A1) dargestellte phosphoreszierende Verbindung, eine durch Formel (1-A2) dargestellte phosphoreszierende Verbindung, eine durch Formel (1-A3) dargestellte phosphoreszierende Verbindung oder eine durch Formel (1-A4) dargestellte phosphoreszierende Verbindung ist: 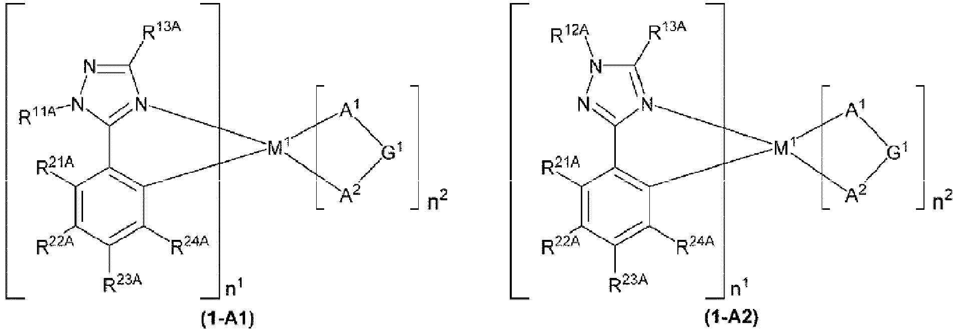 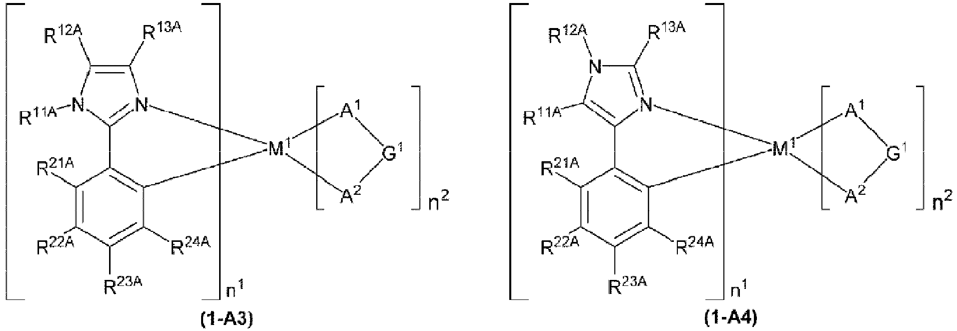 M¹, n¹, n², Ring R^{11A}, R^{12A}, R^{13A}, R^{21A}, R^{22A}, R^{23A}, R^{24A} und A¹-G¹-A² die gleichen Bedeutungen haben, wie es oben beschrieben ist.

10. Zusammensetzung nach einem der Ansprüche 1 bis 9, wobei R^{13A} eine Arylgruppe ist, die einen Substituenten aufweisen kann.

11. Zusammensetzung nach einem der Ansprüche 1 bis 10, wobei die Zusammensetzung zwei oder mehrere durch Formel (2) dargestellte phosphoreszierende Verbindungen umfasst.

12. Zusammensetzung nach einem der Ansprüche 1 bis 11,
wobei die maximale Peak-Wellenlänge des Emissionsspektrums der durch Formel (1) dargestellten phosphoreszierenden Verbindung 380 nm oder mehr und weniger als 495 nm ist, und
wobei die maximale Peak-Wellenlänge des Emissionsspektrums der durch Formel (2) dargestellten phosphoreszierenden Verbindung 495 nm oder mehr und weniger als 750 nm ist.

13. Zusammensetzung nach einem der Ansprüche 1 bis 12, ferner umfassend eine durch Formel (H-1) dargestellte Verbindung: 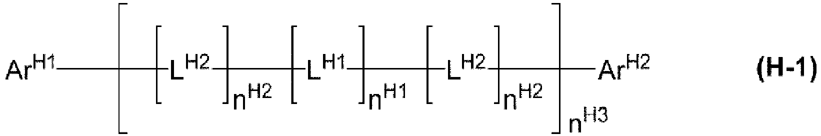 wobei
Ar^{H1} und Ar^{H2} jeweils unabhängig eine Arylgruppe oder eine monovalente heterozyklische Gruppe darstellen, und diese Gruppen jeweils einen Substituenten aufweisen können,
n^{H1} und n^{H2} jeweils unabhängig 0 oder 1 bezeichnen; wenn es eine Vielzahl von n^{H1} gibt, können sie gleich oder verschieden sein; und die Vielzahl von n^{H2} kann gleich oder verschieden sein,
n^{H3} eine ganze Zahl von 0 oder mehr bezeichnet,
L^{H1} eine Arylengruppe, eine zweiwertige heterocyclische Gruppe oder eine durch - [C(RH¹¹)₂]n^{H11}- dargestellte Gruppe darstellt, und diese Gruppen jeweils einen Substituenten aufweisen können; wenn es eine Vielzahl von L^{H1} gibt, können sie gleich oder verschieden sein,
n^{H11} eine ganze Zahl von 1 oder mehr und 10 oder weniger bezeichnet; R^{H11} ein Wasserstoffatom, eine Alkylgruppe, eine Cycloalkylgruppe, eine Alkoxygruppe, eine Cycloalkoxygruppe, eine Arylgruppe oder eine monovalente heterocyclische Gruppe darstellt, und diese Gruppen jeweils einen Substituenten aufweisen können; und die Vielzahl von R^{H11} kann gleich oder verschieden sein und kann aneinander gebunden sein, um zusammen mit dem Kohlenstoffatom, an das sie gebunden sind, einen Ring zu bilden,
L^{H2} eine Gruppe darstellt, die durch -N(-L^{H21}-R^{H21})- dargestellt ist; wenn es eine Vielzahl von L^{H2} gibt, können sie gleich oder verschieden sein, und
L^{H21} eine Einfachbindung, eine Arylengruppe oder eine zweiwertige heterocyclische Gruppe darstellt, und diese Gruppen jeweils einen Substituenten aufweisen können; R^{H21} ein Wasserstoffatom, eine Alkylgruppe, eine Cycloalkylgruppe, eine Arylgruppe oder eine einwertige heterocyclische Gruppe darstellt, und diese Gruppen jeweils einen Substituenten aufweisen können.

14. Zusammensetzung nach einem der Ansprüche 1 bis 13, ferner umfassend mindestens ein Material, ausgewählt aus der Gruppe bestehend aus einem Lochtransportmaterial, einem Lochinjektionsmaterial, einem Elektronentransportmaterial, einem Elektroneninjektionsmaterial, einem lichtemissionsmaterial, einem Antioxidationsmittel und einem Lösungsmittel.

15. Lichtemittierende Vorrichtung, umfassend: eine Anode;
eine Kathode; und
eine zwischen der Anode und der Kathode bereitgestellte Schicht und umfassend die Zusammensetzung nach einem der Ansprüche 1 bis 14.

## Revendications

1. Composition, comprenant :
un composé phosphorescent représenté par la formule (1) ; et
un composé phosphorescent représenté par la formule (2) : 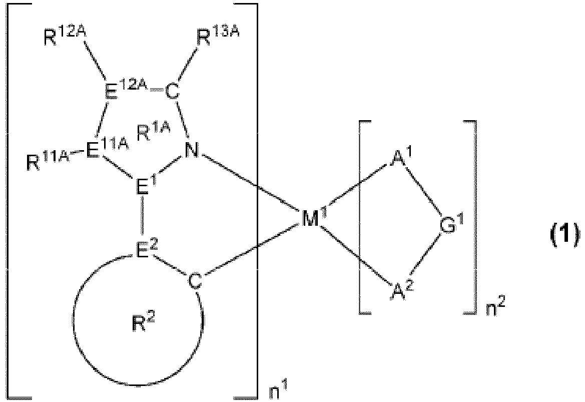 dans laquelle
M¹ représente un atome de rhodium, un atome de palladium, un atome d'iridium ou un atome de platine,
n¹ dénote un nombre entier relatif d'1 ou plus, n² dénote un nombre entier relatif de 0 ou plus, et n¹ + n² est 2 ou 3,
lorsque M¹ est un atome de rhodium ou un atome d'iridium, n¹ + n² est 3, et, lorsque M¹ est un atome de palladium ou un atome de platine, n¹ + n² est 2,
l'anneau R^{1A} représente un anneau triazole ou un anneau diazole constitué d'un atome d'azote, d'E¹, d'E^{11A}, d'E^{12A}, et d'un atome de carbone,
l'anneau R² représente un anneau hydrocarbure aromatique ou un anneau hétérocyclique aromatique, et ces anneaux peuvent chacun avoir un substituant ; lorsqu'il y a une pluralité de tels substituants, ces substituants peuvent être les mêmes ou différents et peuvent être liés les uns aux autres pour former un anneau conjointement avec les atomes auxquels ils sont liés ; et, lorsqu'il y a une pluralité d'anneaux R², ces anneaux peuvent être les mêmes ou différents,
E¹, E², E^{11A}, et E^{12A} représentent chacun indépendamment un atome d'azote ou un atome de carbone ; lorsqu'il y a une pluralité d'E¹, d'E², d'E^{11A}, et d'E^{12A}, ils peuvent être les mêmes ou différents dans chaque cas ; à condition qu'au moins un d'E¹ et d'E² soit un atome de carbone,
R^{11A} et R^{12A} représentent chacun indépendamment un atome d'hydrogène, un groupe alkyle, un groupe cyclcoalkyle, un groupe alkoxy, un groupe cycloalkoxy, un groupe aryle, un groupe aryloxy, un groupe hétérocyclique monovalent, un groupe amino substitué, ou un groupe halogène, et ces groupes peuvent chacun avoir un substituant ; lorsqu'il y a une pluralité de R^{11A} et de R^{12A}, ils peuvent être les mêmes ou différents dans chaque cas ; R^{11A} et R^{12A} peuvent être liés l'un à l'autre pour former un anneau conjointement avec les atomes auxquels ils sont liés ; et R^{11A} et un substituant optionnel de l'anneau R² ne sont pas liés l'un à l'autre pour former un anneau conjointement avec les atomes auxquels ils sont liés,
lorsque E^{11A} est un atome d'azote, R^{11A} peut être présent ou absent, et, lorsque E^{12A} est un atome d'azote, R^{12A} peut être présent ou absent,
R^{13A} représente un groupe aryle, un groupe hétérocyclique monovalent, ou un groupe amino substitué, et ces groupes peuvent chacun avoir un substituant ; lorsqu'il y a une pluralité de R^{13A}, ils peuvent être les mêmes ou différents ; et R^{12A} et R^{13A} peuvent être liés l'un à l'autre pour former un anneau conjointement avec les atomes auxquels ils sont liés, et
A¹-G¹-A² représente un ligand bidenté anionique, A¹ et A² représentent chacun indépendamment un atome de carbone, un atome d'oxygène ou un atome d'azote, et ces atomes peuvent être des atomes constituant un anneau ; G¹ représente une seule liaison ou un groupe atomique constituant le ligand bidenté conjointement avec A¹ et A² ; et, lorsqu'il y a une pluralité d'A¹-G¹-A², ils peuvent être les mêmes ou différents ; 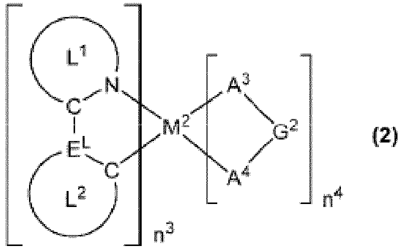
dans laquelle
M² représente un atome de rhodium, un atome de palladium, un atome d'iridium ou un atome de platine,
n³ dénote un nombre entier relatif d'1 ou plus, n⁴ dénote un nombre entier relatif de 0 ou plus, et n³ + n⁴ est 2 ou 3 ; lorsque M² est un atome de rhodium ou un atome d'iridium, n³ + n⁴ est 3 ; et, lorsque M² est un atome de palladium ou un atome de platine, n³ + n⁴ est 2
E^{L} représente un atome de carbone ou un atome d'azote,
l'anneau L¹ représente un anneau hétérocyclique aromatique à 6 membres, qui peut avoir un substituant ; lorsqu'il y a une pluralité de tels substituants, ils peuvent être les mêmes ou différents et peuvent être liés les uns aux autres pour former un anneau conjointement avec les atomes auxquels ils sont liés ; et, lorsqu'il y a une pluralité d'anneaux L¹, ils peuvent être les mêmes ou différents,
l'anneau L² représente un anneau hydrocarbure aromatique ou un anneau hétérocyclique aromatique, et ces anneaux peuvent chacun avoir un substituant ; lorsqu'il y a une pluralité de tels substituants, ils peuvent être les mêmes ou différents et peuvent être liés les uns aux autres pour former un anneau conjointement avec les atomes auxquels ils sont liés ; et, lorsqu'il y a une pluralité d'anneaux L², ils peuvent être les mêmes ou différents,
un substituant optionnel de l'anneau L¹ et un substituant optionnel de l'anneau L² peuvent se combiner l'un avec l'autre pour former un anneau conjointement avec les atomes auxquels ils sont liés,
à condition qu'au moins un anneau sélectionné parmi le groupe constitué de l'anneau L¹ et de l'anneau L² ait au moins un groupe représenté par la formule (1-T) ; et, lorsqu'il y a une pluralité de groupes représentés par la formule (1- T), ils peuvent être les mêmes ou différents,
A³-G²-A⁴ représente un ligand bidenté anionique, A³ et A⁴ représentent chacun indépendamment un atome de carbone, un atome d'oxygène ou un atome d'azote, et ces atomes peuvent être des atomes constituant un anneau ; G² représente une seule liaison ou un groupe atomique constituant le ligand bidenté conjointement avec A³ et A⁴ ; et, lorsqu'il y a une pluralité d'A³-G²-A⁴, ils peuvent être les mêmes ou différents ;
-R^{1T} (1-T)
dans laquelle
R^{1T} représente un groupe alkyle, un groupe cyclcoalkyle, un groupe alkoxy, un groupe cycloalkoxy, un groupe aryloxy, un groupe halogène, un groupe aryle, un groupe hétérocyclique monovalent, ou un groupe amino substitué, et ces groupes peuvent chacun avoir un substituant.

2. Composition selon la revendication 1, dans laquelle le composé phosphorescent représenté par la formule (2) est un composé phosphorescent représenté par la formule (2-B) : 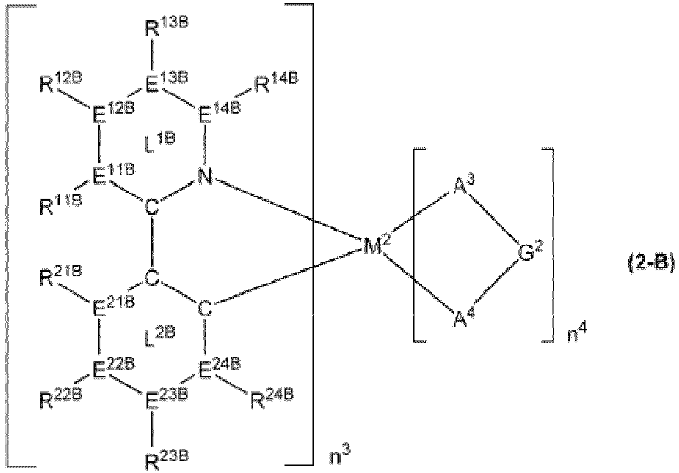 dans laquelle
M², n³, n⁴, et A³-G²-A⁴ ont la même signification que ce qui est décrit ci-dessus,
E^{11B}, E^{12B}, E^{13B}, E^{14B} E^{21B}, E^{22B}, E^{23B}, et E^{24B} représentent chacun indépendamment un atome d'azote ou un atome de carbone ; lorsqu'il y a une pluralité d'E^{11B}, d'E^{12B} , d'E^{13B}, d'E^{14B}, d'E^{21B}, d'E^{22B}, d'E^{23B}, et d'E^{24B}, ils peuvent être les mêmes ou différents dans chaque cas ; lorsqu'E^{11B} est un atome d'azote, R^{11B} est absent ; lorsqu'E^{12B} est un atome d'azote, R^{12B} est absent, lorsqu'E^{13B} est un atome d'azote, R^{13B} est absent ; lorsqu'E^{14B} est un atome d'azote, R^{14B} est absent ; lorsqu'E^{21B} est un atome d'azote, R^{21B} est absent; lorsqu'E^{22B} est un atome d'azote, R^{22B} est absent ; lorsqu'E^{23B} est un atome d'azote, R^{23B} est absent ; et, lorsqu'E^{24B} est un atome d'azote, R^{24B} est absent,
R^{11B}, R^{12B}, R^{13B}, R^{14B}, R^{21B}, R^{22B}, R^{23B}, et R^{24B} représentent chacun indépendamment un atome d'hydrogène ou un groupe représenté par la formule (1-T) ; lorsqu'il y a une pluralité de R^{11B}, de R^{12B}, de R^{13B}, de R^{14B}, de R^{21B}, de R^{22B}, de R^{23B}, et de R^{24B}, ils peuvent être les mêmes ou différents dans chaque cas ; et R^{11B} et R^{12B}, R^{12B} et R^{13B}, R^{13B} et R^{14B}, R^{11B} et R^{21B}, R^{21B} et R^{22B}, R^{22B} et R^{23B}, et R^{23B} et R^{24B} peuvent chacun peuvent être liés l'un à l'autre pour former un anneau conjointement avec les atomes auxquels ils sont liés, à condition qu'au moins un sélectionné parmi le groupe constitué de R^{11B}, de R^{12B} , de R^{13B}, de R^{14B}, de R^{21B}, de R^{22B}, de R^{23B}, et de R^{24B} soit un groupe représenté par la formule (1-T),
l'anneau L^{1B} représente un anneau pyridine ou un anneau pyrimidine constitué d'un atome d'azote, d'un atome de carbone, d'E^{11B}, d'E^{12B}, d'E^{13B} et d'E^{14B}, et
l'anneau L^{2B} représente un anneau benzène, un anneau pyridine, ou un anneau pyrimidine constitué de deux atome de carbones, d'E^{21B}, d'E^{22B}, d'E^{23B}, et d'E^{24B}.

3. Composition selon la revendication 2, dans laquelle le composé phosphorescent représenté par la formule (2-B) est un composé phosphorescent représenté par la formule (2-B1), un composé phosphorescent représenté par la formule (2-B2), un composé phosphorescent représenté par la formule (2-B3), un composé phosphorescent représenté par la formule (2-B4), ou un composé phosphorescent représenté par la formule (2-B5) : 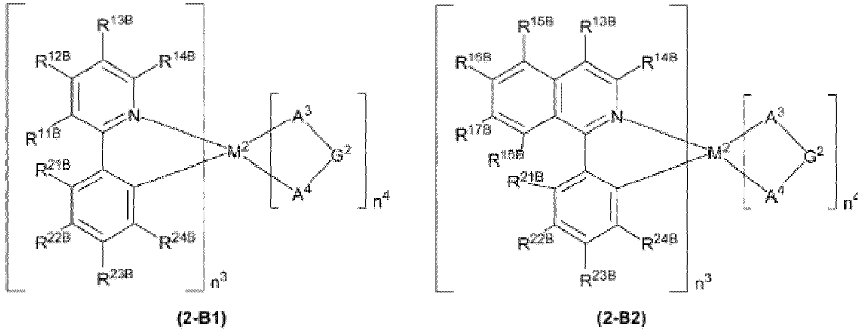 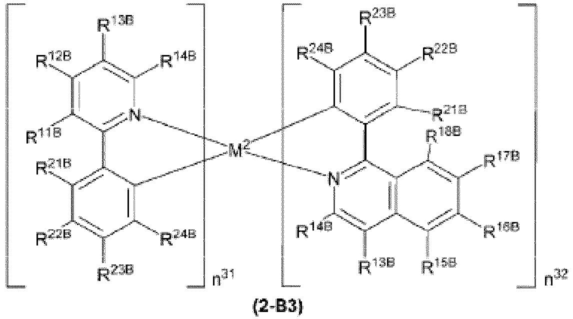 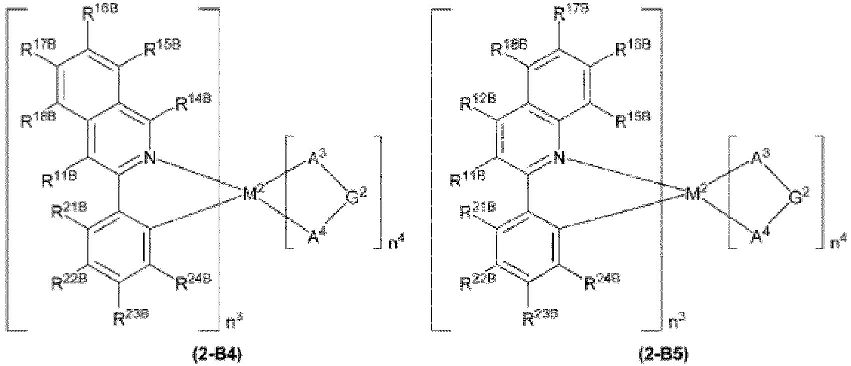 dans laquelle
M², n³, n⁴, R^{11B}, R^{12B}, R^{13B}, R^{14B}, R^{21B}, R^{22B}, R^{23B}, et R^{24B} et A³-G²-A⁴ ont les mêmes significations que ce qui est décrit ci-dessus,
n³¹ et n³² dénotent chacun indépendamment un nombre entier relatif d'1 ou plus, et n³¹ + n³² est 2 ou 3 ; lorsque M² est un atome de rhodium ou un atome d'iridium, n³¹ + n³² est 3 ; et, lorsque M² est un atome de palladium ou un atome de platine, n³¹ + n³² est 2, et
R^{15B}, R^{16B}, R^{17B}, et R^{18B} représentent chacun indépendamment un atome d'hydrogène ou un groupe représenté par la formule (1- T) ; lorsqu'il y a une pluralité de R^{15B}, de R^{16B}, de R^{17B}, et de R^{18B}, ils peuvent être les mêmes ou différents dans chaque cas ; R^{15B} et R^{16B}, R^{16B} et R^{17B} R^{17B} et R^{18B} peuvent chacun être liés l'un à l'autre pour former un anneau conjointement avec les atomes auxquels ils sont liés,
à condition que, dans les formules (2-B1) et (2-B3), au moins un sélectionné parmi le groupe constitué de R^{11B}, de R^{12B}, de R^{13B}, de R^{14B}, de R^{21B}, de R^{22B}, de R^{23B}, et de R^{24B} soit un groupe représenté par la formule (1-T) ; dans la formule (2-B2), au moins un sélectionné parmi le groupe constitué de R^{13B}, de R^{14B}, de R^{21B}, de R^{22B}, de R^{23B}, et de R^{24B} est un groupe représenté par la formule (1-T) ; dans la formule (2-B4), au moins un sélectionné parmi le groupe constitué de R^{11B}, de R^{14B}, de R^{21B}, de R^{22B}, de R^{23B}, et de R^{24B} est un groupe représenté par la formule (1-T) ; et dans la formule (2-B5), au moins un sélectionné parmi le groupe constitué de R^{11B}, de R^{12B}, de R^{21B}, de R^{22B}, de R^{23B}, et de R^{24B} est un groupe représenté par la formule (1-T).

4. Composition selon l'une quelconque des revendications 1 à 3, dans laquelle R^{1T} est un groupe alkyle, un groupe cyclcoalkyle, un groupe représenté par la formule (D-A), un groupe représenté par la formule (D-B), ou un groupe représenté par la formule (D-C) : 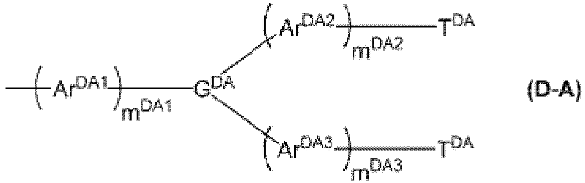 dans laquelle
m^{DA1}, m^{DA2}, et m^{DA3} dénotent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant,
Ar^{DA1}, Ar^{DA2}, et Ar^{DA3} représentent chacun indépendamment un groupe arylène ou un groupe hétérocyclique divalent, et ces groupes peuvent chacun avoir un substituant ; et, lorsqu'il y a une pluralité d'Ar^{DA1}, d'Ar^{DA2}, et d'Ar^{DA3}, ils peuvent être les mêmes ou différents dans chaque cas, et
T^{DA} représente un groupe aryle ou un groupe hétérocyclique monovalent, et ces groupes peuvent chacun avoir un substituant ; et la pluralité de T^{DA} peuvent être les mêmes ou différents ; 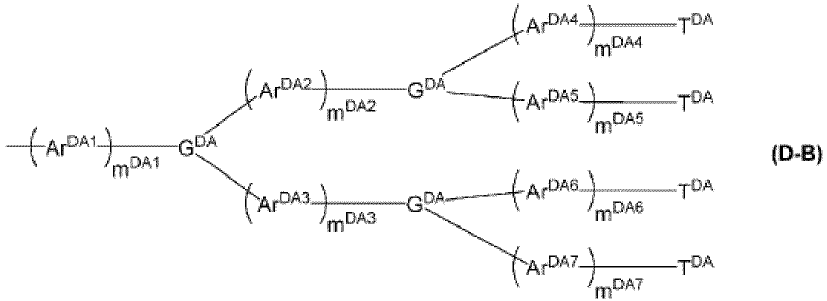
dans laquelle
m^{DA1}, m^{DA2}, m^{DA3}, m^{DA4}, m^{DA5}, m^{DA6}, et m^{DA7} dénotent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant ; et la pluralité de G^{DA} peuvent être les mêmes ou différents,
Ar^{DA1}, Ar^{DA2} , Ar^{DA3} , Ar^{DA4} , Ar^{DA5} , Ar^{DA6}, et Ar^{DA7} représentent chacun indépendamment un groupe arylène ou un groupe hétérocyclique divalent, et ces groupes peuvent chacun avoir un substituant ; et, lorsqu'il y a une pluralité d'Ar^{DA1}, d'Ar^{DA2} , d'Ar^{DA3} , d'Ar^{DA4} , d'Ar^{DA5} , d'Ar^{DA6}, et d'Ar^{DA7}, ils peuvent être les mêmes ou différents dans chaque cas, et
T^{DA} représente un groupe aryle ou un groupe hétérocyclique monovalent, et ces groupes peuvent chacun avoir un substituant ; et la pluralité de T^{DA} peuvent être les mêmes ou différents ; 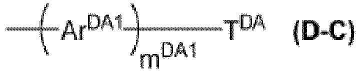
dans laquelle
m^{DA1} dénote un nombre entier relatif de 0 ou plus,
Ar^{DA1} représente un groupe arylène ou un groupe hétérocyclique divalent, et ces groupes peuvent chacun avoir un substituant ; et, lorsqu'il y a une pluralité d'Ar^{DA1}, ils peuvent être les mêmes ou différents, et
T^{DA} représente un groupe aryle ou un groupe hétérocyclique monovalent, et ces groupes peuvent chacun avoir un substituant.

5. Composition selon la revendication 4,
dans laquelle R^{1T} est un groupe représenté par la formule (D-A), et dans laquelle le groupe représenté par la formule (D-A) est un groupe représenté par la formule (D-A1), un groupe représenté par la formule (D-A2), un groupe représenté par la formule (D-A3), ou un groupe représenté par la formule (D-A4) : 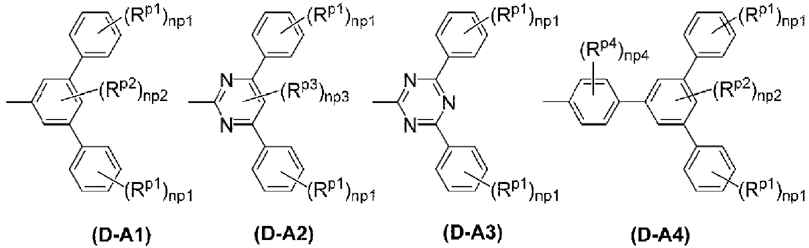 dans laquelle
R^{p1}, R^{p2}, R^{p3}, et R^{p4} représentent chacun indépendamment un groupe alkyle, un groupe cyclcoalkyle, un groupe alkoxy, un groupe cycloalkoxy, ou un groupe halogène ; et, lorsqu'il y a une pluralité de R^{p1}, de R^{p2}, et de R^{p4}, ils peuvent être les mêmes ou différents dans chaque cas, et
np1 dénote un nombre entier relatif de 0 à 5, np2 dénote un nombre entier relatif de 0 à 3, np3 représente 0 ou 1, et np4 dénote un nombre entier relatif de 0 à 4 ; et la pluralité de np1 peuvent être les mêmes ou différents.

6. Composition selon la revendication 4,
dans laquelle R^{1T} est un groupe représenté par la formule (D-B), et dans laquelle le groupe représenté par la formule (D-B) est un groupe représenté par la formule (D-B1), un groupe représenté par la formule (D-B2), ou un groupe représenté par la formule (D-B3) : 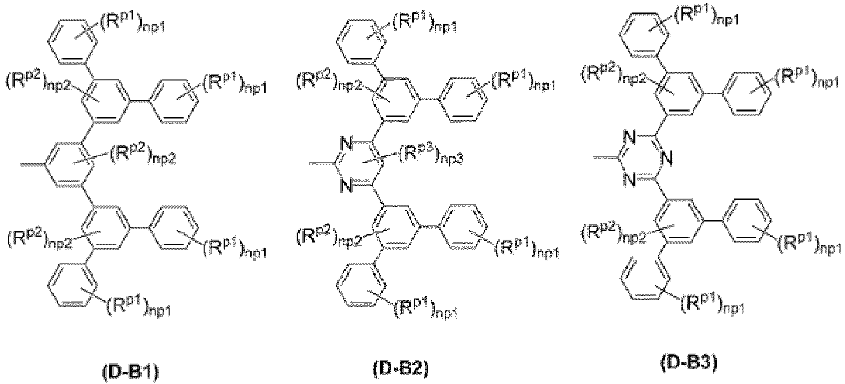 dans laquelle
R^{p1}, R^{p2}, et R^{p3} représentent chacun indépendamment un groupe alkyle, un groupe cyclcoalkyle, un groupe alkoxy, un groupe cycloalkoxy, ou un groupe halogène ; et, lorsqu'il y a une pluralité de R^{p1}, et de R^{p2}, ils peuvent être les mêmes ou différents dans chaque cas, et
np1 dénote un nombre entier relatif de 0 à 5, np2 dénote un nombre entier relatif de 0 à 3, et np3 représente 0 ou 1 ; et, lorsqu'il y a une pluralité de np1 et de np2, ils peuvent être les mêmes ou différents dans chaque cas.

7. Composition selon la revendication 4,
dans laquelle R^{1T} est un groupe représenté par la formule (D-C), et dans laquelle le groupe représenté par la formule (D-C) est un groupe représenté par la formule (D-C1), un groupe représenté par la formule (D-C2), un groupe représenté par la formule (D-C3), ou un groupe représenté par la formule (D-C4) : 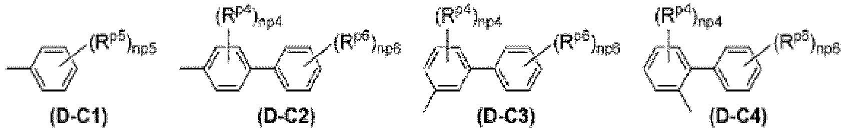 dans laquelle
R^{p4}, R^{p5}, et R^{p6} représentent chacun indépendamment un groupe alkyle, un groupe cyclcoalkyle, un groupe alkoxy, un groupe cycloalkoxy, ou un groupe halogène ; et, lorsqu'il y a une pluralité de R^{p4}, de R^{p5}, et de R^{p6}, ils peuvent être les mêmes ou différents dans chaque cas, et
np4 dénote un nombre entier relatif de 0 à 4, np5 dénote un nombre entier relatif de 0 à 5, et np6 dénote un nombre entier relatif de 0 à 5.

8. Composition selon l'une quelconque des revendications 1 à 7, dans laquelle le composé phosphorescent représenté par la formule (1) est un composé phosphorescent représenté par la formule (1-A) : 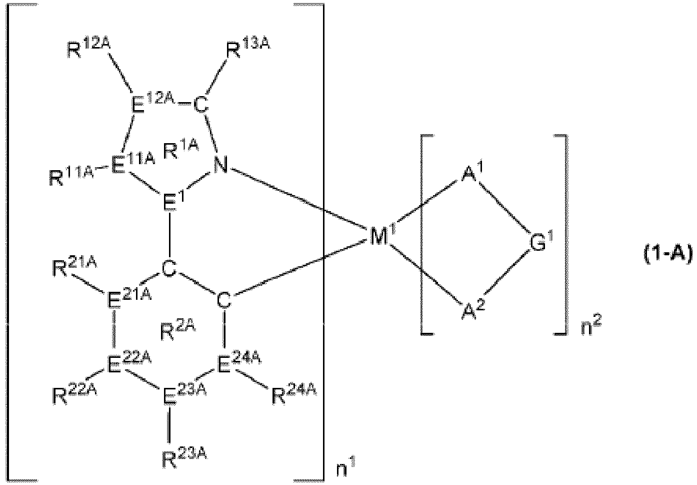 dans laquelle
M¹, n¹, n², l'anneau R^{1A}, E¹, E^{11A} , E^{12A}, R^{11A}, R^{12A}, R^{13A}, et A¹-G¹-A² ont les mêmes significations que ce qui est décrit ci-dessus,
l'anneau R^{2A} représente un anneau benzène, un anneau pyridine, ou un anneau pyrimidine constitué de deux atome de carbones, d'E^{21A}, d'E^{22A}, d'E^{23A}, et d'E^{24A},
E^{21A}, E^{22A}, E^{23A}, et E^{24A} représentent chacun indépendamment un atome d'azote ou un atome de carbone ; lorsqu'il y a une pluralité d'E^{21A}, d'E^{22A}, d'E^{23A}, et d'E^{24A}, ils peuvent être les mêmes ou différents dans chaque cas ; lorsqu'E^{21A} est un atome d'azote, R^{21A} est absent ; lorsqu'E^{22A} est un atome d'azote, R^{22A} est absent ; lorsqu'E^{23A} est un atome d'azote, R^{23A} est absent ; et, lorsqu'E^{24A} est un atome d'azote, R^{24A} est absent, et
R^{21A}, R^{22A}, R^{23A}, et R^{24A} représentent chacun un atome d'hydrogène, un groupe alkyle, un groupe cyclcoalkyle, un groupe alkoxy, un groupe cycloalkoxy, un groupe aryle, un groupe aryloxy, un groupe hétérocyclique monovalent, un groupe amino substitué, ou un groupe halogène, et ces groupes peuvent chacun avoir un substituant ; lorsqu'il y a une pluralité de R^{21A}, de R^{22A}, de R^{23A}, et de R^{24A}, ils peuvent être les mêmes ou différents dans chaque cas ; R^{21A} et R^{22A} peuvent être liés l'un à l'autre pour former un anneau conjointement avec les atomes auxquels ils sont liés ; R^{22A} et R^{23A} peuvent être liés l'un à l'autre pour former un anneau conjointement avec les atomes auxquels ils sont liés ; R^{23A} et R^{24A} peuvent être liés l'un à l'autre pour former un anneau conjointement avec les atomes auxquels ils sont liés ; et R^{11A} et R^{21A} ne sont pas liés l'un à l'autre pour former un anneau conjointement avec les atomes auxquels ils sont liés.

9. Composition selon la revendication 8, dans laquelle le composé phosphorescent représenté par la formule (1-A) est un composé phosphorescent représenté par la formule (1-A1), un composé phosphorescent représenté par la formule (1-A2), un composé phosphorescent représenté par la formule (1-A3), ou un composé phosphorescent représenté par la formule (1-A4) : 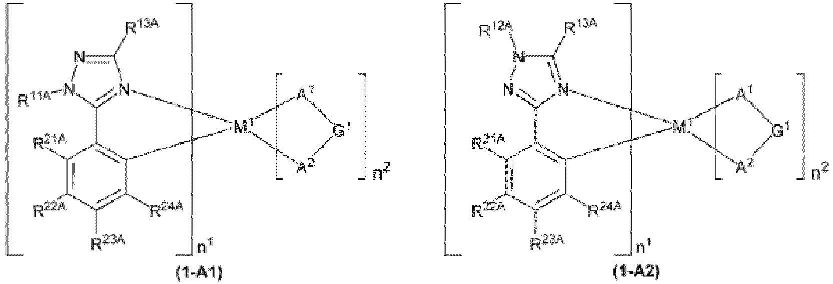 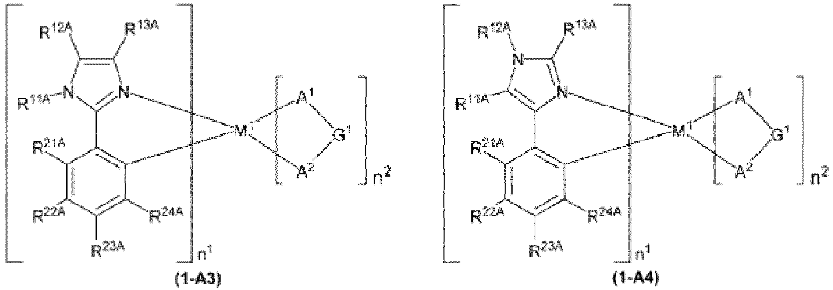 dans laquelle M¹, n¹, n², R^{11A}, R^{12A}, R^{13A}, R^{21A}, R^{22A}, R^{23A}, R^{24A}, et A¹-G¹-A² ont les mêmes significations que ce qui est décrit ci-dessus.

10. Composition selon l'une quelconque des revendications 1 à 9, dans laquelle R^{13A} est un groupe aryle qui peut avoir un substituant.

11. Composition selon l'une quelconque des revendications 1 à 10, dans laquelle la composition comprend deux ou plus composés phosphorescents représentés par la formule (2).

12. Composition selon l'une quelconque des revendications 1 à 11,
dans laquelle la longueur d'onde de pointe maximum du spectre d'émission du composé phosphorescent représenté par la formule (1) est de 380 nm ou plus et inférieure à 495 nm, et
dans laquelle la longueur d'onde de pointe maximum du spectre d'émission du composé phosphorescent représenté par la formule (2) est de 495 nm ou plus et inférieure à 750 nm.

13. Composition selon l'une quelconque des revendications 1 à 12, comprenant en outre un composé représenté par la formule (H-1) : 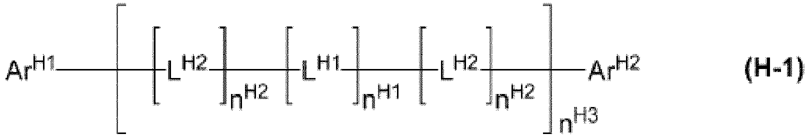 dans laquelle,
Ar^{H1} et Ar^{H2} représentent chacun indépendamment un groupe aryle ou un groupe hétérocyclique monovalent, et ces groupes peuvent chacun avoir un substituant,
n^{H1} et n^{H2} dénotent chacun indépendamment 0 ou 1 ; lorsqu'il y a une pluralité de n^{H1}, ils peuvent être les mêmes ou différents ; et la pluralité de n^{H2} peuvent être les mêmes ou différents,
n^{H3} dénote un nombre entier relatif de 0 ou plus,
L^{H1} représente un groupe arylène, un groupe hétérocyclique divalent, ou un groupe représenté par -[C(R^{H11})₂]n^{H11-}, et ces groupes peuvent chacun avoir un substituant ; lorsqu'il y a une pluralité de L^{H1}, ils peuvent être les mêmes ou différents,
n^{H11} dénote un nombre entier relatif d'1 ou plus et de 10 ou moins ; R^{H11} représente un atome d'hydrogène, un groupe alkyle, un groupe cyclcoalkyle, un groupe alkoxy, un groupe cycloalkoxy, un groupe aryle, ou un groupe hétérocyclique monovalent, et ces groupes peuvent chacun avoir un substituant ; et la pluralité de R^{H11} peuvent être les mêmes ou différents et peuvent être liés les uns aux autres pour former un anneau conjointement avec the atome de carbone auxquels ils sont liés,
L^{H2} représente un groupe représenté par -N(-L^{H21}-R^{H21})- ; lorsqu'il y a une pluralité de L^{H2}, ils peuvent être les mêmes ou différents, et
L^{H21} représente une seule liaison, un groupe arylène, ou un groupe hétérocyclique divalent, et ces groupes peuvent chacun avoir un substituant ; R^{H21} représente un atome d'hydrogène, un groupe alkyle, un groupe cyclcoalkyle, un groupe aryle, ou un groupe hétérocyclique monovalent, et ces groupes peuvent chacun avoir un substituant.

14. Composition selon l'une quelconque des revendications 1 à 13, comprenant en outre au moins un matériau sélectionné parmi le groupe constitué d'un matériau de transport de trous, d'un matériau d'injection de trous, d'un matériau de transport d'électrons, d'un matériau d'injection d'électrons, d'un matériau luminescent, d'un antioxydant, et d'un solvent.

15. Dispositif luminescent, comprenant :
une anode ;
une cathode ; et
une couche prévue entre l'anode et la cathode, et comprenant la composition selon l'une quelconque des revendications 1 à 14.
